# EUROPEAN PATENT APPLICATION

(11) **EP 4 794 483 A1**
(43) Date of publication of application: **19.08.2026**
(21) Application number: 24876931.7
(22) Date of filing: 19.08.2024
(51) Int. Cl.: H10F 39/12, H10W 74/10, H10W 74/40

(54) **PACKAGE AND METHOD FOR MANUFACTURING PACKAGE**

(30) Priority: 12.10.2023 JP 2023176372
(71) Applicant: Sony Semiconductor Solutions Corporation, Atsugi-shi, Kanagawa 243-0014 (JP)
(72) Inventor: OHIRA, Hikaru, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/029254
(87) International publication number: WO 2025/079331

(57) **Abstract**

Packaging chips can be achieved while minimizing an increase in a mounting area.

A package includes: a sensor chip that is face-down mounted; a semiconductor chip that is face-down mounted at a position different from the sensor chip; a sealing material that collectively seals the sensor chip and the semiconductor chip in such a way that a back surface side of the sensor chip is exposed; and a wiring layer that is formed on a mounting surface on which the sensor chip and the semiconductor chip are mounted. The sensor chip may be a back-side illumination image sensor. The package further includes an interposer substrate including the wiring layer, and the interposer substrate may include a through electrode connected to the wiring layer.

## Description

### TECHNICAL FIELD

The present technology relates to a package and a method for manufacturing the package. Specifically, the present technology relates to a package to which chiplets are applied and a method for manufacturing the package.

### BACKGROUND ART

In order to enable high-density integration of sensor chips, chiplets may be applied to systems-in-package (SiP) and the like. For example, a device having a sensor disposed on a substrate and including an active surface and a sensor bond pad, and a molded layer covering side surfaces of the sensor (see, for example, Patent Document 1).

### CITATION LIST

### PATENT DOCUMENT

Patent Document 1: JP 2022-532811 A

### SUMMARY OF THE INVENTION

### PROBLEMS TO BE SOLVED BY THE INVENTION

However, in the above-described related art, since an overhang of the molded layer is formed on the sensor, there is a risk that the chip size may increase depending on the overhang.

The present technology has been made in view of such circumstances, and an object thereof is to enable packaging of chips while minimizing an increase in a mounting area.

### SOLUTIONS TO PROBLEMS

The present technology has been made to solve the above-described problems, and a first aspect thereof is a package including: a sensor chip that is face-down mounted; a semiconductor chip that is face-down mounted at a position different from the sensor chip; a sealing material that collectively seals the sensor chip and the semiconductor chip in such a way that a back surface side of the sensor chip is exposed; and a wiring layer that is formed on a mounting surface on which the sensor chip and the semiconductor chip are mounted. Therefore, the effect of improving mounting density for chips of different sizes while enabling sensing is obtained.

Furthermore, in the first aspect, the sensor chip may be a back-side illumination image sensor. Therefore, the effect of enabling sensing of the sensor chip while the sensor chip is face-down mounted is obtained.

Furthermore, in the first aspect, a back surface side of the semiconductor chip may be exposed from the sealing material. Therefore, the effect of reducing the level difference around the sensor chip while the sensor chip and the semiconductor chips are collectively sealed is obtained.

Furthermore, in the first aspect, the sealing material may be a molding resin. Therefore, the effect that the sensor chip and the semiconductor chips are collectively sealed is obtained.

Furthermore, in the first aspect, the package further includes an interposer substrate including the wiring layer, in which the interposer substrate may include a through electrode connected to the wiring layer. Therefore, the effect that the face-down mounted sensor chip and semiconductor chips are electrically connected to the outside is obtained.

Furthermore, in the first aspect, the sensor chip and the semiconductor chip may be flip-chip mounted on the interposer substrate. Therefore, the effect of face-down mounting the sensor chip and the semiconductor chips while electrically connecting the sensor chip and the semiconductor chips to the interposer substrate is obtained.

Furthermore, in the first aspect, positions of end portions of the sealing material in a horizontal direction may be equal to positions of end portions of the interposer substrate in the horizontal direction. Therefore, the effect that a wafer level chip size package (WLCSP) to which the chiplets are applied is achieved is obtained.

Furthermore, in the first aspect, the wiring layer may be a redistribution layer formed between the mounting surface on which the sensor chip and the semiconductor chip are mounted, and the sealing material. Therefore, the effect that the sensor chip and semiconductor chips face-down mounted are electrically connected to the outside without forming the through electrodes in the package is obtained.

Furthermore, in the first aspect, a distance between a sensor surface of the sensor chip and the mounting surface may be shorter than a distance between a back surface of the semiconductor chip and the mounting surface. Therefore, the effect that the sensor chip is formed with the recess having the bottom surface on which the sensor surface is disposed is obtained.

Furthermore, in the first aspect, a distance between a surface of the sealing material and the mounting surface may be longer than a distance between a back surface of the semiconductor chip and the mounting surface. Therefore, the effect of encapsulating the semiconductor chips with the sealing material is obtained.

Furthermore, in the first aspect, a distance between the sensor surface of the sensor chip and the mounting surface may be equal to a distance between a back surface of the semiconductor chip and the mounting surface. Therefore, the effect of achieving the back-side illumination image sensor while minimizing the level difference around the sensor surface of the sensor chip is obtained.

Furthermore, in the first aspect, the sensor chip may include a plurality of sensor chips having different types and being face-down mounted at different positions from each other. Therefore, the effect of improving mounting density for chips of different sizes while enabling different types of sensing is obtained.

Furthermore, in the first aspect, the package may further include a transparent substrate disposed on the sensor surface of the sensor chip. Therefore, the effect of sealing the sensor surface of the sensor chip while enabling sensing of the sensor chip is obtained.

Furthermore, in the first aspect, the package may further include a transparent adhesive layer provided between the sensor chip and the transparent substrate. Therefore, the effect of fixing the transparent substrate on the sensor surface of the sensor chip while enabling sensing of the sensor chip is obtained.

Furthermore, in the first aspect, the package may further include a cavity provided between the sensor chip and the transparent substrate. Therefore, the effect of sealing the sensor surface of the sensor chip without affecting the optical characteristics of the sensor chip is obtained.

Furthermore, in the first aspect, a height of the cavity on the sensor surface may be greater than a height of the cavity on a region other than the sensor surface. Therefore, the effect of achieving the back-side illumination image sensor while minimizing the level difference between the sensor chip and the sealing material is obtained.

Furthermore, in the first aspect, the package may further include an opaque layer that is disposed around the sensor surface of the sensor chip. Therefore, the effect of attenuating unnecessary light while enabling sensing of the sensor chip is obtained.

Furthermore, in the first aspect, the package may further include a spacer that is disposed around the sensor surface of the sensor chip. Therefore, the effect of adjusting the height of the cavity on the sensor surface of the sensor chip is obtained.

Furthermore, a second aspect is a method for manufacturing a package, the method including: a step of collectively sealing a sensor chip and a semiconductor chip disposed at different positions from each other, with a sealing material; a step of thinning the sensor chip, the semiconductor chip, and the sealing material to expose a back surface of the sensor chip and a back surface of the semiconductor chip. Therefore, the effect of achieving sensing of the sensor chip while improving the mounting density of the chips of different sizes is obtained.

Furthermore, in the second aspect, the method may further include a step of face-down mounting the sensor chip and the semiconductor chip at different positions from each other on an interposer substrate before collectively sealing the sensor chip and the semiconductor chip with the sealing material. Therefore, the effect of connecting the sensor chip and the semiconductor chips to the outside while forming the sensor surface on the back surface of the sensor chip is obtained.

### BRIEF DESCRIPTION OF DRAWINGS

Fig. 1 is a diagram illustrating a configuration example of a sensor package according to a first embodiment.
Fig. 2 is a cross-sectional view illustrating an example of a method for manufacturing a sensor package according to the first embodiment.
Fig. 3 is a cross-sectional view illustrating an example of the method for manufacturing a sensor package according to the first embodiment.
Fig. 4 is a cross-sectional view illustrating an example of the method for manufacturing a sensor package according to the first embodiment.
Fig. 5 is a cross-sectional view illustrating an example of the method for manufacturing a sensor package according to the first embodiment.
Fig. 6 is a cross-sectional view illustrating an example of a method for manufacturing a sensor package according to the first embodiment.
Fig. 7 is a cross-sectional view illustrating an example of a method for manufacturing a sensor package according to the first embodiment.
Fig. 8 is a cross-sectional view illustrating an example of the method for manufacturing a sensor package according to the first embodiment.
Fig. 9 is a diagram illustrating a configuration example of a sensor package according to a second embodiment.
Fig. 10 is a diagram illustrating a configuration example of a sensor package according to a third embodiment.
Fig. 11 is a diagram illustrating a configuration example of a sensor package according to a fourth embodiment.
Fig. 12 is a diagram illustrating a configuration example of a sensor package according to a fifth embodiment.
Fig. 13 is a diagram illustrating a configuration example of a sensor package according to a sixth embodiment.
Fig. 14 is a diagram illustrating a configuration example of a sensor package according to a seventh embodiment.
Fig. 15 is a diagram illustrating a configuration example of a sensor package according to an eighth embodiment.
Fig. 16 is a diagram illustrating a configuration example of a sensor package according to a ninth embodiment.
Fig. 17 is a cross-sectional view illustrating an example of a method for manufacturing a sensor package according to the ninth embodiment.
Fig. 18 is a cross-sectional view illustrating an example of the method for manufacturing a sensor package according to the ninth embodiment.
Fig. 19 is a cross-sectional view illustrating an example of the method for manufacturing a sensor package according to the ninth embodiment.
Fig. 20 is a cross-sectional view illustrating an example of the method for manufacturing a sensor package according to the ninth embodiment.
Fig. 21 is a cross-sectional view illustrating an example of the method for manufacturing a sensor package according to the ninth embodiment.
Fig. 22 is a diagram illustrating a configuration example of a sensor package according to a tenth embodiment.
Fig. 23 is a diagram illustrating a configuration example of a sensor package according to an eleventh embodiment.
Fig. 24 is a diagram illustrating a configuration example of a sensor package according to a twelfth embodiment.
Fig. 25 is a diagram illustrating a configuration example of a sensor package according to a thirteenth embodiment.
Fig. 26 is a diagram illustrating a configuration example of a sensor package according to a fourteenth embodiment.
Fig. 27 is a cross-sectional view illustrating an example of a method for manufacturing a sensor package according to the fourteenth embodiment.
Fig. 28 is a diagram illustrating a configuration example of a sensor package according to a fifteenth embodiment.
Fig. 29 is a diagram illustrating a configuration example of a sensor package according to a sixteenth embodiment.
Fig. 30 is a diagram illustrating a configuration example of a sensor package according to a seventeenth embodiment.
Fig. 31 is a diagram illustrating a configuration example of a sensor package according to an eighteenth embodiment.
Fig. 32 is a cross-sectional view illustrating an example of a method for manufacturing a sensor package according to the eighteenth embodiment.
Fig. 33 is a cross-sectional view illustrating an example of the method for manufacturing a sensor package according to the eighteenth embodiment.
Fig. 34 is a cross-sectional view illustrating an example of the method for manufacturing a sensor package according to the eighteenth embodiment.
Fig. 35 is a cross-sectional view illustrating an example of the method for manufacturing a sensor package according to the eighteenth embodiment.
Fig. 36 is a diagram illustrating a configuration example of a sensor package according to a nineteenth embodiment.
Fig. 37 is a diagram illustrating a configuration example of a sensor package according to a twentieth embodiment.
Fig. 38 is a diagram illustrating a configuration example of a sensor package according to a twenty-first embodiment.
Fig. 39 is a diagram illustrating a configuration example of a sensor package according to a twenty-second embodiment.
Fig. 40 is a cross-sectional view illustrating an example of a method for manufacturing a sensor package according to the twenty-second embodiment.
Fig. 41 is a cross-sectional view illustrating an example of the method for manufacturing a sensor package according to the twenty-second embodiment.
Fig. 42 is a diagram illustrating a configuration example of a sensor package according to a twenty-third embodiment.
Fig. 43 is a cross-sectional view illustrating an example of a method for manufacturing a sensor package according to the twenty-third embodiment.
Fig. 44 is a cross-sectional view illustrating an example of the method for manufacturing a sensor package according to the twenty-third embodiment.
Fig. 45 is a cross-sectional view illustrating an example of the method for manufacturing a sensor package according to the twenty-third embodiment.
Fig. 46 is a cross-sectional view illustrating an example of the method for manufacturing a sensor package according to the twenty-third embodiment.
Fig. 47 is a diagram illustrating a configuration example of a sensor package according to a twenty-fourth embodiment.
Fig. 48 is a diagram illustrating a configuration example of a sensor package according to a twenty-fifth embodiment.
Fig. 49 is a diagram illustrating a configuration example of a sensor package according to a twenty-sixth embodiment.
Fig. 50 is a block diagram illustrating a schematic configuration example of a vehicle control system.
Fig. 51 is an explanatory diagram illustrating an example of installation positions of imaging sections.

### MODE FOR CARRYING OUT THE INVENTION

Modes for carrying out the present technology (hereinafter, referred to as embodiments) will be described below. The description will be given in the following order.
1. First Embodiment (Example in which a sensor chip having a sensor surface formed at the bottom of a recess on the back surface side and semiconductor chips are flip-chip mounted on an interposer substrate, and a transparent substrate is disposed via cavities on the sensor chip and the semiconductor chips)
2. Second Embodiment (Example in which a sensor chip having a sensor surface formed at the bottom of a recess on the back surface side and semiconductor chips are flip-chip mounted on an interposer substrate, and a transparent substrate is disposed via a cavity on the sensor chip)
3. Third Embodiment (Example in which a sensor chip having a sensor surface formed at the bottom of a recess on the back surface side and semiconductor chips are flip-chip mounted on an interposer substrate, and the sensor chip and the semiconductor chip are bonded to a transparent substrate via a transparent resin to achieve a cavity-less structure)
4. Fourth Embodiment (Example in which a sensor chip having a sensor surface formed at the bottom of a recess on the back surface side and semiconductor chips are flip-chip mounted on an interposer substrate, and a transparent substrate is disposed via a spacer on the sensor chip and the semiconductor chips)
5. Fifth Embodiment (Example in which a plurality of different types of sensor chips, each having a sensor surface formed at the bottom of a recess on the back surface side, and semiconductor chips are flip-chip mounted on an interposer substrate, and a transparent substrate is disposed via cavities on the sensor chips and the semiconductor chips)
6. Sixth Embodiment (Example in which a plurality of different types of sensor chips, each having a sensor surface formed at the bottom of a recess on the back surface side, and semiconductor chips are flip-chip mounted on an interposer substrate, and a transparent substrate is disposed via cavities on the sensor chips)
7. Seventh Embodiment Example in which a plurality of different types of sensor chips, each having a sensor surface formed at the bottom of a recess on the back surface side, and semiconductor chips are flip-chip mounted on an interposer substrate, and the sensor chip and the semiconductor chips are bonded to a transparent substrate via a transparent resin to achieve a cavity-less structure)
8. Eighth Embodiment Example in which a plurality of different types of sensor chips, each having a sensor surface formed at the bottom of a recess on the back surface side, and semiconductor chips are flip-chip mounted on an interposer substrate, and a transparent substrate is disposed via a spacer on the sensor chips and the semiconductor chips)
9. Ninth Embodiment (Example in which a sensor chip having a sensor surface formed at the bottom of a recess on the back surface side and semiconductor chips are flip-chip mounted on an interposer substrate, the semiconductor chips are encapsulated with a sealing material, and a transparent substrate is disposed via cavities on the sensor chip and the semiconductor chips)
10. Tenth Embodiment (Example in which a sensor chip having a sensor surface formed at the bottom of a recess on the back surface side and semiconductor chips are flip-chip mounted on an interposer substrate, the semiconductor chips are encapsulated with a sealing material, and a transparent substrate is disposed via a cavity on the sensor chip)
11. Eleventh Embodiment (Example in which a sensor chip having a sensor surface formed at the bottom of a recess on the back surface side and semiconductor chips are flip-chip mounted on an interposer substrate, the semiconductor chips are encapsulated with a sealing material, and the sensor chip and the sealing material are bonded to a transparent substrate via a transparent resin to achieve a cavity-less structure)
12. Twelfth Embodiment (Example in which a sensor chip having a sensor surface formed at the bottom of a recess on the back surface side and semiconductor chips are flip-chip mounted on an interposer substrate, the semiconductor chips are encapsulated with a sealing material, and a transparent substrate is disposed via a spacer on the sensor chip and the semiconductor chips)
13. Thirteenth Embodiment (Example in which a sensor chip having a sensor surface formed at the bottom of a recess on the back surface side and semiconductor chips are directly bonded to an interposer substrate, and a transparent substrate is disposed via cavities on the sensor chip and the semiconductor chips)
14. Fourteenth Embodiment (Example in which a sensor chip having a sensor surface formed on the back surface side and semiconductor chips are flip-chip mounted on an interposer substrate, and a transparent substrate is disposed via cavities on the sensor chip and the semiconductor chip)
15. Fifteenth Embodiment (Example in which a sensor chip having a sensor surface formed on the back surface side and semiconductor chips are flip-chip mounted on an interposer substrate, and a transparent substrate is disposed via a cavity on the sensor chip)
16. Sixteenth Embodiment (Example in which a sensor chip having a sensor surface formed on the back surface side and semiconductor chips are flip-chip mounted on an interposer substrate, and the sensor chip and the semiconductor chips are bonded to a transparent substrate via a transparent resin to achieve a cavity-less structure)
17. Seventeenth Embodiment (Example in which a sensor chip having a sensor surface formed on the back surface side and a semiconductor chip are flip-chip mounted on an interposer substrate, and a transparent substrate is disposed via a spacer on the sensor chip and the semiconductor chip)
18. Eighteenth Embodiment (Example in which a sensor chip thinned together with a sealing material and a semiconductor chip are flip-chip mounted on an interposer substrate, and a transparent substrate is disposed via a cavity on the sensor chip and the semiconductor chip)
19. Nineteenth Embodiment (Example in which a sensor chip thinned together with a sealing material and a semiconductor chip are flip-chip mounted on an interposer substrate, and a transparent substrate is disposed via a cavity on the sensor chip)
20. Twentieth Embodiment (Example in which a sensor chip thinned together with a sealing material and a semiconductor chip are flip-chip mounted on an interposer substrate, and the sensor chip and the semiconductor chip are bonded to a transparent substrate via a transparent resin to achieve a cavity-less structure)
21. Twenty-First Embodiment (Example in which a sensor chip thinned together with a sealing material and a semiconductor chip are flip-chip mounted on an interposer substrate, and a transparent substrate is disposed via a spacer on the sensor chip and the semiconductor chip)
22. Twenty-Second Embodiment (Example in which a sensor chip having a sensor surface formed at the bottom of a recess on the back surface side and semiconductor chips are flip-chip mounted on an interposer substrate, and the sensor surface is sealed with a transparent resin on the sensor chip and the semiconductor chip)
23. Twenty-Third Embodiment (Example in which a sensor chip thinned together with a sealing material and a semiconductor chip are face-down mounted on a redistribution layer, and a transparent substrate is disposed via a cavity on the sensor chip and the semiconductor chip)
24. Twenty-Fourth Embodiment (Example in which a sensor chip thinned together with a sealing material and a semiconductor chip are face-down mounted on a redistribution layer, and a transparent substrate is disposed via a cavity on the sensor chip)
25. Twenty-Fifth Embodiment (Example in which a sensor chip thinned together with a sealing material and a semiconductor chip are face-down mounted on a redistribution layer, and the sensor chip and the semiconductor chip are bonded to a transparent substrate via a transparent resin to achieve a cavity-less structure)
26. Twenty-Sixth Embodiment (Example in which a sensor chip thinned together with a sealing material and a semiconductor chip are face-down mounted on a redistribution layer, and a transparent substrate is disposed via a spacer on the sensor chip and the semiconductor chip)
27. Application Example to Mobile Body

### <1. First Embodiment>

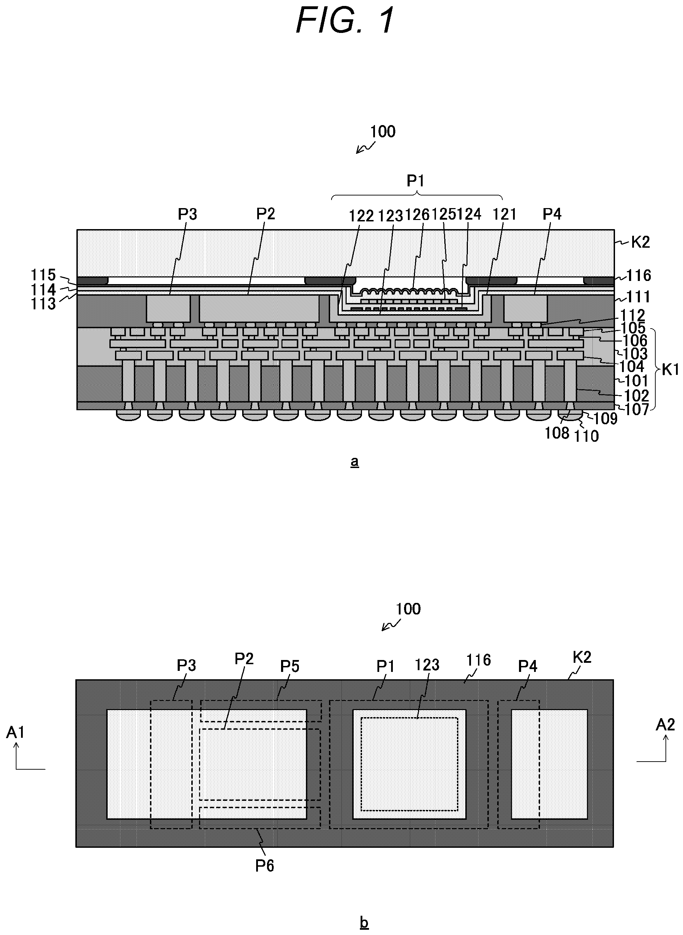

Fig. 1 is a diagram illustrating a configuration example of a sensor package according to a first embodiment. Note that a in the drawing is a cross-sectional view illustrating a configuration example of the sensor package according to the first embodiment, and b in the drawing is a plan view illustrating a configuration example of the sensor package according to the first embodiment. The cross-sectional view of a in the drawing is cut at the position of line A1-A2 of b in the drawing. Note that in the drawings used in the following description, a scale, a shape, and the like may be different from an actual structure in order to facilitate understanding of each configuration.

In the drawing, a sensor package 100 is, for example, SiP to which chiplets are applied. The sensor package 100 includes a sensor chip P1 and semiconductor chips P2 to P6.

In the sensor chip P1, a sensor element is formed. The sensor element may be an image sensor such as a Charge-Coupled Device (CCD) sensor, a Complementary Metal-Oxide Semiconductor (CMOS) sensor, or a Single Photon Avalanche Diode (SPAD) sensor. The light received by the image sensor may be visible light, near infrared (NIR) light, short wavelength infrared (SWIR) light, ultraviolet light, X-rays, or the like. The material used for the sensor element may be, for example, Si, InGaAs, InP, InSb, HgCdTe, or the like.

The sensor chip P1 includes a semiconductor substrate 121. A recess 122 is formed on the back surface side of the semiconductor substrate 121. In this case, the opening width of the recess 122 can be set to be smaller than the width of the semiconductor substrate 121 in consideration of positional deviation of the recess 122 and variation in the opening width. A sensor surface 123 is formed at the bottom of the recess 122. The sensor surface 123 can have sensitivity to incident light. For example, a back-side illumination image sensor may be formed in the sensor chip P1. In this case, pixels can be disposed on the sensor surface 123 in a matrix along the row direction and the column direction. A photodiode and a pixel transistor can be formed in each pixel. On the semiconductor substrate 121, a wiring layer is formed. The wiring layer can be bonded to protruding electrodes 112.

A semiconductor element is formed on each of the semiconductor chips P2 to P6. The semiconductor element may include a transistor, a resistor, a capacitor, and the like. As the semiconductor element, a memory may be formed, a processor may be formed, a signal processing circuit may be formed, a data processing circuit may be formed, or an interface circuit may be formed. The processor may be a single core or a multi-core. As the semiconductor element, for example, a hardware circuit such as a field-programmable gate array (FPGA) or an application specific integrated circuit (ASIC) may be formed. The semiconductor chips P2 to P6 may be different in type from each other, or may include the same type of chips. For example, the semiconductor chip P2 may be a core chip, the semiconductor chips P3 and P4 may be memory chips, and the semiconductor chips P5 and P6 may be IO chips. The material used for the semiconductor element may also be, for example, Si, GaAs, SiC, GaN, InGaAsP, or the like.

The sensor chip P1 and the semiconductor chips P2 to P6 are flip-chip mounted on a mounting surface of an interposer substrate K1 via each protruding electrode 112. The sensor chip P1 and each of the semiconductor chips P2 to P6 are disposed at different positions from one another on the interposer substrate K1. In this case, the distance between the sensor surface 123 of the sensor chip P1 and the mounting surface of the interposer substrate K1 can be shorter than the distance between the back surface of each of the semiconductor chips P2 to P6 and the mounting surface of the interposer substrate K1. The protruding electrode 112 may be a pillar electrode or a solder ball.

On the interposer substrate K1, the sensor chip P1 and the semiconductor chips P2 to P6 are collectively sealed with a sealing material 111. The sealing material 111 may be, for example, a molding resin or a potting material. The heights of the sensor chip P1, the semiconductor chips P2 to P6, and the sealing material 111 with respect to the interposer substrate K1 can be equal to one another. In this case, the back surfaces of the sensor chip P1 and the semiconductor chips P2 to P6 are exposed from the sealing material 111.

The interposer substrate K1 includes a base substrate 101. The base substrate 101 may be, for example, a resin substrate, a Si substrate, a glass substrate, or a glass epoxy substrate. A wiring layer 103 is formed on the base substrate 101. Through electrodes 102 are embedded in the base substrate 101 and connected to the wiring layer 103.

Wiring lines 104 and land electrodes 105 embedded in an insulating layer are formed in the wiring layer 103. Each land electrode 105 is exposed on a surface of the wiring layer 103. Furthermore, vias 106 used for interlayer connection are formed in the wiring layer 103. The protruding electrodes 112 are bonded onto the land electrodes 105. The through electrodes 102 are connected to the wiring lines 104.

An insulating layer 107 is formed on the back surface of the base substrate 101. Land electrodes 109 are formed on the insulating layer 107. Vias 108 are embedded in the insulating layer 107. In this case, the land electrodes 109 are connected to the through electrodes 102 via the vias 108. Protruding electrodes 110 are formed on the land electrodes 109. Each protruding electrode 110 may be a pillar electrode or a solder ball. The material of the insulating layer 107 may be, for example, an inorganic material such as SiO₂, SiN, or SiCN, or an organic material such as a solder resist.

As the materials of the wiring lines 104, the land electrodes 105 and 109, and the vias 106 and 108, for example, a metal such as Al, Cu, AlCu, AlSiCu, or Co can be used. As the material of the through electrode 102, for example, a metal such as Cu, Ti, Ta, Al, W, Ni, Ru, or Co can be used, and a laminated structure of a plurality of materials may be used.

On the sealing material 111, an underlayer 113 is formed to cover the back surface of each of the sensor chip P1 and the semiconductor chips P2 to P6. Here, the inner surface of the recess 122 of the semiconductor substrate 121 is covered with the underlayer 113. In this case, the underlayer 113 is formed on the sensor surface 123. The material of the underlayer 113 may be, for example, SiO₂ or tetraethyl orthosilicate (TEOS).

A light shielding layer 124 is formed on the underlayer 113 on the sensor surface 123. The light shielding layer 124 can be used for optical black (OPB) pixels. As the material of the light shielding layer 124, a metal such as Al, Cu, Ag, Ti, or W may be used, or a black resin may be used.

On the back surface side of each of the sensor chip P1 and the semiconductor chips P2 to P6, a protective film 114 is formed on the underlayer 113 to cover the light shielding layer 124. For example, TEOS can be used as the material of the protective film 114.

A color filter 125 is formed on the protective film 114 on the sensor surface 123 for each pixel. An on-chip lens 126 is formed on the color filter 125 for each pixel. As the material of the color filter 125 and the on-chip lens 126, for example, an insulator such as SiO₂, SiN, or SiCN, or a transparent resin such as acrylic or polycarbonate can be used. The color filter 125 may include a pigment. For example, the color filter 125 may form a Bayer array or a quad-Bayer array. The color filter 125 may include an RGB filter, a complementary color filter, or a white filter. A meta-surface may be formed on the sensor surface 123. The meta-surface may include a color splitter or a deflector.

On the back surface side of each of the sensor chip P1 and the semiconductor chips P2 to P6, a protective film 115 is formed on the protective film 114 to cover the on-chip lens 126. A material of the protective film 115 may be, for example, low temperature oxide (LTO) or polyimide.

The transparent substrate K2 is bonded to the protective film 115 via an adhesive layer 116. In this case, a cavity is formed between the transparent substrate K2 and the protective film 115 on the back surface side of each of the sensor chip P1 and the semiconductor chips P2 to P6. The height of the cavity on the sensor surface 123 may be greater than the heights of cavities on the regions other than the sensor surface 123. The transparent substrate K2 may be a glass substrate, a quartz substrate, or a transparent resin substrate including acrylic, polycarbonate, or the like. As the transparent substrate K2, Al₂O₃, CaF₂, MgF₂, LiF, or the like may be used according to a wavelength detected by the sensor chip P1. The adhesive layer 116 may be a thermosetting resin such as epoxy or an ultraviolet curable resin. The adhesive layer 116 may be blackened or may include an opaque layer in order to reduce flare or the like on the sensor surface 123. For example, the adhesive layer 116 may contain a black pigment such as carbon black or may contain a filler such as carbon fiber.

Here, the transparent substrate K2 is chipped to have the same size as the interposer substrate K1. In this case, positions of end portions of the transparent substrate K2 in the horizontal direction can be aligned with positions of end portions of the interposer substrate K1 in the horizontal direction. Furthermore, the positions of the end portions of the interposer substrate K1 in the horizontal direction can be aligned with positions of end portions of the sealing material 111 in the horizontal direction. As a result, the sensor package 100 can form a wafer level chip size package (WLCSP) packaged at the wafer level.

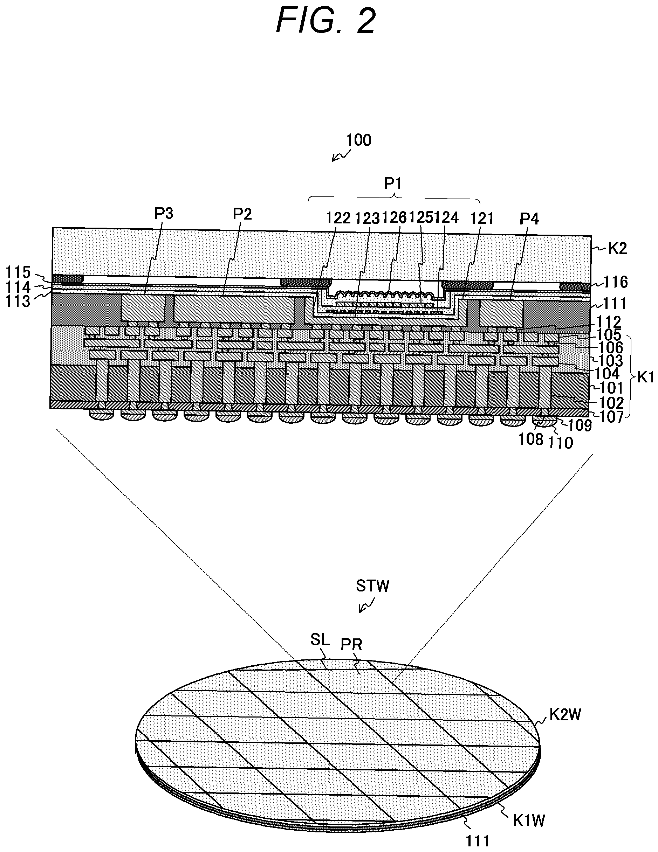

Figs. 2 to 8 are cross-sectional views, each illustrating an example of a method for manufacturing a sensor package according to the first embodiment.

In Fig. 2, in a stacked wafer STW, an interposer wafer K1W is stacked on a transparent substrate wafer K2W via the sealing material 111 in which the sensor chip P1 and the semiconductor chips P2 to P6 are collectively sealed. The stacked wafer STW is provided with partitioned regions PR. The sensor package 100 is cut out from each partitioned region PR. Partitioning of the partitioned regions PR is performed along a scribe line SL. The sensor package 100 can be formed by singulating the stacked wafer STW along the scribe line SL. In this case, the interposer substrate K1 is cut out from the interposer wafer K1W. A transparent substrate K2 is cut out from the transparent substrate wafer K2W.

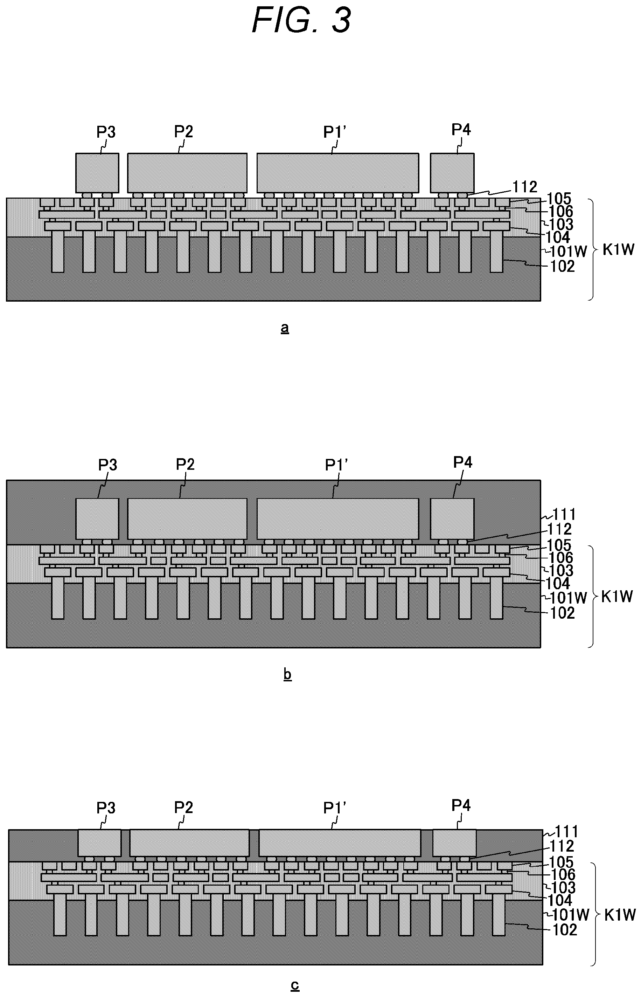

In the formation of the stacked wafer STW, as illustrated in a of Fig. 3, the sensor chip P1' and the semiconductor chips P2 to P6 before the formation of the recess 122 are flip-chip mounted on the interposer wafer K1W for each partitioned region PR.

Next, as illustrated in b of Fig. 3, the sealing material 111 is formed on the interposer wafer K1W to cover the sensor chip P1' and the semiconductor chips P2 to P6 in each partitioned region PR. In this case, the sensor chip P1' and the semiconductor chips P2 to P6 in each partitioned region PR are collectively sealed with the sealing material 111.

Next, as illustrated in c of Fig. 3, the back surface side of the sensor chip P1' and semiconductor chips P2 to P6 is thinned together with the sealing material 111. In this case, the back surfaces of the sensor chip P1' and semiconductor chips P2 to P6 are exposed from the sealing material 111. In this thinning, chemical mechanical polishing (CMP) may be used, back grinding may be used, or etch back may be used.

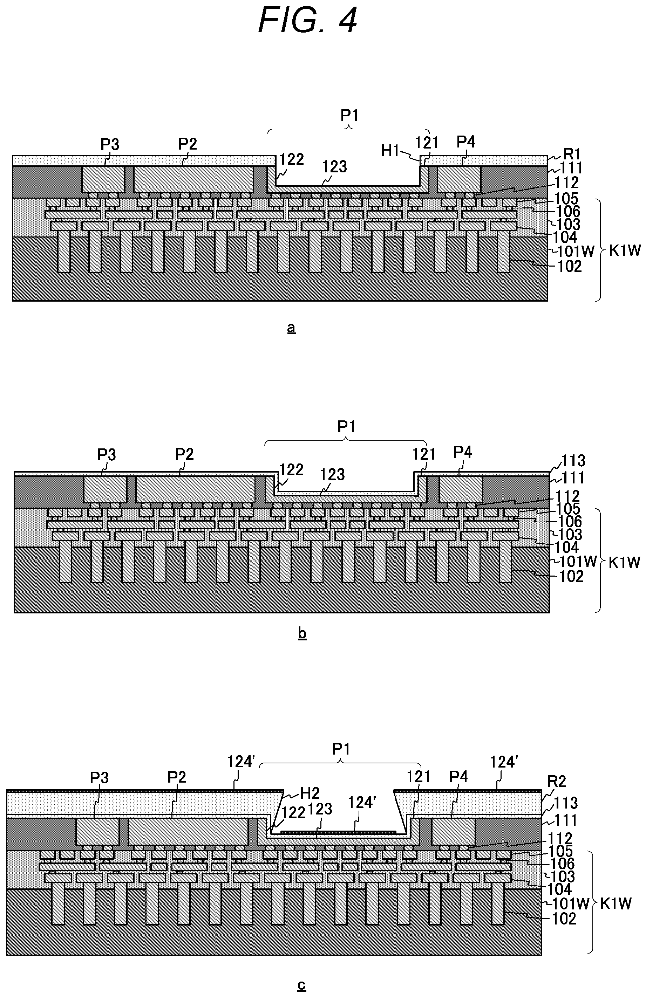

Next, as illustrated in a of Fig. 4, a resist pattern R1 provided with an opening portion H1 is formed on the sealing material 111 on the basis of a lithography technique. The opening portion H1 can be disposed at a position where the sensor surface 123 is formed. In this case, a peripheral portion of the back surface of the sensor chip P1' and the back surfaces of the semiconductor chips P2 to P6 can be covered with the resist pattern R1.

Then, the semiconductor substrate 121 of the sensor chip P1' is etched using the resist pattern R1 as an etching mask to form the recess 122 on the back surface side of the semiconductor substrate 121. In this case, the sensor surface 123 can be formed at the bottom of the recess 122. In this etching, for example, anisotropic etching such as reactive ion etching (RIE) can be used.

Next, as illustrated in b of Fig. 4, the resist pattern R1 is removed by a method such as ashing. Then, the underlayer 113 is formed on the sealing material 111 in such a way that the sensor surface 123 is covered by a method such as sputtering or chemical vapor deposition (CVD). In this case, the back surface of the sensor chip P1 and the back surfaces of the semiconductor chips P2 to P6 can be covered with the underlayer 113.

Next, as illustrated in c of Fig. 4, a resist pattern R2 provided with an opening portion H2 is formed on the underlayer 113 on the basis of a lithography technique. The opening portion H2 can be disposed on the sensor surface 123. In this case, end portions of the opening portion H2 can be formed in a reverse tapered shape. The narrow-side end portions of the reverse taper can form an acute angle. The positions of the narrow-side end portions of the reverse taper can be aligned with the end portions of the sensor surface 123. The reverse taper of the opening portion H2 can be formed by adjusting exposure conditions.

Then, a light shielding material 124' is formed on the sensor surface 123 by a method such as sputtering. In this case, the light shielding material 124' is also formed on the resist pattern R2. In the film formation of the light shielding material 124', it is possible to spray a light shielding raw material toward the sensor surface 123 from the vertical direction, thereby preventing wraparound of the light shielding raw material. Thus, the light shielding material 124' is not allowed to adhere to the position retracted from the reverse taper of the opening portion H2. Therefore, it is possible to avoid the formation of the light shielding material 124' on the side surfaces of the underlayer 113 in the recess 122, and to avoid the occurrence of flare and the like.

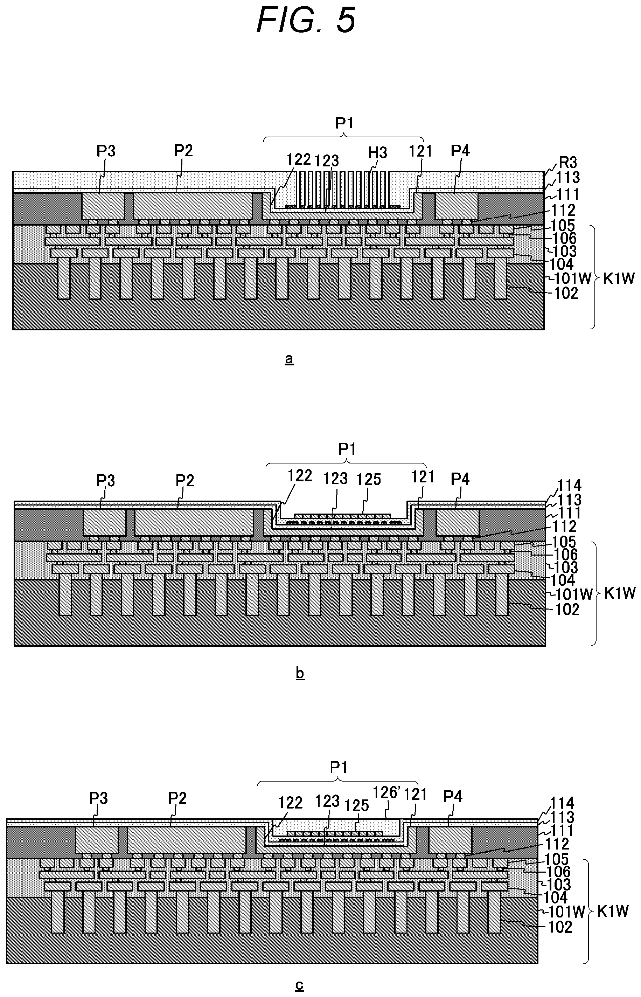

Next, as illustrated in a of Fig. 5, the resist pattern R2 is removed using a peeling solution. In this case, the light shielding material 124' on the resist pattern R2 can be lifted off while leaving the light shielding material 124' on the sensor surface 123.

Then, a resist pattern R3 provided with an opening portion H3 is formed on the light shielding material 124' on the basis of a lithography technique. The opening portion H3 can be disposed at a separation position of the light shielding material 124'. In this case, on the underlayer 113, a region where the light shielding material 124' is not formed can be covered with the resist pattern R3.

Then, by etching the light shielding material 124' using the resist pattern R3 as an etching mask, the light shielding layer 124 is formed on the underlayer 113 on the sensor surface 123. Note that anisotropic etching such as RIE can be used for the etching, for example.

Next, as illustrated in b of Fig. 5, the resist pattern R3 is removed by a method such as ashing. Then, the protective film 114 is formed on the underlayer 113 to cover the light shielding layer 124 by a method such as sputtering or CVD. Moreover, the color filter 125 is formed on the protective film 114 on the sensor surface 123 for each pixel.

Next, as illustrated in c of Fig. 5, a lens material 126' is formed on the protective film 114 to cover the color filter 125. In this case, the lens material 126' can be flattened to expose a surface of the protective film 114.

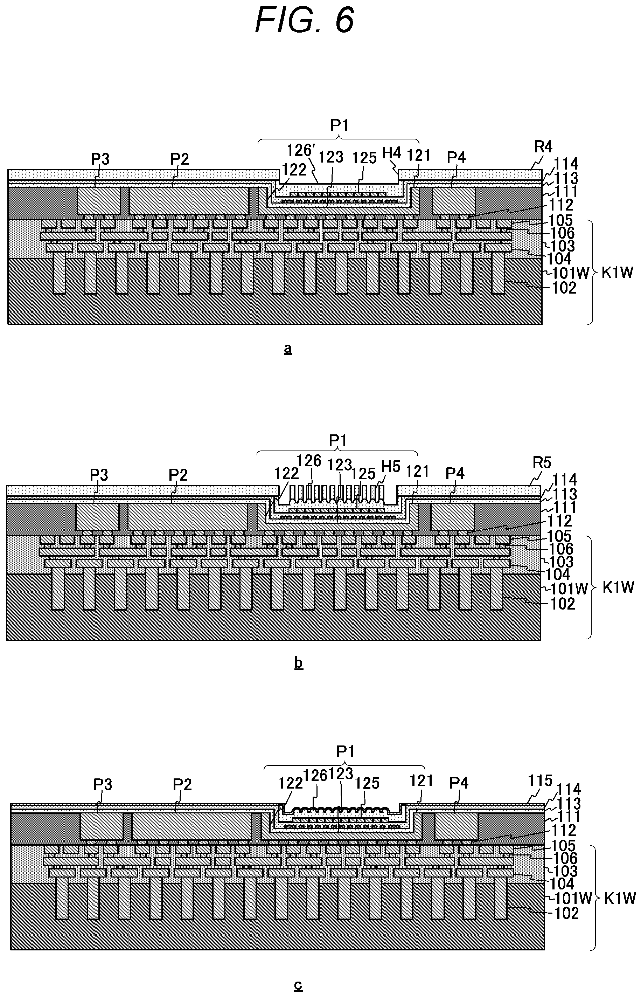

Next, as illustrated in a of Fig. 6, a resist pattern R4 provided with an opening portion H4 is formed on the protective film 114 on the basis of a lithography technique. The opening portion H4 can be disposed on the sensor surface 123. In this case, on the protective film 114, a region where the lens material 126' is not formed can be covered with the resist pattern R4.

Then, by etching the lens material 126' using the resist pattern R4 as an etching mask, the lens material 126' on the sensor surface 123 is thinned. Note that anisotropic etching such as RIE can be used for the etching, for example.

Next, as illustrated in b of Fig. 6, the resist pattern R4 is removed by a method such as ashing. Then, a resist pattern R5 provided with the opening portion H5 is formed on the lens material 126' on the basis of a lithography technique. The opening portion H5 can be disposed at a separation position of the on-chip lens 126. In this case, on the protective film 114, a region where the lens material 126' is not formed can be covered with the resist pattern R5.

Then, by etching the lens material 126' using the resist pattern R5 as an etching mask, the on-chip lens 126 is formed on the sensor surface 123. Note that anisotropic etching such as RIE can be used for the etching, for example. In this case, a lens surface can be formed on the on-chip lens 126 on the basis of heat treatment and surface tension at the time of etching of the lens material 126'.

Next, as illustrated in c of Fig. 6, the resist pattern R5 is removed by a method such as ashing. Then, the protective film 115 is formed on the protective film 114 to cover the on-chip lens 126 by a method such as sputtering or CVD.

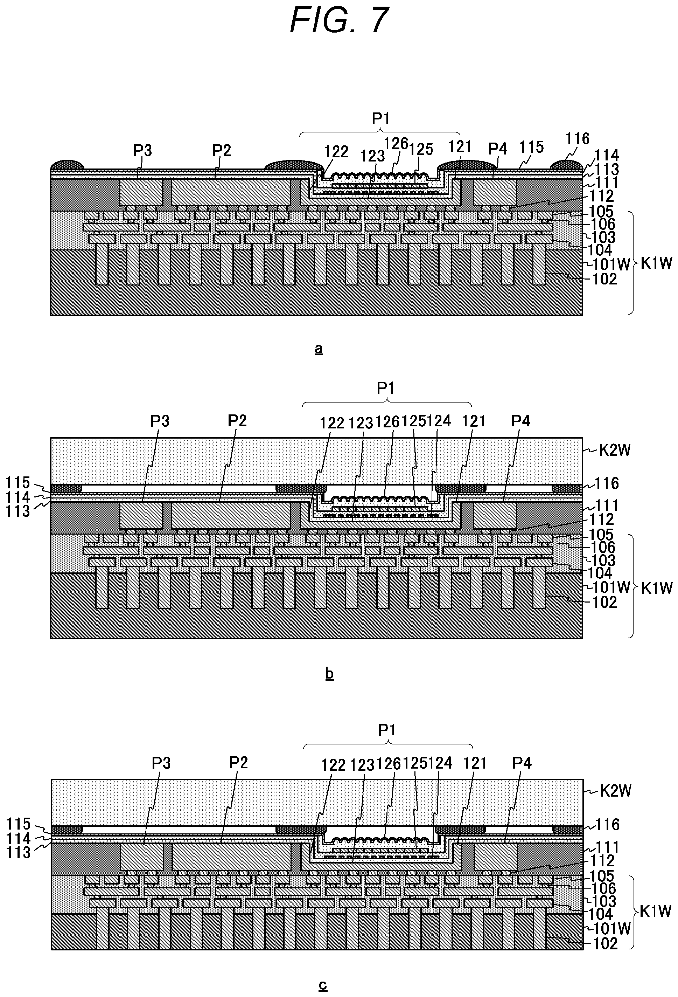

Next, as illustrated in a of Fig. 7, the adhesive layer 116 is formed on the protective film 115. The adhesive layer 116 can be disposed in a peripheral portion of the sensor chip P1 and a peripheral portion of the sensor package 100. Furthermore, the adhesive layer 116 may be disposed on the scribe line SL. The adhesive layer 116 may be formed by potting, printing, or ink-jet printing.

Next, as illustrated in b of Fig. 7, the transparent substrate wafer K2W is bonded to the protective film 115 via the adhesive layer 116. Then, the adhesive layer 116 is cured to fix the transparent substrate wafer K2W to the protective film 115.

Next, as illustrated in c of Fig. 7, the back surface side of the interposer wafer K1W is thinned to expose the through electrodes 102. In this thinning, CMP may be used, back grinding may be used, or etch back may be used. Note that, in the thinning of the interposer wafer K1W, a protective film may be attached onto the transparent substrate wafer K2W in order to avoid the formation of scratches on the transparent substrate wafer K2W.

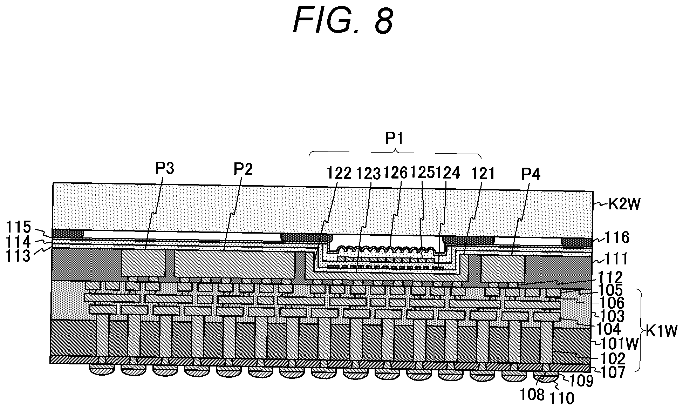

Next, as illustrated in Fig. 8, the insulating layer 107 is formed on the interposer wafer K1W. After the vias 108 are embedded in the insulating layer 107, the land electrodes 109 connected to the vias 108 are formed on the insulating layer 107. Moreover, the protruding electrodes 110 are formed on the land electrodes 109. In this case, the stacked wafer STW before being singulated into in the sensor package 100 is formed.

Next, as illustrated in Fig. 1, the stacked wafer STW is cut along the scribe line SL to be singulated into the sensor package 100. For the cutting of the stacked wafer STW, dicing may be used, or a laser cutter may be used.

Note that, in the first embodiment described above, the example in which the through electrodes 102 are formed in the interposer wafer K1W before the sensor chip P1' and the semiconductor chips P2 to P6 are collectively sealed with the sealing material 111 has been described. Alternatively, after the sensor chip P1' and the semiconductor chips P2 to P6 are collectively sealed with the sealing material 111, the through electrodes 102 may be formed in the interposer wafer K1W.

As described above, in the first embodiment described above, the sensor chip P1 in which the sensor surface 123 is formed at the bottom of the recess 122 and the semiconductor chips P2 to P6 are flip-chip mounted on the interposer substrate K1, and the transparent substrate K2 is disposed via the cavities on the sensor chip P1 and on the semiconductor chips P2 to P6. As a result, it is possible to increase the mounting density of the sensor chip P1 and the semiconductor chips P2 to P6 on the interposer substrate K1 while reducing the stress applied to the semiconductor chips P2 to P6 via the adhesive layer 116. In this case, by forming the sensor surface 123 at the bottom of the recessed portion 122 formed on the back surface side of the semiconductor substrate 121, it is possible to form the back-side illumination image sensor in the sensor package 100 while maintaining the thicknesses of the semiconductor chips P2 to P6.

### <2. Second Embodiment>

In the first embodiment described above, the sensor chip P1 and the semiconductor chips P2 to P6 are flip-chip mounted on the interposer substrate K1, and the transparent substrate K2 is disposed via the cavities on the sensor chip P1 and on the semiconductor chips P2 to P6. In this second embodiment, the sensor chip P1 and the semiconductor chips P2 to P6 are flip-chip mounted on the interposer substrate K1, and the transparent substrate K2 is disposed via the cavity on the sensor chip P1.

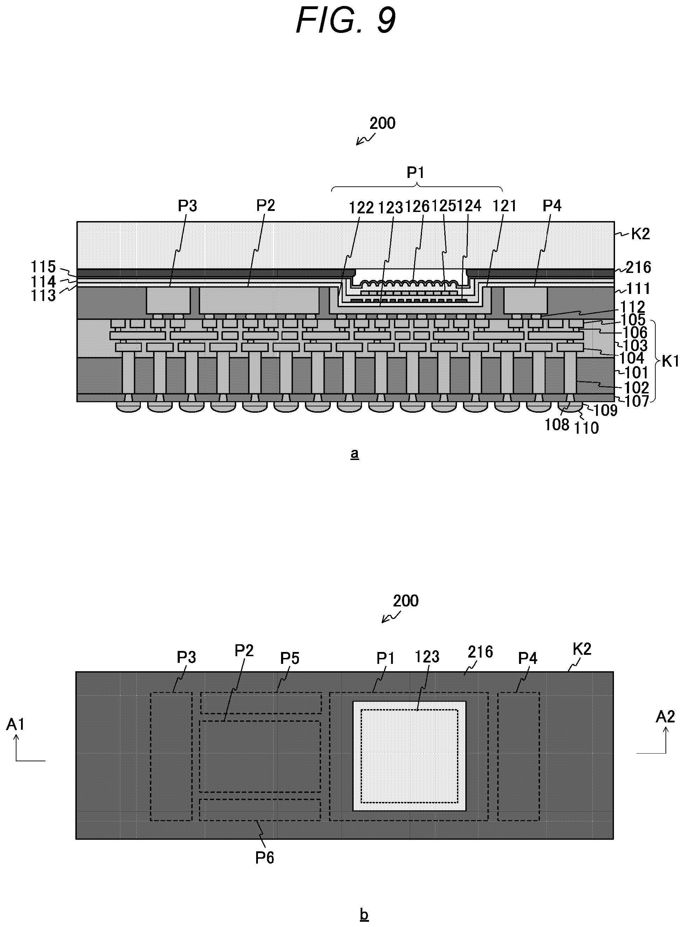

Fig. 9 is a diagram illustrating a configuration example of a sensor package according to the second embodiment. Note that a in the drawing is a cross-sectional view illustrating a configuration example of the sensor package according to the second embodiment, and b in the drawing is a plan view illustrating a configuration example of the sensor package according to the second embodiment.

In the drawing, a sensor package 200 includes an adhesive layer 216 instead of the adhesive layer 116 of the first embodiment described above. Other configurations of the sensor package 200 of the second embodiment are similar to the configurations of the sensor package 100 of the first embodiment described above.

The transparent substrate K2 is bonded to the protective film 115 via the adhesive layer 216. In this case, the cavity is formed between the transparent substrate K2 and the protective film 115 on the back surface side of the sensor chip P1. Other configurations of the adhesive layer 216 of the second embodiment are similar to the configurations of the adhesive layer 116 of the first embodiment described above.

As described above, in the second embodiment described above, the transparent substrate K2 is supported on the sensor chip P1 and on the semiconductor chips P2 to P6 via the adhesive layer 216, and a cavity is provided on the sensor chip P1. As a result, as compared to the configuration in which the cavities are formed on the semiconductor chips P2 to P6, the contact area between the adhesive layer 216 and the protective film 115 can be increased, and the bonding strength to the transparent substrate K2 can be increased.

### <3. Third Embodiment>

In the first embodiment described above, the transparent substrate K2 was supported on the sensor chip P1 and on the semiconductor chips P2 to P6 via the adhesive layer 116, and cavities were provided on the sensor chip P1 and the semiconductor chips P2 to P6. In this third embodiment, the sensor chip P1 and the semiconductor chips P2 to P6 are flip-chip mounted on the interposer substrate K1, and the sensor chip P1 and the semiconductor chips P2 to P6 are bonded to the transparent substrate K2 via the transparent resin to achieve a cavity-less structure.

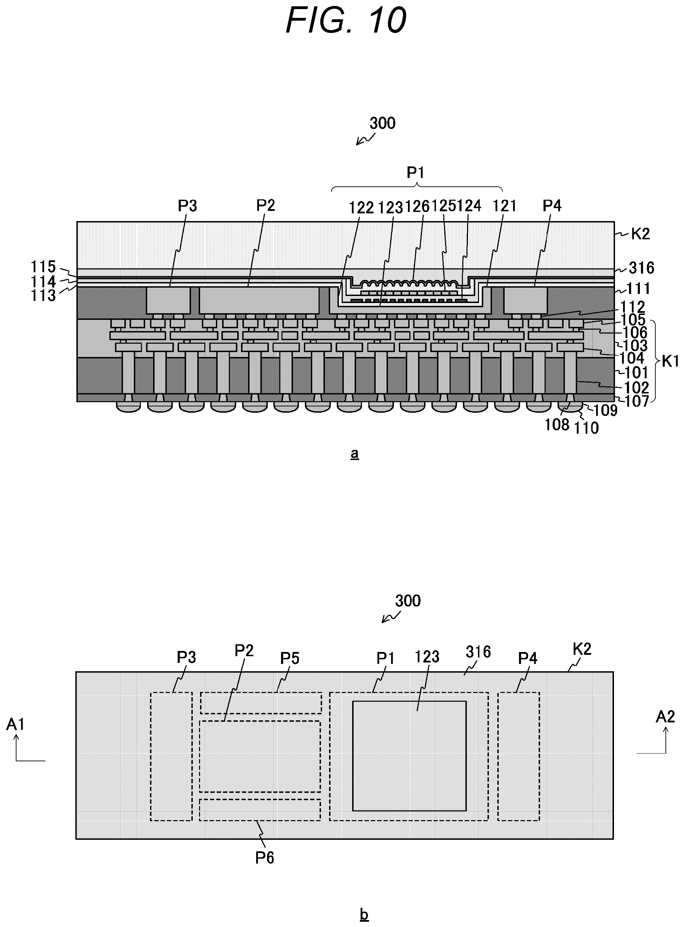

Fig. 10 is a diagram illustrating a configuration example of a sensor package according to the third embodiment. Note that a in the drawing is a cross-sectional view illustrating a configuration example of the sensor package according to the third embodiment, and b in the drawing is a plan view illustrating a configuration example of the sensor package according to the third embodiment.

In the drawing, a sensor package 300 includes a transparent resin 316 instead of the adhesive layer 116 of the first embodiment described above. Other configurations of the sensor package 300 of the third embodiment are similar to the configurations of the sensor package 100 of the first embodiment described above.

The transparent substrate K2 is bonded to the protective film 115 via the transparent resin 316. The transparent resin 316 is formed on the entire surface of the protective film 115. In this case, the recess 122 is also filled with the transparent resin 316. Here, the cavity-less structure is formed between the transparent substrate K2 and the protective film 115 on the back surface side of the sensor chip P1 and semiconductor chips P2 to P6.

The transparent resin 316 may be a thermosetting resin or an ultraviolet curable resin. The material of the transparent resin 316 may be, for example, a siloxane-based resin, an acrylic resin, an epoxy-based resin, or the like. In this case, the material of the transparent resin 316 can be selected in such a way that a refractive index difference with the on-chip lens 126 is secured. The transparent resin 316 may contain a filler including an inorganic substance or an organic substance in order to improve reliability. As the transparent resin 316, a material having adjusted optical characteristics (refractive index, extinction coefficient, and the like) may be selected in such a way that light can be well received in an effective pixel region.

As described above, in the above-described third embodiment, the sensor chip P1 and the semiconductor chips P2 to P6 are bonded to the transparent substrate K2 via the transparent resin 316, and the cavity-less structure on the sensor surface 123 can be achieved. Therefore, while enabling light reception at the sensor surface 123, it can be unnecessary to provide the cavity in the sensor package 300. As a result, it is possible to improve the strength of the sensor package 300, and there is no need to avoid the formation of the transparent resin 316 on the sensor surface 123, thereby enabling simplification of the manufacturing process.

### <4. Fourth Embodiment>

In the first embodiment described above, the transparent substrate K2 was supported on the sensor chip P1 and the semiconductor chips P2 to P6 via the adhesive layer 116 in order to provide the cavities on the sensor chip P1 and on the semiconductor chips P2 to P6. In this fourth embodiment, a spacer is provided between the adhesive layer 116 and the transparent substrate K2 in order to adjust the heights of the cavities on the sensor chip P1 and on the semiconductor chips P2 to P6.

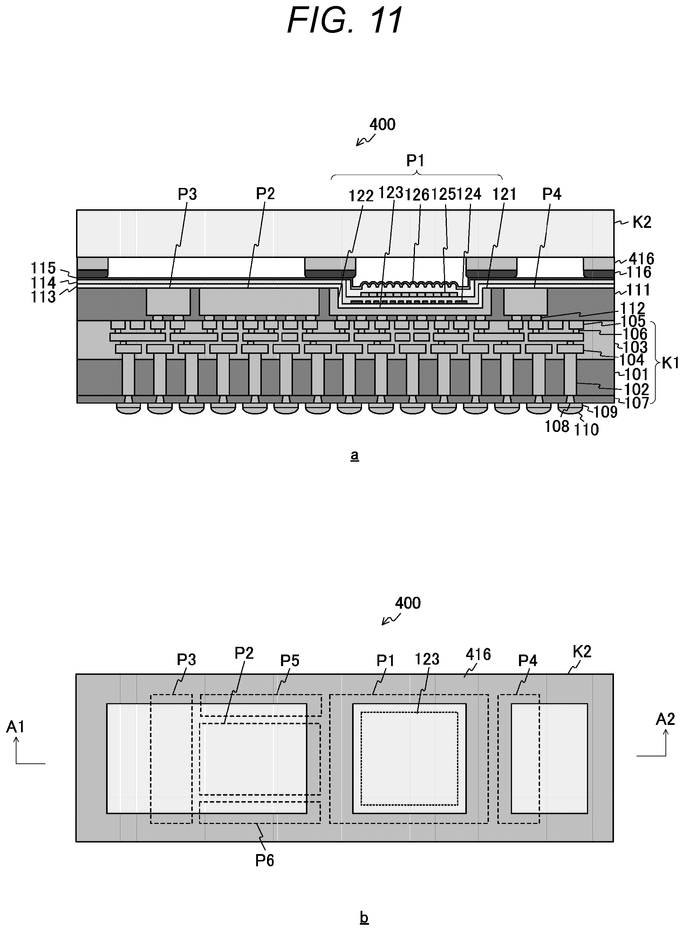

Fig. 11 is a diagram illustrating a configuration example of a sensor package according to the fourth embodiment. Note that a in the drawing is a cross-sectional view illustrating a configuration example of the sensor package according to the fourth embodiment, and b in the drawing is a plan view illustrating a configuration example of the sensor package according to the fourth embodiment.

In the drawing, in a sensor package 400, a spacer 416 is added to the sensor package 100 of the first embodiment described above. Other configurations of the sensor package 400 of the fourth embodiment are similar to the configurations of the sensor package 100 of the first embodiment described above.

The spacer 416 is provided between the adhesive layer 116 and the transparent substrate K2. The planar shape of the spacer 416 may be identical to the planar shape of the adhesive layer 116. Here, the spacer 416 can be bonded to the transparent substrate K2. In this case, the cavities can be ensured on the sensor chip P1 and on the semiconductor chips P2 to P6 by the adhesive layer 116 and the spacer 416. The material of the spacer 416 may be a resin such as epoxy or a metal such as stainless steel. The spacer 416 may be blackened to reduce flares or the like on the sensor surface 123.

As described above, in the above-described fourth embodiment, the spacer 416 is provided between the adhesive layer 116 and the transparent substrate K2. As a result, the heights of the cavities on the sensor chip P1 and on the semiconductor chips P2 to P6 can be adjusted, and the optical characteristics on the sensor surface 123 can be adjusted.

Note that, in the above-described fourth embodiment, the example in which the spacer 416 is provided between the adhesive layer 116 and the transparent substrate K2 of the above-described first embodiment has been described, but a spacer may be provided between the adhesive layer 216 and the transparent substrate K2 of the above-described second embodiment.

### <5. Fifth Embodiment>

In the first embodiment described above, the single sensor chip P1 and the semiconductor chips P2 to P6 are flip-chip mounted on the interposer substrate K1. In this fifth embodiment, a plurality of sensor chips and semiconductor chips are flip-chip mounted on an interposer substrate, and a transparent substrate is disposed via cavities on the plurality of sensor chips and the semiconductor chips.

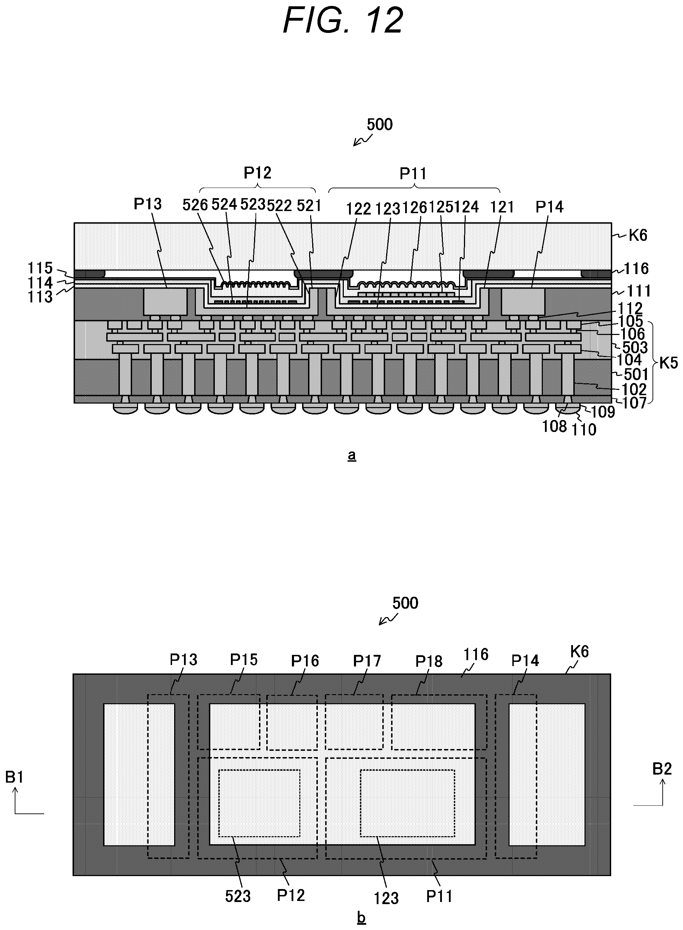

Fig. 12 is a diagram illustrating a configuration example of a sensor package according to the fifth embodiment. Note that a in the drawing is a cross-sectional view illustrating a configuration example of the sensor package according to the fifth embodiment, and b in the drawing is a plan view illustrating a configuration example of the sensor package according to the fifth embodiment. Note that the cross-sectional view of a in the drawing is cut at the position of line B1-B2 of b in the drawing.

In the drawing, a sensor package 500 includes sensor chips P11 and P12, semiconductor chips P13 to P18, an interposer substrate K5, and a transparent substrate K6 instead of the sensor chip P1, the semiconductor chips P2 to P6, the interposer substrate K1, and the transparent substrate K2 of the first embodiment described above. Other configurations of the sensor package 500 of the fifth embodiment are similar to the configurations of the sensor package 100 of the first embodiment described above.

The sensor chip P11 can be configured similarly to the sensor chip P1. In this case, the light shielding layer 124, the color filter 125, and the on-chip lens 126 can be formed on the sensor surface 123 of the sensor chip P11.

In the sensor chip P12, a sensor element is formed. The sensor chip P12 is different in type from the sensor chip P11. For example, the sensitivity band of the sensor chip P12 may be different from the sensitivity band of the sensor chip P11, the sensor chip P12 may be an infrared sensor, and the sensor chip P11 may be a visible light sensor. Alternatively, the sensor chip P11 may be a CMOS image sensor, and the sensor chip P12 may be an event-base vision sensor (EVS). The plane size of the sensor chip P12 may be different from the plane size of the sensor chip P11.

The sensor chip P12 includes a semiconductor substrate 521. A recess 522 is formed on the back surface side of the semiconductor substrate 521. A sensor surface 523 is formed at the bottom of the recess 522. The sensor surface 523 can have sensitivity to incident light. A wiring layer bonded to protruding electrodes 112 is formed on the semiconductor substrate 521.

A semiconductor element is formed on each of the semiconductor chips P13 to P18. The types of the semiconductor chips P13 to P18 may be different from each other, or may include the same type of chips. For example, the semiconductor chips P15 and P18 may be core chips, the semiconductor chips P16 and P17 may be memory chips, and the semiconductor chips P13 and P14 may be IO chips.

The sensor chips P11 and P12, and the semiconductor chips P13 to P18 are flip-chip mounted on a mounting surface of an interposer substrate K5 via each protruding electrode 112. The sensor chips P11 and P12 and the semiconductor chips P13 to P18 are disposed at different positions from one another on the interposer substrate K5. On the interposer substrate K5, the sensor chips P11 and P12 and the semiconductor chips P13 to P18 are collectively sealed with a sealing material 111.

The interposer substrate K5 includes a base substrate 501. A wiring layer 503 is formed on the base substrate 501. The through electrodes 102 are embedded in the base substrate 501 and connected to the wiring layer 503. The wiring lines 104 and the land electrodes 105 are formed in the wiring layer 503. Furthermore, vias 106 used for interlayer connection are formed in the wiring layer 503. An insulating layer 107 is formed on the back surface of the base substrate 501.

On the sealing material 111, an underlayer 113 is formed to cover the back surface of each of the sensor chips P11 and P12 and the semiconductor chips P13 to P18. Here, the inner surfaces of the recesses 122 and 522 of the semiconductor substrates 121 and 521 are covered with the underlayer 113. In this case, the underlayer 113 is formed on each of the sensor surfaces 123 and 523. On the sensor surface 523, a light shielding layer 524 is formed on the underlayer 113.

On the back surface side of each of the sensor chips P11 and P12 and the semiconductor chips P13 to P18, a protective film 114 is formed on the underlayer 113 to cover the light shielding layers 124 and 524.

On the protective film 114 on the sensor surface 523, an on-chip lens 526 is formed for each pixel. On the back surface side of each of the sensor chips P11 and P12 and the semiconductor chips P13 to P18, a protective film 115 is formed on the protective film 114 to cover the on-chip lenses 126 and 526.

The transparent substrate K6 is bonded to the protective film 115 via an adhesive layer 116. In this case, a cavity is formed between the transparent substrate K6 and the protective film 115 on the back surface side of each of the sensor chips P11 and P12 and the semiconductor chips P13 to P18.

Here, the transparent substrate K6 is chipped to have the same size as the interposer substrate K5. In this case, positions of end portions of the transparent substrate K6 in the horizontal direction can be aligned with positions of end portions of the interposer substrate K5 in the horizontal direction. The positions of the end portions of the interposer substrate K5 in the horizontal direction can be aligned with positions of end portions of the sealing material 111 in the horizontal direction. As a result, the sensor package 500 can constitute a WLCSP packaged at the wafer level.

As described above, in the above-described fifth embodiment, the sensor chips P11 and P12 and the semiconductor chips P13 to P18 are flip-chip mounted on the interposer substrate K5, and the transparent substrate K6 is disposed via cavities on the sensor chips P11 and P12 and the semiconductor chips P13 to P18. As a result, it is possible to increase the mounting density of the sensor chips P11 and P12 and the semiconductor chips P13 to P18 on the interposer substrate K1 while diversifying the sensing functions.

### <6. Sixth Embodiment>

In the above-described fifth embodiment, the sensor chips P11 and P12 and the semiconductor chips P13 to P18 are flip-chip mounted on the interposer substrate K5, and the transparent substrate K6 is disposed via cavities on the sensor chips P11 and P12 and the semiconductor chips P13 to P18. In this sixth embodiment, the sensor chips P11 and P12 and the semiconductor chips P13 to P18 are flip-chip mounted on the interposer substrate K5, and the transparent substrate K6 is disposed via cavities on the sensor chips P11 and P12.

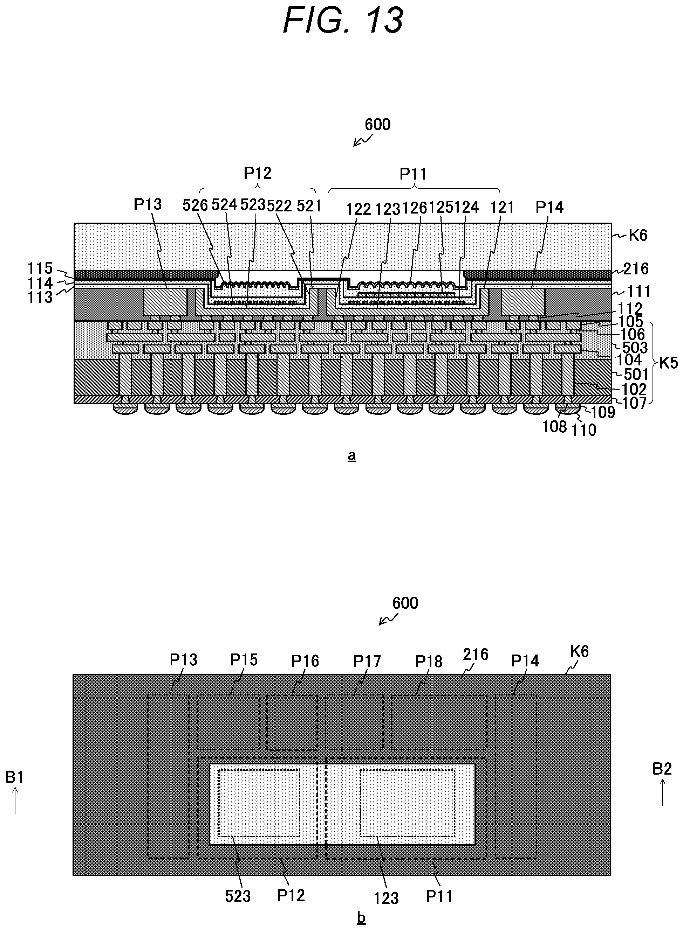

Fig. 13 is a diagram illustrating a configuration example of a sensor package according to the sixth embodiment. Note that a in the drawing is a cross-sectional view illustrating a configuration example of the sensor package according to the sixth embodiment, and b in the drawing is a plan view illustrating a configuration example of the sensor package according to the sixth embodiment.

In the drawing, a sensor package 600 includes an adhesive layer 216 instead of the adhesive layer 116 of the fifth embodiment described above. Other configurations of the sensor package 600 of the sixth embodiment are similar to the configurations of the sensor package 500 of the fifth embodiment described above.

The transparent substrate K6 is bonded to the protective film 115 via the adhesive layer 216. In this case, a cavity is formed between the transparent substrate K6 and the protective film 115 on the back surface side of each of the sensor chips P11 and P12. Other configurations of the adhesive layer 216 of the sixth embodiment are similar to the configurations of the adhesive layer 116 of the fifth embodiment described above.

As described above, in the above-described sixth embodiment, the transparent substrate K6 is supported on the sensor chips P11 and P12 and the semiconductor chips P13 to P18 via the adhesive layer 216, and a cavity is provided on each of the sensor chips P11 and P12. As a result, the contact area between the adhesive layer 216 and the protective film 115 can be increased with respect to the configuration in which cavities are formed on the semiconductor chips P13 to P18, and the bonding strength of the transparent substrate K6 can be increased.

### <7. Seventh Embodiment>

In the above-described fifth embodiment, the transparent substrate K6 is supported on the sensor chips P11 and P12 and the semiconductor chips P13 to P18 via the adhesive layer 116, and a cavity is provided on the sensor chips P11 and P12 and the semiconductor chips P13 to P18. In this seventh embodiment, the sensor chips P11 and P12 and the semiconductor chips P13 to P18 are flip-chip mounted on the interposer substrate K5, and the sensor chips P11 and P12 and the semiconductor chips P13 to P18 are bonded to the transparent substrate K6 via the transparent resin 316 to achieve a cavity-less structure.

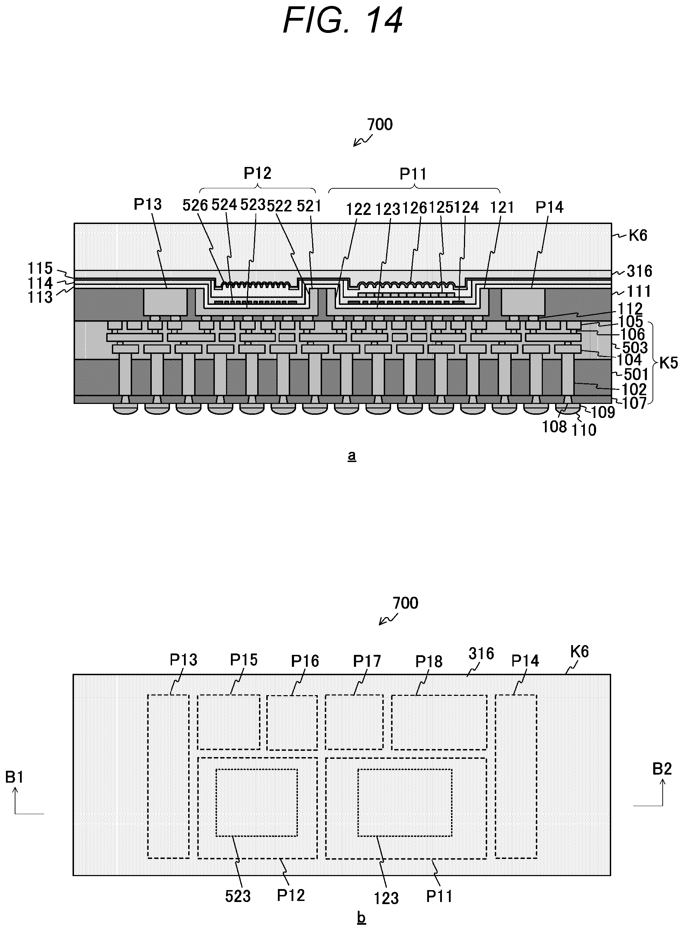

Fig. 14 is a diagram illustrating a configuration example of a sensor package according to the seventh embodiment. Note that a in the drawing is a cross-sectional view illustrating a configuration example of the sensor package according to the seventh embodiment, and b in the drawing is a plan view illustrating a configuration example of the sensor package according to the seventh embodiment.

In the drawing, a sensor package 700 includes a transparent resin 316 instead of the adhesive layer 116 of the fifth embodiment described above. Other configurations of the sensor package 700 of the seventh embodiment are similar to the configurations of the sensor package 500 of the fifth embodiment described above.

The transparent substrate K6 is bonded to the protective film 115 via the transparent resin 316. The transparent resin 316 is formed on the entire surface of the protective film 115. In this case, the recesses 122 and 521 are also filled with the transparent resin 316. Here, on the back surface side of each of the sensor chips P11 and P12 and the semiconductor chips P13 to P18, the cavity-less structure is achieved between the transparent substrate K6 and the protective film 115.

As described above, in the above-described seventh embodiment, the sensor chips P11 and P12 and the semiconductor chips P13 to P18 are bonded to the transparent substrate K6 via the transparent resin 316, and the cavity-less structure is achieved on the sensor surfaces 123 and 523. As a result, while enabling light reception at each of the sensor surfaces 123 and 523, it can be unnecessary to provide the cavity in the sensor package 700. As a result, it is possible to improve the strength of the sensor package 700, and there is no need to avoid the formation of the transparent resin 316 on the sensor surfaces 123 and 523, thereby enabling simplification of the manufacturing process.

### <8. Eighth Embodiment>

In the above-described fifth embodiment, the transparent substrate K2 was supported on the sensor chips P11 and P12 and on the semiconductor chips P13 to P18 via the adhesive layer 116 in order to provide cavities on the sensor chips P11 and P12 and on the semiconductor chips P13 to P18. In this eighth embodiment, a spacer 416 is provided between the adhesive layer 116 and the transparent substrate K2 in order to adjust the heights of the cavities on the sensor chips P11 and P12 and the semiconductor chips P13 to P18.

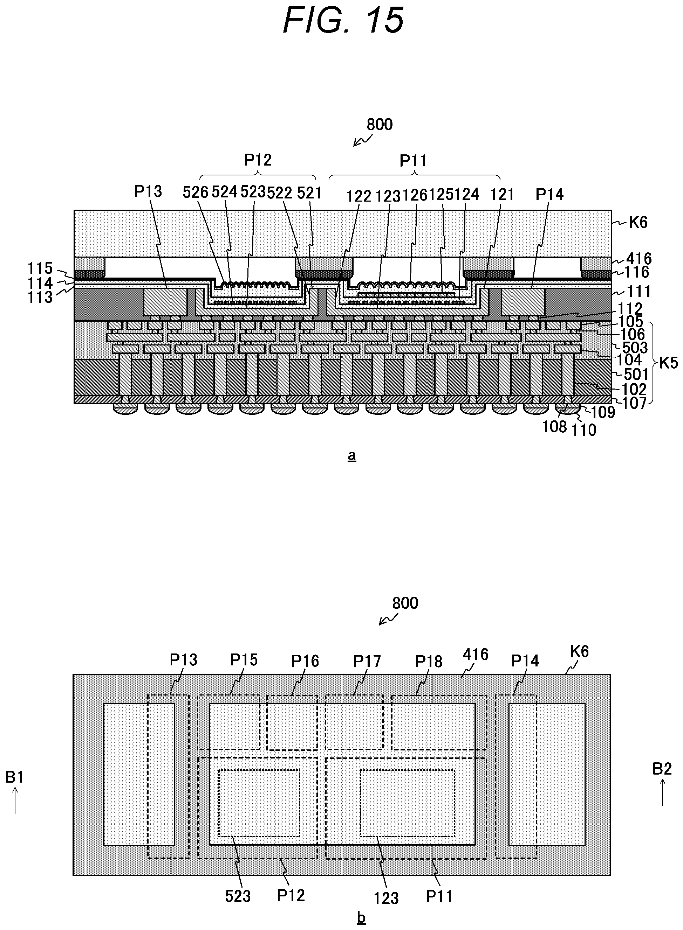

Fig. 15 is a diagram illustrating a configuration example of a sensor package according to the eighth embodiment. Note that a in the drawing is a cross-sectional view illustrating a configuration example of the sensor package according to the eighth embodiment, and b in the drawing is a plan view illustrating a configuration example of the sensor package according to the second embodiment.

In the drawing, in a sensor package 800, a spacer 416 is added to the sensor package 500 of the fifth embodiment described above. Other configurations of the sensor package 800 of the eighth embodiment are similar to the configurations of the sensor package 500 of the fifth embodiment described above.

The spacer 416 is provided between the adhesive layer 116 and the transparent substrate K6. Here, the spacer 416 can be bonded to the transparent substrate K6. In this case, the cavities can be ensured on the sensor chips P11 and P12 and on the semiconductor chips P13 to P18 by the adhesive layer 116 and the spacer 416.

As described above, in the above-described eighth embodiment, the spacer 416 is provided between the adhesive layer 116 and the transparent substrate K6. As a result, the heights of the cavities on the sensor chips P11 and P12 and the semiconductor chips P13 to P18 can be adjusted, and the optical characteristics on the sensor surfaces 123 and 523 can be adjusted.

Note that, in the above-described eighth embodiment, the example in which the spacer 416 is provided between the adhesive layer 116 and the transparent substrate K6 of the above-described fifth embodiment has been described, but a spacer may be provided between the adhesive layer 216 and the transparent substrate K6 of the above-described sixth embodiment.

### <9. Ninth Embodiment>

In the first embodiment described above, the sensor chip P1 in which the sensor surface 123 is formed at the bottom of the recess 122 and the semiconductor chips P2 to P6 are flip-chip mounted on the interposer substrate K1, and the back surface sides of the sensor chip P1 and the semiconductor chips P2 to P6 are exposed from the sealing material 111. In this ninth embodiment, the sensor chip in which the sensor surface 123 is formed at the bottom of the recess and the semiconductor chips P2 to P6 are flip-chip mounted on the interposer substrate K1, the back surface side of the semiconductor chips P2 to P6 is covered with the sealing material 111, and the back surface side of the sensor chip is exposed from the sealing material 111.

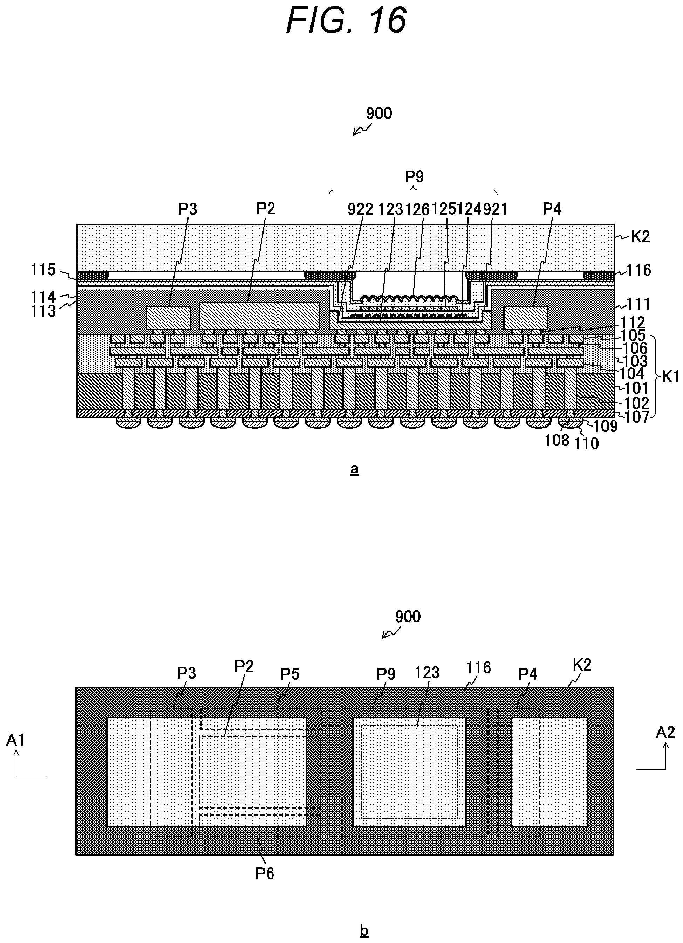

Fig. 16 is a diagram illustrating a configuration example of a sensor package according to the ninth embodiment. Note that a in the drawing is a cross-sectional view illustrating a configuration example of the sensor package according to the ninth embodiment, and b in the drawing is a plan view illustrating a configuration example of the sensor package according to the ninth embodiment.

In the drawing, a sensor package 900 includes a sensor chip P9 instead of the sensor chip P1 of the first embodiment described above. Other configurations of the sensor package 900 of the ninth embodiment are similar to the configurations of the sensor package 100 of the first embodiment described above.

The sensor chip P9 includes a semiconductor substrate 921 instead of the semiconductor substrate 121 of the first embodiment described above. The thickness of the semiconductor substrate 921 can be made thinner than the thickness of the semiconductor substrate 121. The semiconductor substrate 921 includes a recess 922 instead of the recess 122 of the first embodiment described above. A sensor surface 123 is formed at the bottom of the recess 922. The depth of the recess 922 can be shallower than the depth of the recess 122. Other configurations of the sensor chip P9 of the ninth embodiment are similar to the configurations of the sensor chip P1 of the first embodiment described above.

The sensor chip P9 and the semiconductor chips P2 to P6 are flip-chip mounted on a mounting surface of the interposer substrate K1 via each protruding electrode 112. On the interposer substrate K1, the sensor chip P9 and the semiconductor chips P2 to P6 are collectively sealed with the sealing material 111. Here, the back surface side of the semiconductor chips P2 to P6 are covered with the sealing material 111, and the back surface side of the sensor chip P9 is exposed from the sealing material 111. In this case, at least one of the semiconductor chips P2 to P6 may have a different height with respect to the mounting surface of the interposer substrate K1.

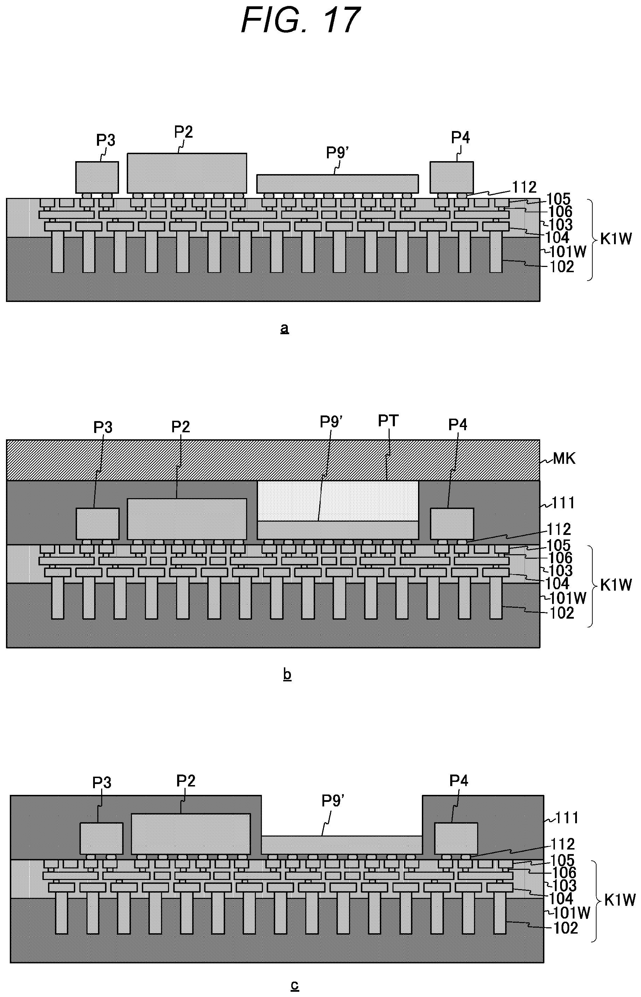

Figs. 17 to 21 are cross-sectional views, each illustrating an example of a method for manufacturing a sensor package according to the ninth embodiment.

As illustrated in a of Fig. 17, the sensor chip P9' and the semiconductor chips P2 to P6 before the formation of the recess 922 are flip-chip mounted on the interposer wafer K1W for each of the partitioned areas PR. Note that, in the drawing, an example is illustrated in which the heights of the sensor chip P9' and the semiconductor chips P2 to P4 are different from one another.

Next, as illustrated in b of Fig. 17, a protective tape PT is disposed on the sensor chip P9'. The protective tape PT may be attachable to the sensor chip P9' in order to avoid positional deviation. The shape of the protective tape PT can be a rectangular parallelepiped. The planar size of the protective tape PT can be equal to the planar size of the sensor chip P9'. The material of the protective tape PT may be, for example, a heat-resistant resin.

Then, a molding die MK is positioned at a position facing the interposer wafer K1W to be in contact with the protective tape PT. Then, the sealing material 111 is injected between the interposer wafer K1W and the molding die MK and cured. In this case, the sensor chip P9' and the semiconductor chips P2 to P6 in each partitioned region PR are collectively sealed with the sealing material 111.

Next, as illustrated in c of Fig. 17, the molding die MK is removed from above the sealing material 111, and the protective tape PT is removed from the sensor chip P9'.

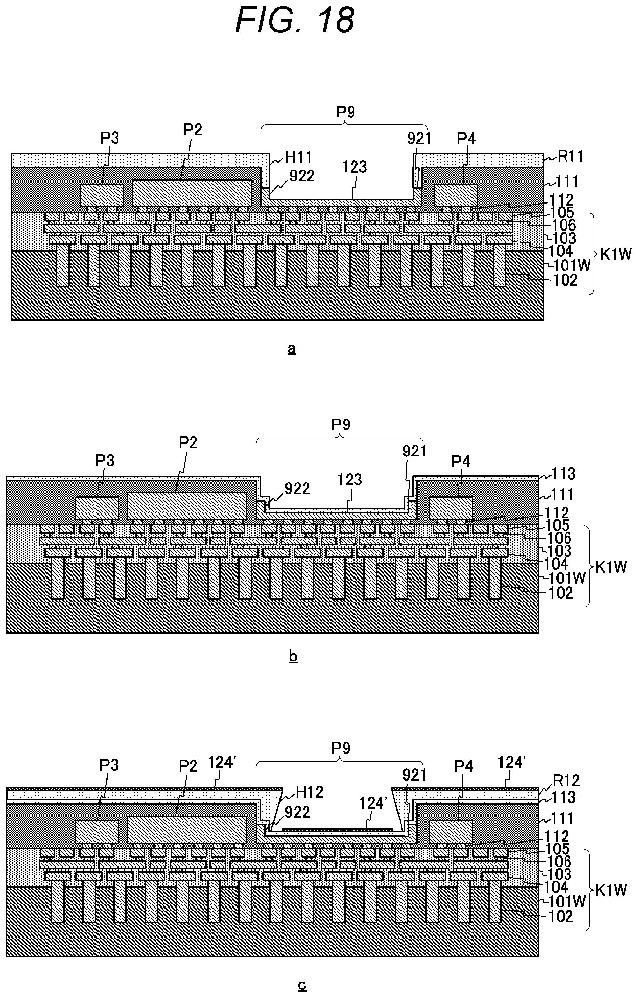

Next, as illustrated in a of Fig. 18, a resist pattern R11 provided with an opening portion H11 is formed on the sealing material 111. The opening portion H11 can be disposed at a position where the sensor surface 123 is formed. In this case, the peripheral portion of the back surface of the sensor chip P9' and the back surfaces of the semiconductor chips P2 to P6 can be covered with the resist pattern R11.

Then, the semiconductor substrate 921 of the sensor chip P9' is etched using the resist pattern R11 as an etching mask to form the recess 922 on the back surface side of the semiconductor substrate 921. In this case, the sensor surface 123 can be formed at the bottom of the recess 922.

Next, as illustrated in b of Fig. 18, after the resist pattern R11 is removed, the underlayer 113 is formed on the sealing material 111 to cover the sensor surface 123. In this case, the back surface of the sensor chip P9 and the back surfaces of the semiconductor chips P2 to P6 can be covered with the underlayer 113.

Next, as illustrated in c of Fig. 18, a resist pattern R12 provided with an opening portion H12 is formed on the underlayer 113. The opening portion H12 can be arranged on the sensor surface 123. In this case, the end portions of the opening portion H12 can be formed in a reverse tapered shape. Then, a light shielding material 124' is formed on the sensor surface 123. In this case, the light shielding material 124' is also formed on the resist pattern R12.

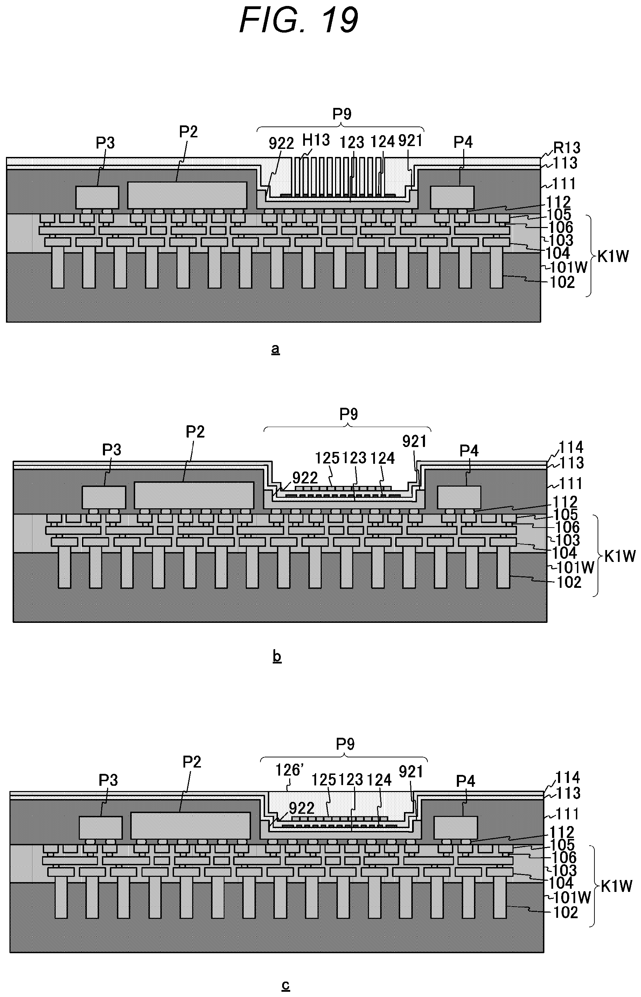

Next, as illustrated in a of Fig. 19, the resist pattern R12 is removed using a peeling solution, and the light shielding material 124' on the resist pattern R12 is lifted off.

Then, a resist pattern R13 provided with an opening portion H13 is formed on the light shielding material 124'. The opening portion H13 can be disposed at a separation position of the light shielding material 124'. In this case, on the underlayer 113, a region where the light shielding material 124' is not formed can be covered with the resist pattern R13.

Then, by etching the light shielding material 124' using the resist pattern R13 as an etching mask, the light shielding layer 124 is formed on the underlayer 113 on the sensor surface 123.

Next, as illustrated in b of Fig. 19, after the resist pattern R13 is removed, the protective film 114 is formed on the underlayer 113 to cover the light shielding layer 124. Moreover, the color filter 125 is formed on the protective film 114 on the sensor surface 123 for each pixel.

Next, as illustrated in c of Fig. 19, a lens material 126' is formed on the protective film 114 to cover the color filter 125. In this case, the lens material 126' can be flattened to expose a surface of the protective film 114.

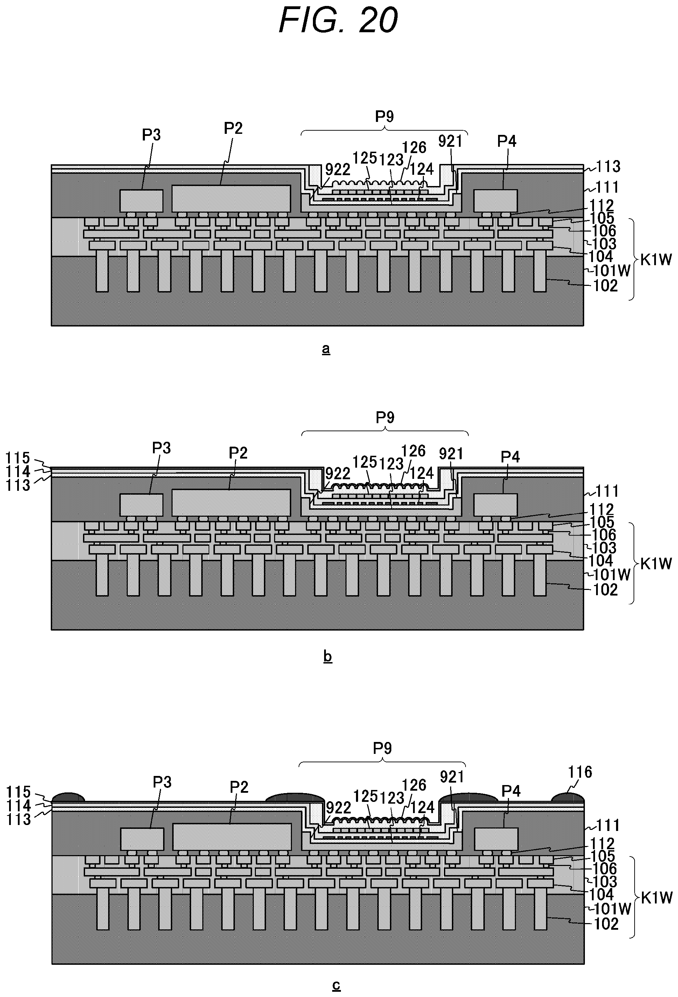

Next, as illustrated in a of Fig. 20, after the lens material 126' on the sensor surface 123 is thinned, the lens material 126' is processed to form an on-chip lens 126 on the sensor surface 123 for each pixel.

Next, as illustrated in b of Fig. 20, the protective film 115 is formed on the protective film 114 to cover the on-chip lens 126.

Next, as illustrated in c of Fig. 20, the adhesive layer 116 is formed on the protective film 115. The adhesive layer 116 can be disposed on the peripheral portion of the sensor chip P9 and the peripheral portion of the sensor package 900.

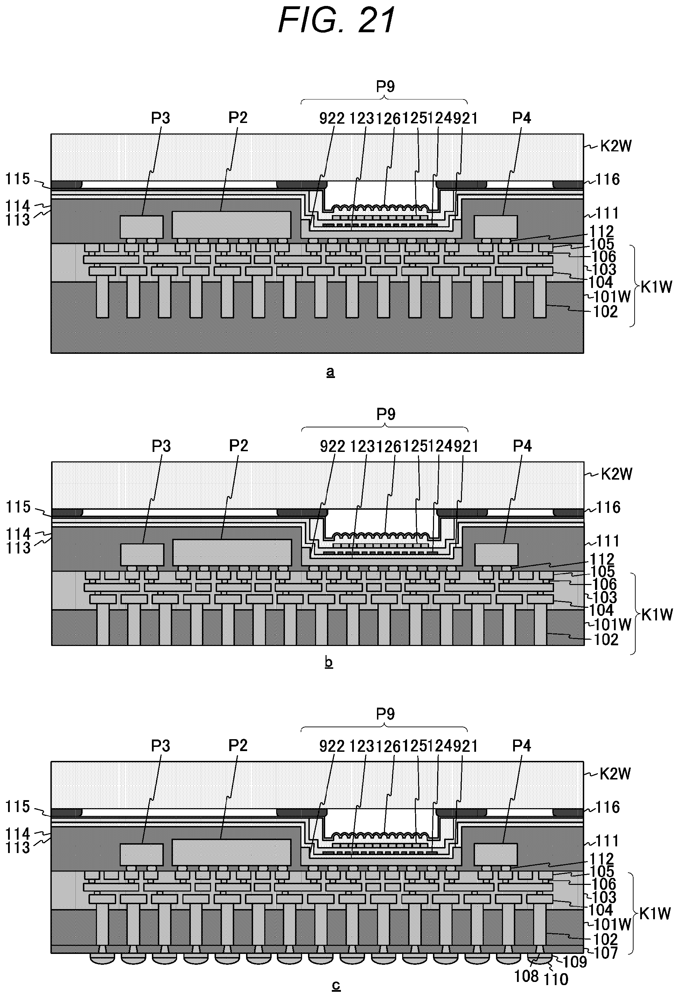

Next, as illustrated in a of Fig. 21, the transparent substrate wafer K2W is bonded to the protective film 115 via the adhesive layer 116. Then, the adhesive layer 116 is cured to fix the transparent substrate wafer K2W to the protective film 115.

Next, as illustrated in b of Fig. 21, the back surface side of the interposer wafer K1W is thinned to expose the through electrodes 102.

Next, as illustrated in c of Fig. 21, the insulating layer 107 is formed on the interposer wafer K1W. After the vias 108 are embedded in the insulating layer 107, the land electrodes 109 connected to the vias 108 are formed on the insulating layer 107. Moreover, the protruding electrodes 110 are formed on the land electrodes 109.

Next, as illustrated in Fig. 16, the stacked wafer in which the sensor chip P9 and the semiconductor chips P2 to P6 are disposed between the interposer wafer K1W and the transparent substrate wafer K2W is cut along the scribe line SL to be singulated into the sensor package 900.

As described above, in the ninth embodiment described above, the sensor chip P9 in which the sensor surface 123 is formed at the bottom of the recess 922 and the semiconductor chips P2 to P6 are flip-chip mounted on the interposer substrate K1, the back surface side of the semiconductor chips P2 to P6 is covered with the sealing material 111, and the back surface side of the sensor chip P9 is exposed from the sealing material 111. As a result, it is not necessary to thin the sealing material 111 in order to expose the back surface side of the sensor chip P9 from the sealing material 111, and damage to the sensor chip P9 can be reduced.

Note that, in the above-described ninth embodiment, the example in which the single sensor chip P9 is flip-chip mounted on the interposer substrate K1 has been described, but the plurality of sensor chips P11 and P12 of the fifth embodiment described above may be provided.

### <10. Tenth Embodiment>

In the ninth embodiment described above, the transparent substrate K2 is disposed via cavities on the sensor chip P9 and on the semiconductor chips P2 to P6, the back surface sides of the semiconductor chips P2 to P6 are covered with the sealing material 111, and the back surface side of the sensor chip P9 is exposed from the sealing material 111. In this tenth embodiment, the transparent substrate K2 is disposed via the cavity on the sensor chip P9, the back surface side of each of the semiconductor chips P2 to P6 are covered with the sealing material 111, and the back surface side of the sensor chip P9 is exposed from the sealing material 111.

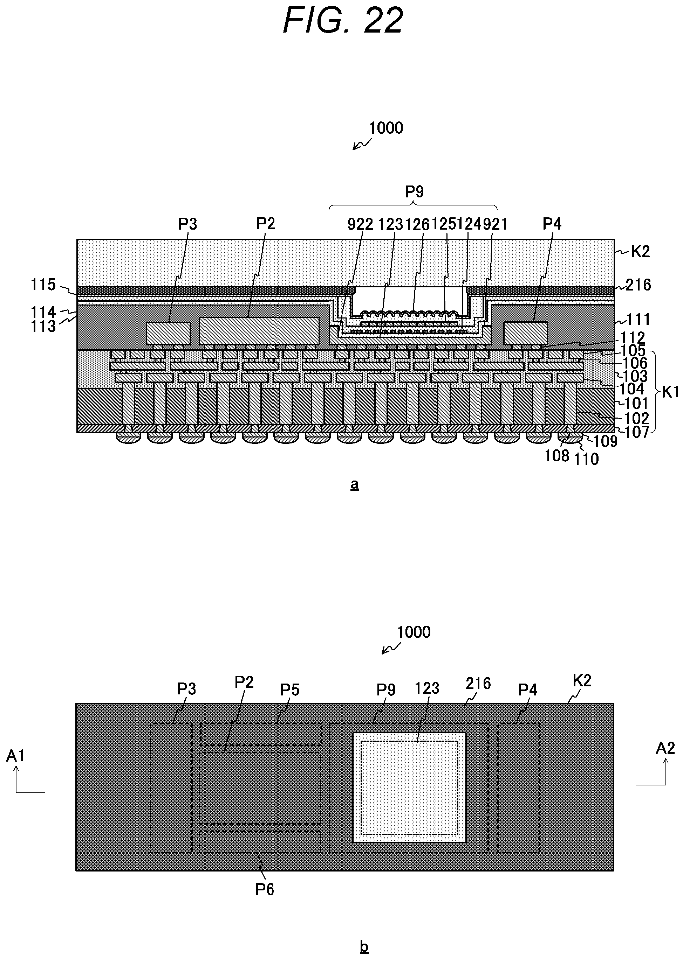

Fig. 22 is a diagram illustrating a configuration example of a sensor package according to the tenth embodiment. Note that a in the drawing is a cross-sectional view illustrating a configuration example of the sensor package according to the tenth embodiment, and b in the drawing is a plan view illustrating a configuration example of the sensor package according to the tenth embodiment.

In the drawing, a sensor package 1000 includes an adhesive layer 216 instead of the adhesive layer 116 of the ninth embodiment described above. Other configurations of the sensor package 1000 of the tenth embodiment are similar to the configurations of the sensor package 900 of the ninth embodiment described above.

The transparent substrate K2 is bonded to the protective film 115 via the adhesive layer 216. In this case, a cavity is formed between the transparent substrate K2 and the protective film 115 on the back surface side of the sensor chip P9. Other configurations of the adhesive layer 216 of the tenth embodiment are similar to the configurations of the adhesive layer 116 of the ninth embodiment described above.

As described above, in the above-described tenth embodiment, the transparent substrate K2 was supported on the sensor chip P9 and on the semiconductor chips P2 to P6 via the adhesive layer 216, and a cavity was provided on the sensor chip P9. As a result, as compared to the configuration in which the cavities are formed on the semiconductor chips P2 to P6, the contact area between the adhesive layer 216 and the protective film 115 can be increased, and the bonding strength to the transparent substrate K2 can be increased.

Note that, in the above-described tenth embodiment, the example in which the single sensor chip P9 is flip-chip mounted on the interposer substrate K1 has been described, but a plurality of the sensor chips P11 and P12 of the fifth embodiment described above may be provided.

### <11. Eleventh Embodiment>

In the ninth embodiment described above, the transparent substrate K2 was supported on the sensor chip P9 and on the semiconductor chips P2 to P6 via the adhesive layer 116, and cavities were provided on the sensor chip P9 and on the semiconductor chips P2 to P6. In this eleventh embodiment, the sensor chip P9 and the semiconductor chips P2 to P6 are flip-chip mounted on the interposer substrate K1, and the sensor chip P9 and the semiconductor chips P2 to P6 are bonded to the transparent substrate K2 via the transparent resin 316 to achieve a cavity-less structure.

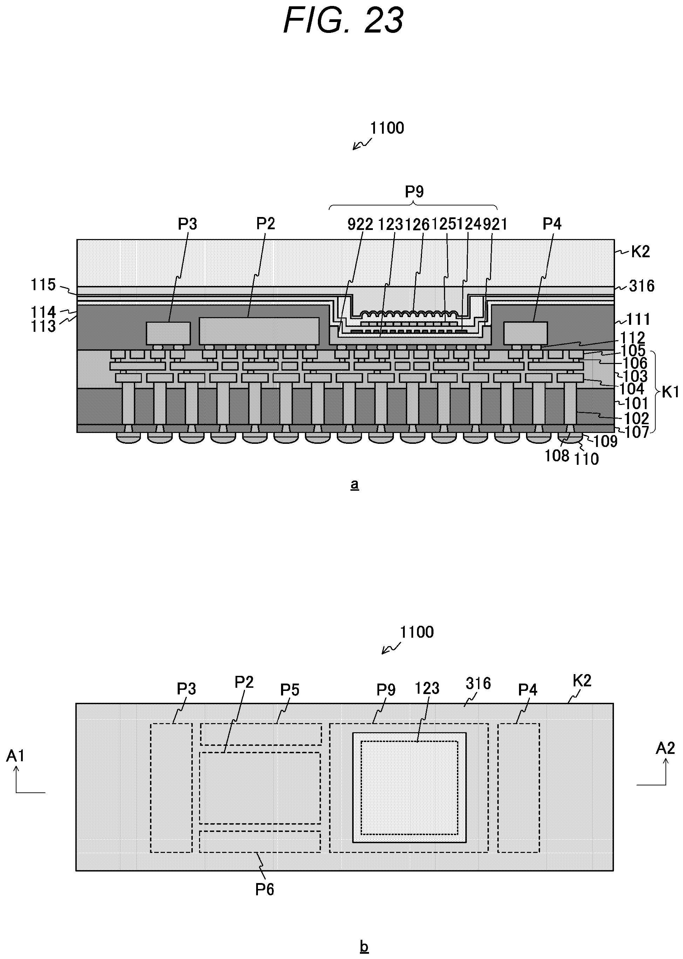

Fig. 23 is a diagram illustrating a configuration example of a sensor package according to the eleventh embodiment. Note that a in the drawing is a cross-sectional view illustrating a configuration example of the sensor package according to the eleventh embodiment, and b in the drawing is a plan view illustrating a configuration example of the sensor package according to the eleventh embodiment.

In the drawing, a sensor package 1100 includes a transparent resin 316 instead of the adhesive layer 116 of the ninth embodiment described above. Other configurations of the sensor package 1100 of the eleventh embodiment are similar to the configurations of the sensor package 900 of the ninth embodiment described above.

The transparent substrate K2 is bonded to the protective film 115 via the transparent resin 316. The transparent resin 316 is formed on the entire surface of the protective film 115. In this case, the recess 922 is also filled with the transparent resin 316. Here, the cavity-less structure is formed between the transparent substrate K2 and the protective film 115 on the back surface side of the sensor chip P9 and semiconductor chips P2 to P6.

As described above, in the above-described eleventh embodiment, the sensor chip P9 and the semiconductor chips P2 to P6 are bonded to the transparent substrate K2 via the transparent resin 316, and the cavity-less structure on the sensor surface 123 can be achieved. Therefore, while enabling light reception at the sensor surface 123, it can be unnecessary to provide the cavity in the sensor package 1100. As a result, it is possible to improve the strength of the sensor package 1100, and there is no need to avoid the formation of the transparent resin 316 on the sensor surface 123, thereby enabling simplification of the manufacturing process.

Note that, in the above-described eleventh embodiment, the example in which the single sensor chip P9 is flip-chip mounted on the interposer substrate K1 has been described, but a plurality of the sensor chips P11 and P12 of the fifth embodiment described above may be provided.

### <12. Twelfth Embodiment>

In the ninth embodiment described above, the transparent substrate K2 was supported on the sensor chip P9 and on the semiconductor chips P2 to P6 via the adhesive layer 116 in order to provide the cavities on the sensor chip P9 and on the semiconductor chips P2 to P6. In this twelfth embodiment, in order to adjust the heights of the cavities on the sensor chip P9 and on the semiconductor chips P2 to P6, a spacer 416 is provided between the adhesive layer 116 and the transparent substrate K2.

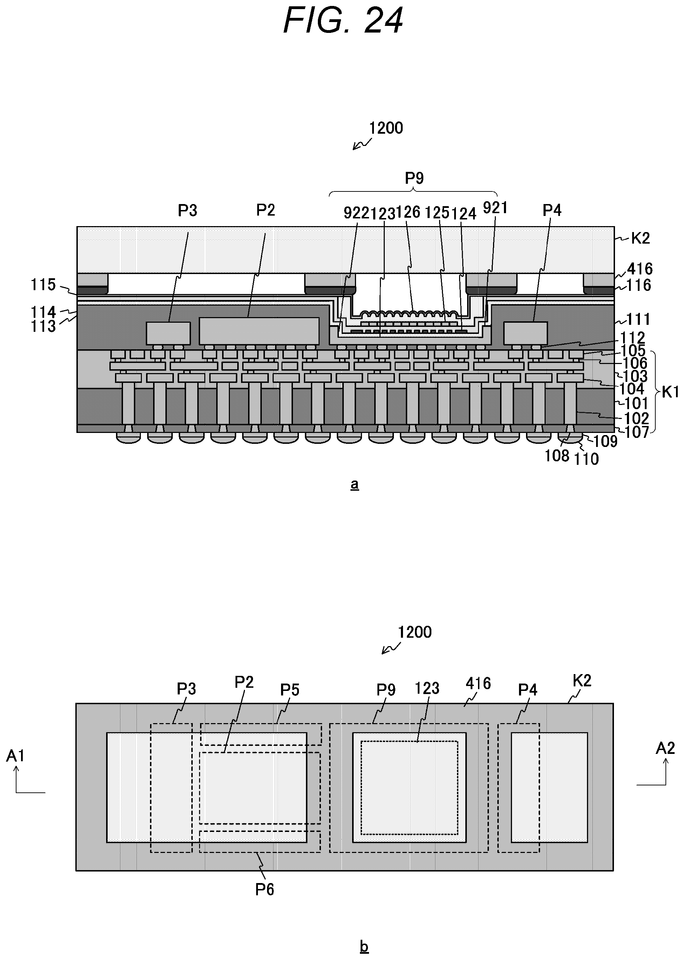

Fig. 24 is a diagram illustrating a configuration example of a sensor package according to the twelfth embodiment. Note that a in the drawing is a cross-sectional view illustrating a configuration example of the sensor package according to the twelfth embodiment, and b in the drawing is a plan view illustrating a configuration example of the sensor package according to the twelfth embodiment.

In the drawing, in a sensor package 1200, a spacer 416 is added to the sensor package 900 of the ninth embodiment described above. Other configurations of the sensor package 1200 of the twelfth embodiment are similar to the configurations of the sensor package 900 of the ninth embodiment described above.

The spacer 416 is provided between the adhesive layer 116 and the transparent substrate K2. In this case, the cavities can be secured on the sensor chip P9 and on the semiconductor chips P2 to P6 by the adhesive layer 116 and the spacer 416.

As described above, in the above-described twelfth embodiment, the spacer 416 is provided between the adhesive layer 116 and the transparent substrate K2. As a result, the heights of the cavities on the sensor chip P9 and on the semiconductor chips P2 to P6 can be adjusted, and the optical characteristics on the sensor surface 123 can be adjusted.

Note that, in the above-described twelfth embodiment, the example in which the single sensor chip P9 is flip-chip mounted on the interposer substrate K1 has been described, but a plurality of the sensor chips P11 and P12 of the fifth embodiment described above may be provided.

### <13. Thirteenth Embodiment>

In the first embodiment described above, the sensor chip P1 and the semiconductor chips P2 to P6 are flip-chip mounted on the interposer substrate K1 via the protruding electrodes 110. In this thirteenth embodiment, the sensor chip and the semiconductor chips are directly bonded onto the interposer substrate by face-down mounting.

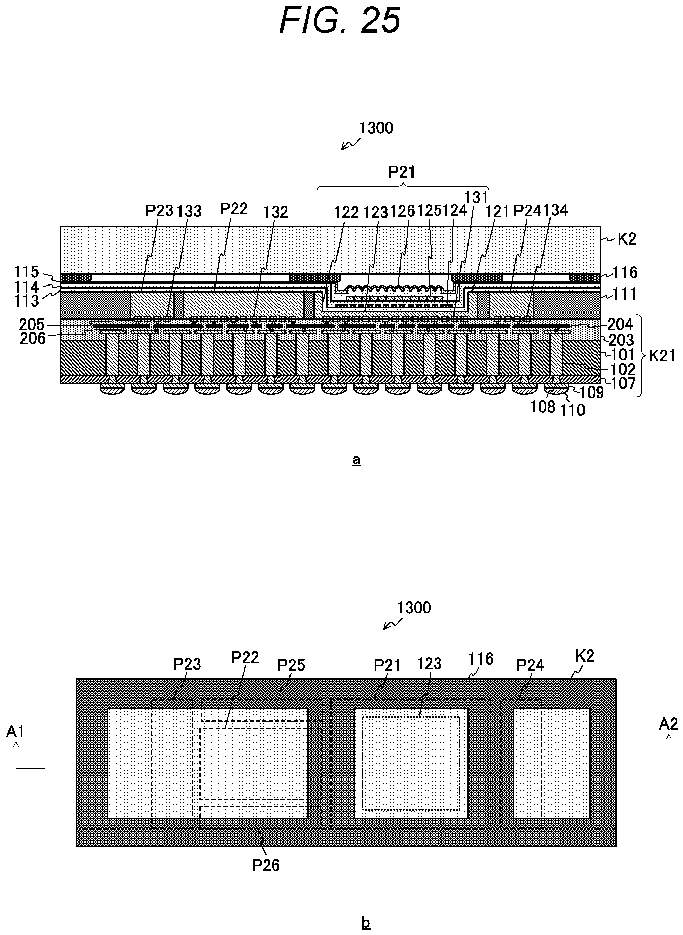

Fig. 25 is a diagram illustrating a configuration example of a sensor package according to the thirteenth embodiment. Note that a in the drawing is a cross-sectional view illustrating a configuration example of the sensor package according to the thirteenth embodiment, and b in the drawing is a plan view illustrating a configuration example of the sensor package according to the thirteenth embodiment.

In the drawing, the sensor package 1300 includes a sensor chip P21, semiconductor chips P22 to P26, and an interposer substrate K21 instead of the sensor chip P1, the semiconductor chips P2 to P6, and the interposer substrate K1 of the first embodiment described above. Other configurations of the sensor package 1300 of the thirteenth embodiment are similar to the configurations of the sensor package 100 of the first embodiment described above.

The sensor chip P21 includes a semiconductor substrate 121. A junction electrode 131 is formed in the wiring layer on the semiconductor substrate 121. The surface of the junction electrode 131 is exposed from the wiring layer on the semiconductor substrate 121. Other configurations of the sensor chip P21 of the thirteenth embodiment are similar to the configurations of the sensor chip P1 of the first embodiment described above.

A semiconductor element is formed on each of the semiconductor chips P22 to P26. The junction electrodes are formed on the wiring layers of the semiconductor chips P22 to P26. The surfaces of the junction electrodes of the semiconductor chips P22 to P26 are exposed from the wiring layers of the semiconductor chips P22 to P26. For example, the junction electrodes 132 to 134 are formed on the wiring layer of each of the semiconductor chips P22 to P24. Other configurations of the semiconductor chips P22 to P26 of the thirteenth embodiment are similar to the configurations of the semiconductor chips P2 to P6 of the above-described first embodiment.

The interposer substrate K21 includes a base substrate 101. A wiring layer 203 is formed on the base substrate 101. The through electrodes 102 are embedded in the base substrate 101 and connected to the wiring layer 203. Wiring lines 204 and a junction electrode 205 embedded in an insulating layer are formed in the wiring layer 203. The surface of the junction electrode 205 is exposed from the wiring layer 203. Furthermore, vias 206 used for interlayer connection are formed in the wiring layer 203. Other configurations of the interposer substrate K21 of the thirteenth embodiment are similar to the configurations of the interposer substrate K1 of the first embodiment described above.

The junction electrodes 131 to 134 and the junction electrode 205 can be used for directly bonding the sensor chip P21 and the semiconductor chips P22 to P24 to the interposer substrate K21. Hybrid bonding can be used for direct bonding of the sensor chip P21 and the semiconductor chips P22 to P24 to the interposer substrate K21. In this case, the junction electrodes 131 to 134 are disposed at positions facing the junction electrode 205. Then, the junction electrodes 131 to 134 can be directly joined to the junction electrode 205 on the basis of metal joining such as Cu-Cu joining.

As described above, in the above-described thirteenth embodiment, the sensor chip P21 and the semiconductor chips P22 to P26 are directly bonded onto the interposer substrate K21 by face-down mounting. As a result, it is possible to increase the arrangement density of the connection terminals between the sensor chip P21 and each of the semiconductor chips P22 to P24 and the interposer substrate K21 while minimizing a decrease in bonding strength.

Note that, in the above-described thirteenth embodiment, an example of the configuration, in which the sensor chip P21 and the semiconductor chips P22 to P26 are directly bonded to the interposer substrate K21, being applied to the above-described first embodiment has been described. In addition, the configuration in which the sensor chip P21 and the semiconductor chips P22 to P26 are directly bonded to the interposer substrate K21 may be applied to any of the configurations of the second to twelfth embodiments described above.

### <14. Fourteenth Embodiment>

In the first embodiment described above, the recess 122 is formed on the back surface side of the sensor chip P1, and the sensor surface 123 is provided at the bottom of the recess 122. In this fourteenth embodiment, the sensor chip in which the entire back surface where the sensor surface 123 is formed is thinned and the semiconductor chips P2 to P6 are collectively sealed with the sealing material 111.

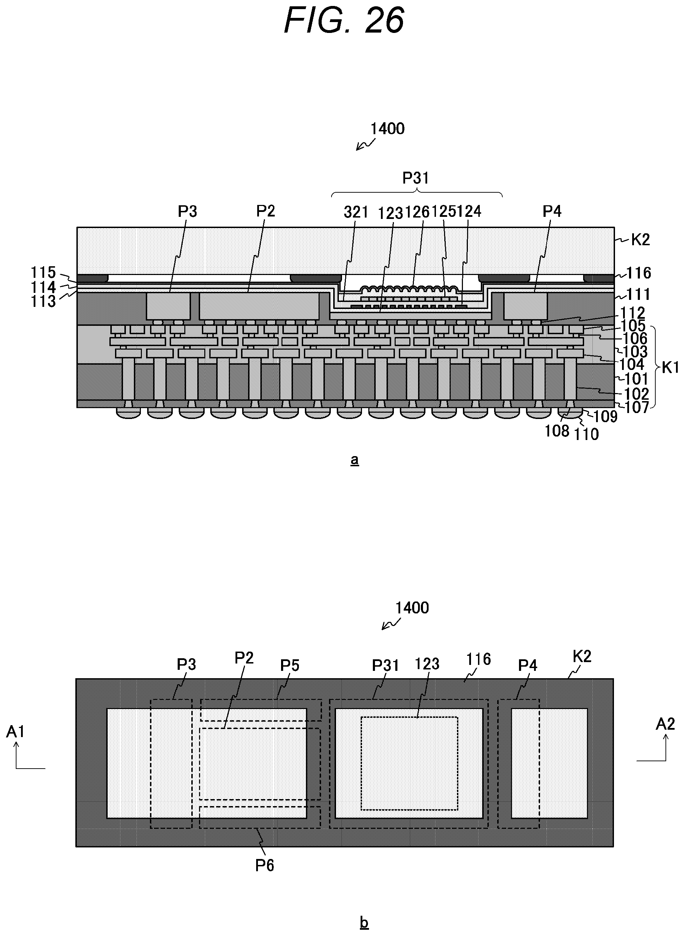

Fig. 26 is a diagram illustrating a configuration example of a sensor package according to the fourteenth embodiment. Note that a in the drawing is a cross-sectional view illustrating a configuration example of the sensor package according to the fourteenth embodiment, and b in the drawing is a plan view illustrating a configuration example of the sensor package according to the fourteenth embodiment.

In the drawing, a sensor package 1400 includes a sensor chip P31 instead of the sensor chip P1 of the first embodiment described above. Other configurations of the sensor package 1400 of the fourteenth embodiment are similar to the configurations of the sensor package 100 of the first embodiment described above.

The sensor chip P31 includes a semiconductor substrate 321. The back surface of the semiconductor substrate 321 is flattened. The sensor surface 123 is formed on the back surface of the semiconductor substrate 321. The planar size of the sensor surface 123 can be made smaller than the planar size of the semiconductor substrate 321. Other configurations of the sensor chip P31 are similar to the configurations of the sensor chip P1 of the first embodiment described above.

The sensor chip P31 and the semiconductor chips P2 to P6 are flip-chip mounted on a mounting surface of an interposer substrate K1 via each protruding electrode 112. On the interposer substrate K1, the sensor chip P31 and the semiconductor chips P2 to P6 are collectively sealed with the sealing material 111. On the back surface side of each of the sensor chip P31 and the semiconductor chips P2 to P6, cavities are formed between the transparent substrate K2 and the protective film 115.

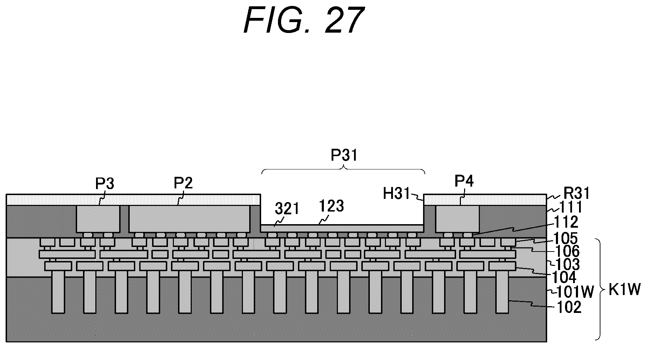

Fig. 27 is a cross-sectional view illustrating an example of the method for manufacturing the sensor package according to the fourteenth embodiment.

In the method for manufacturing the sensor package according to the fourteenth embodiment, the process of Fig. 27 is provided instead of the process of the method for manufacturing the sensor package according to the first embodiment described above in a of Fig. 4. The other steps of the method for manufacturing the sensor package according to the fourteenth embodiment are similar to the steps of the method for manufacturing the sensor package according to the first embodiment described above.

In the drawing, a resist pattern R31 provided with the opening portion H31 is formed on the sealing material 111 on the basis of a lithography technique. The opening portion H31 can be arranged at the position of the sensor chip P31. In this case, the back surfaces of the semiconductor chips P2 to P6 can be covered with the resist pattern R31.

Then, by etching the semiconductor substrate 321 of the sensor chip P31 using the resist pattern R31 as an etching mask, the entire back surface of the semiconductor substrate 321 is thinned. In this case, the sensor surface 123 can be formed on the back side of the semiconductor substrate 321.

As described above, in the above-described fourteenth embodiment, the sensor chip P31 in which the entire back surface where the sensor surface 123 is formed is thinned and the semiconductor chips P2 to P6 are collectively sealed with the sealing material 111. As a result, the recess 122 on the back surface side of the sensor chip P31 can be made unnecessary, and stress concentration on the sensor chip P31 can be reduced.

### <15. Fifteenth Embodiment>

In the above-described fourteenth embodiment, the sensor chip P31 in which the entire back surface where the sensor surface 123 is formed is thinned and the semiconductor chips P2 to P6 are collectively sealed with the sealing material 111, and the transparent substrate K2 is disposed via the cavities on the sensor chip P31 and the semiconductor chips P2 to P6. In this fifteenth embodiment, the sensor chip P31 in which the entire back surface where the sensor surface 123 is formed is thinned and the semiconductor chips P2 to P6 are collectively sealed with the sealing material 111, and the transparent substrate K2 is disposed via the cavity on the sensor chip P31.

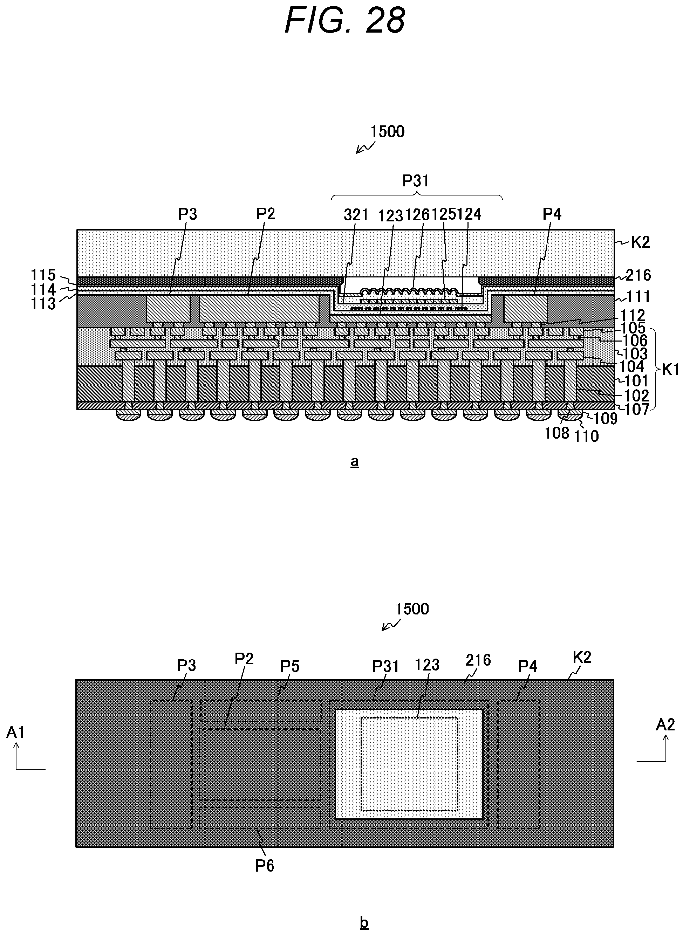

Fig. 28 is a diagram illustrating a configuration example of a sensor package according to the fifteenth embodiment. Note that a in the drawing is a cross-sectional view illustrating a configuration example of the sensor package according to the fifteenth embodiment, and b in the drawing is a plan view illustrating a configuration example of the sensor package according to the fifteenth embodiment.

In the drawing, a sensor package 1500 includes an adhesive layer 216 instead of the adhesive layer 116 of the fourteenth embodiment described above. Other configurations of the sensor package 1500 of the fifteenth embodiment are similar to the configurations of the sensor package 1400 of the fourteenth embodiment described above.

The transparent substrate K2 is bonded to the protective film 115 via the adhesive layer 216. In this case, a cavity is formed between the transparent substrate K2 and the protective film 115 on the back surface side of the sensor chip P31. Other configurations of the adhesive layer 216 of the fifteenth embodiment are similar to the configurations of the adhesive layer 116 of the fourteenth embodiment described above.

As described above, in the fifteenth embodiment described above, the transparent substrate K2 is supported on the sensor chip P31 and on the semiconductor chips P2 to P6 via the adhesive layer 216, and a cavity is provided on the sensor chip P31. As a result, as compared to the configuration in which the cavities are formed on the semiconductor chips P2 to P6, the contact area between the adhesive layer 216 and the protective film 115 can be increased, and the bonding strength to the transparent substrate K2 can be increased.

### <16. Sixteenth Embodiment>

In the fourteenth embodiment described above, the transparent substrate K2 was supported on the sensor chip P31 and on the semiconductor chips P2 to P6 via the adhesive layer 116, and cavities were provided on the sensor chip P31 and on the semiconductor chips P2 to P6. In this sixteenth embodiment, the sensor chip P31 and the semiconductor chips P2 to P6 are flip-chip mounted on the interposer substrate K1, and the sensor chip P31 and the semiconductor chips P2 to P6 are bonded to the transparent substrate K2 via the transparent resin 316 to achieve a cavity-less structure.

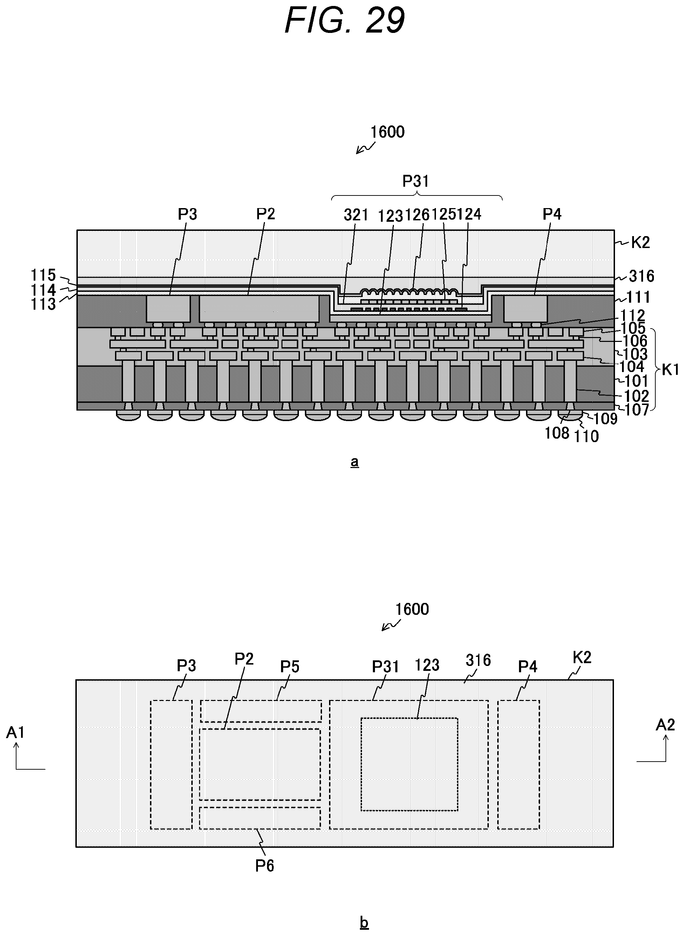

Fig. 29 is a diagram illustrating a configuration example of a sensor package according to the sixteenth embodiment. Note that a in the drawing is a cross-sectional view illustrating a configuration example of the sensor package according to the sixteenth embodiment, and b in the drawing is a plan view illustrating a configuration example of the sensor package according to the sixteenth embodiment.

In the drawing, a sensor package 1600 includes a transparent resin 316 instead of the adhesive layer 116 of the fourteenth embodiment described above. Other configurations of the sensor package 1600 of the sixteenth embodiment are similar to the configurations of the sensor package 1400 of the fourteenth embodiment described above.

The transparent substrate K2 is bonded to the protective film 115 via the transparent resin 316. The transparent resin 316 is formed on the entire surface of the protective film 115. Here, the cavity-less structure is formed between the transparent substrate K2 and the protective film 115 on the back surface side of the sensor chip P31 and semiconductor chips P2 to P6.

As described above, in the above-described sixteenth embodiment, the sensor chip P31 and the semiconductor chips P2 to P6 are bonded to the transparent substrate K2 via the transparent resin 316, and the cavity-less structure on the sensor surface 123 can be achieved. Therefore, while enabling light reception at the sensor surface 123, it can be unnecessary to provide the cavity in the sensor package 1600. As a result, it is possible to improve the strength of the sensor package 1600, and there is no need to avoid the formation of the transparent resin 316 on the sensor surface 123, thereby enabling simplification of the manufacturing process.

### <17. Seventeenth Embodiment>

In the above-described fourteenth embodiment, the transparent substrate K2 was supported on the sensor chip P31 and on the semiconductor chips P2 to P6 via the adhesive layer 116 in order to provide cavities on the sensor chip P31 and on the semiconductor chips P2 to P6. In this seventeenth embodiment, in order to adjust the heights of the cavities on the sensor chip P31 and on the semiconductor chips P2 to P6, a spacer 416 is provided between the adhesive layer 116 and the transparent substrate K2.

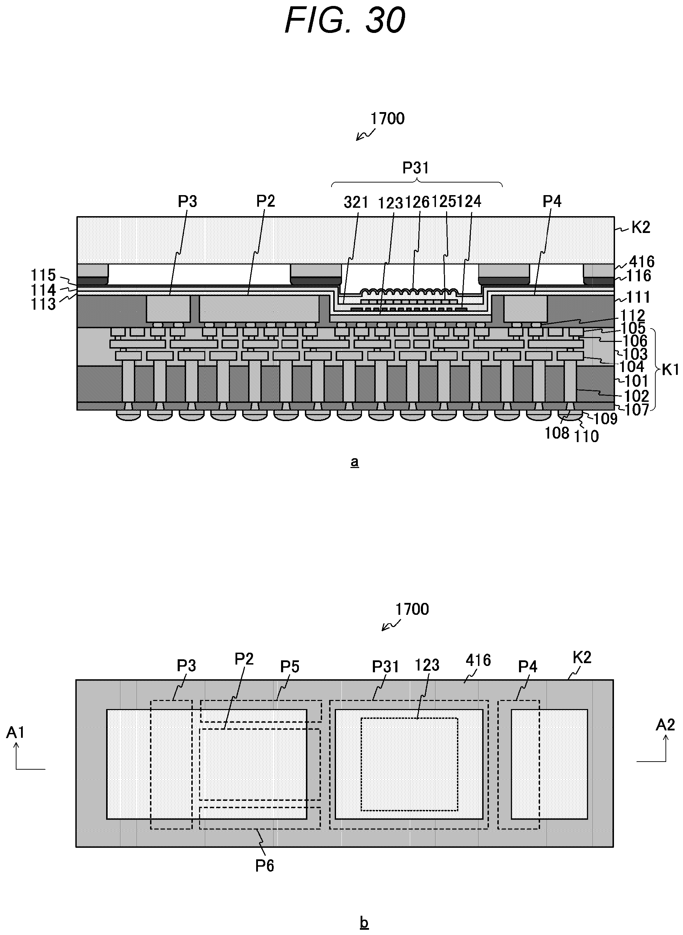

Fig. 30 is a diagram illustrating a configuration example of a sensor package according to the seventeenth embodiment. Note that a in the drawing is a cross-sectional view illustrating a configuration example of the sensor package according to the seventeenth embodiment, and b in the drawing is a plan view illustrating a configuration example of the sensor package according to the seventeenth embodiment.

In the drawing, in a sensor package 1700, a spacer 416 is added to the sensor package 1400 of the fourteenth embodiment described above. Other configurations of the sensor package 1700 of the seventeenth embodiment are similar to the configurations of the sensor package 1400 of the fourteenth embodiment described above.

The spacer 416 is provided between the adhesive layer 116 and the transparent substrate K2. In this case, the cavities can be secured on the sensor chip P31 and on the semiconductor chips P2 to P6 by the adhesive layer 116 and the spacer 416.

As described above, in the above-described seventeenth embodiment, the spacer 416 is provided between the adhesive layer 116 and the transparent substrate K2. As a result, the heights of the cavities on the sensor chip P31 and on the semiconductor chips P2 to P6 can be adjusted, and the optical characteristics on the sensor surface 123 can be adjusted.

Note that, in the above-described seventeenth embodiment, the example in which the spacer 416 is provided between the adhesive layer 116 and the transparent substrate K2 of the above-described fourteenth embodiment has been described, but a spacer may be provided between the adhesive layer 216 and the transparent substrate K2 of the above-described fifteenth embodiment.

Furthermore, in the above-described seventeenth embodiment, the example in which the configuration where the back surface side of the sensor chip P31 is flattened is applied to the above-described first embodiment has been described. In addition, the configuration in which the back surface side of the sensor chip P31 is flattened may be applied to any of the configurations of the second to thirteenth embodiments described above.

Moreover, in any of the configurations of the above-described fifth to eighth embodiments, the back surface side of the sensor chip P12 may be flattened.

### <18. Eighteenth Embodiment>

In the fourteenth embodiment described above, the sensor chip P31 in which the entire back surface where the sensor surface 123 is formed is thinned, and the semiconductor chips P2 to P6 were collectively sealed with the sealing material 111. In this eighteenth embodiment, the sensor chip P31 and the semiconductor chips are collectively sealed with the sealing material 111, and the entire back surface of the sensor chip P31 and the entire back surfaces of the semiconductor chips are thinned together with the sealing material 111.

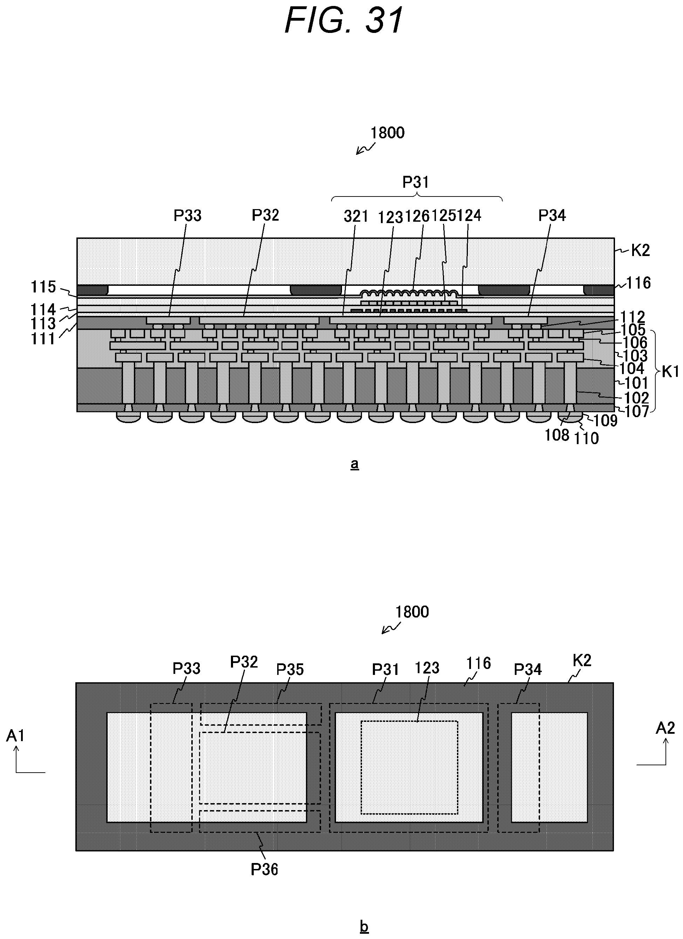

Fig. 31 is a diagram illustrating a configuration example of a sensor package according to the eighteenth embodiment. Note that a in the drawing is a cross-sectional view illustrating a configuration example of the sensor package according to the eighteenth embodiment, and b in the drawing is a plan view illustrating a configuration example of the sensor package according to the eighteenth embodiment.

In the drawing, a sensor package 1800 includes semiconductor chips P32 to P36 instead of the semiconductor chips P2 to P6 of the fourteenth embodiment described above. Other configurations of the sensor package 1800 of the eighteenth embodiment are similar to the configurations of the sensor package 1400 of the fourteenth embodiment described above.

The entire back surfaces of the semiconductor chips P32 to P36 are uniformly thinned together with the entire back surface of the sensor chip P31. Here, the sealing material 111 can be uniformly thinned together with the entire back surface of the sensor chip P31 and the entire back surfaces of the semiconductor chips P32 to P36. In this case, the entire back surface of the sensor chip P31 and the entire back surfaces of the semiconductor chips P32 to P36 are exposed from the sealing material 111. Here, the distance between the sensor surface 123 of the sensor chip P31 and the mounting surface of the interposer substrate K1 can be equal to the distance between the back surface of each of the semiconductor chips P32 to P36 and the mounting surface of the interposer substrate K1. The distance between the surface of the sealing material 111 and the mounting surface of the interposer substrate K1 can be equal to the distance between the back surface of each of the semiconductor chips P32 to P36 and the mounting surface of the interposer substrate K1. Other configurations of the semiconductor chips P32 to P36 are similar to the configurations of the semiconductor chips P2 to P6 of the above-described first embodiment.

The sensor chip P31 and the semiconductor chips P32 to P36 are flip-chip mounted on a mounting surface of the interposer substrate K1 via each protruding electrode 112. On the interposer substrate K1, the sensor chip P31 and the semiconductor chips P32 to P36 are collectively sealed with the sealing material 111. On the back surface side of each of the sensor chip P31 and the semiconductor chips P32 to P36, a cavity is formed between the transparent substrate K2 and the protective film 115.

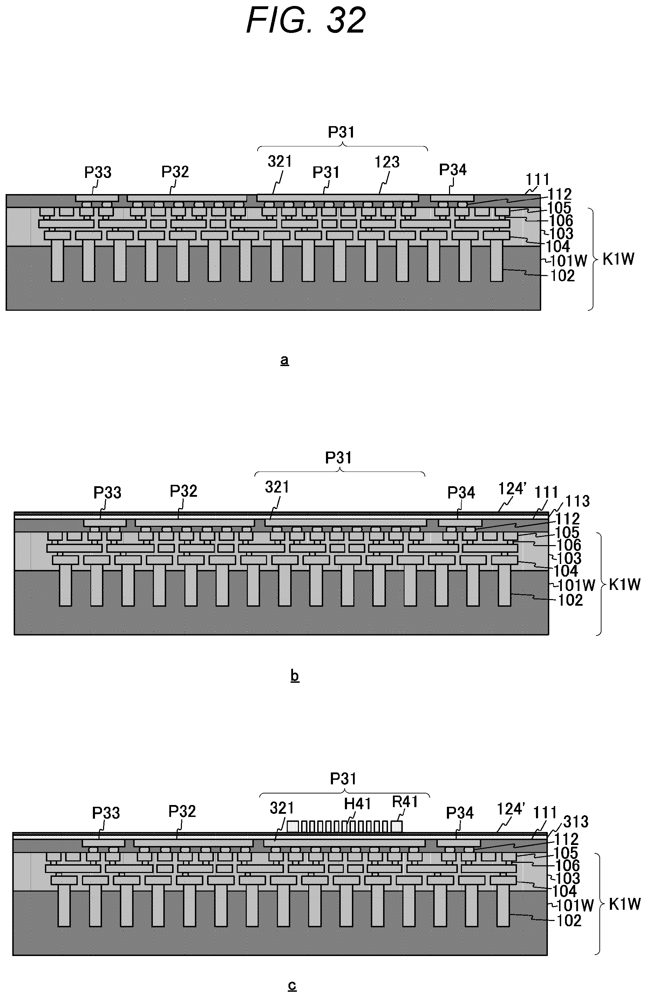

Figs. 32 to 35 are cross-sectional views, each illustrating an example of a method for manufacturing the sensor package according to the eighteenth embodiment.

In a of Fig. 32, after processing is performed in the same manner as in the steps a and b of Fig. 3, the back surface side of the sensor chip P31 and semiconductor chips P32 to P36 is thinned together with the sealing material 111. In this case, until reaching the position of the sensor surface 123 of the sensor chip P31, the back surface side of the sensor chip P31 and semiconductor chips P32 to P36 is uniformly thinned together with the sealing material 111.

Next, as illustrated in b of Fig. 32, the underlayer 113 is formed on the sealing material 111 to cover the sensor surface 123. In this case, the back surface of the sensor chip P31 and the back surfaces of the semiconductor chips P32 to P36 can be covered with the underlayer 113. Then, the light shielding material 124' is formed on the underlayer 113.

Next, as illustrated in c of Fig. 32, a resist pattern R41 provided with the opening portion H41 is formed on the light shielding material 124'. The opening portion H41 can be disposed at a separation position of the light shielding material 124'.

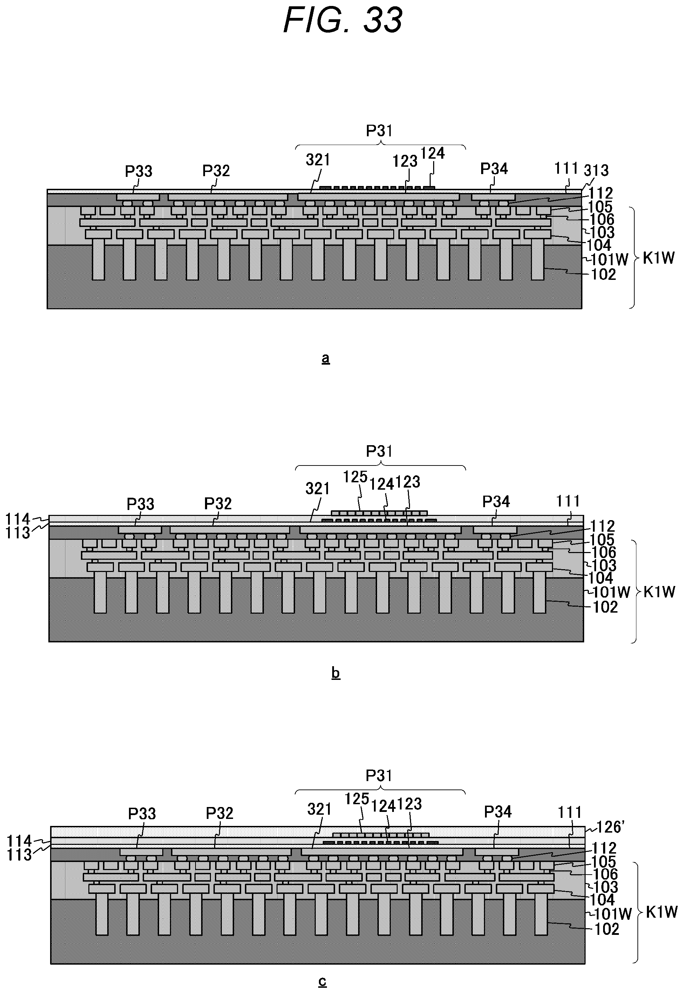

Next, as illustrated in a of Fig. 33, the light shielding material 124' is patterned using the resist pattern R41 as an etching mask to form the light shielding layer 124 on the underlayer 113 on the sensor surface 123. Then, the resist pattern R41 is removed.

Next, as illustrated in b of Fig. 33, the protective film 114 is formed on the underlayer 113 to cover the light shielding layer 124. Moreover, the color filter 125 is formed on the protective film 114 on the sensor surface 123 for each pixel.

Next, as illustrated in c of Fig. 33, a lens material 126' is formed on the protective film 114 to cover the color filter 125.

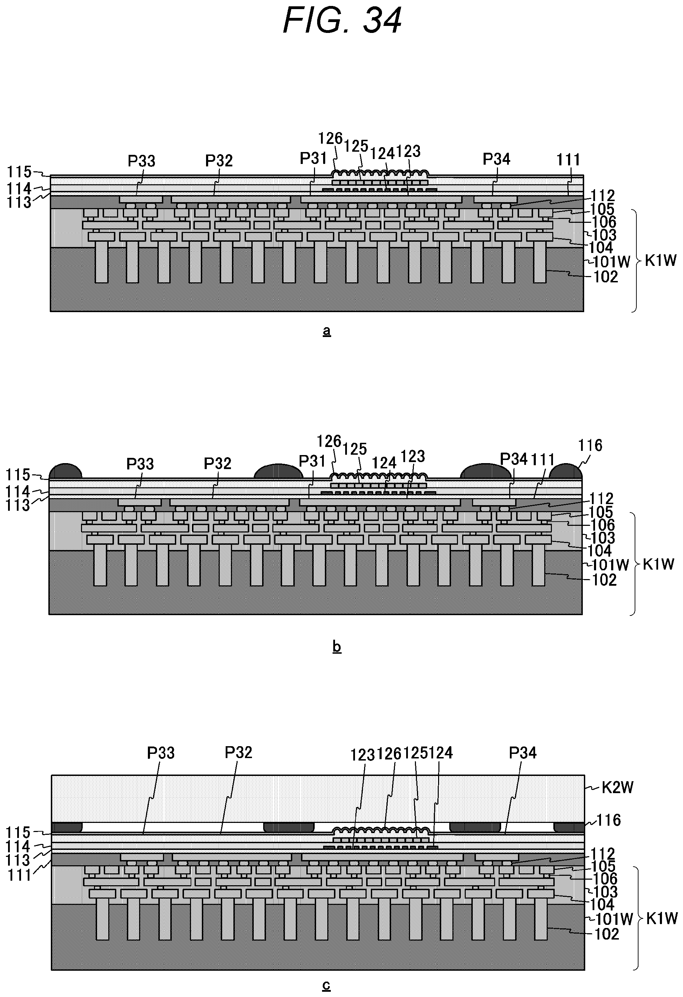

Next, as illustrated in a of Fig. 34, the on-chip lens 126 is formed on the sensor surface 123 by processing the lens material 126'. Then, the protective film 115 is formed on the protective film 114 to cover the on-chip lens 126.

Next, as illustrated in b of Fig. 34, the adhesive layer 116 is formed on the protective film 115. The adhesive layer 116 can be disposed in the peripheral portion of the sensor chip P31 and the peripheral portion of the sensor package 1800.

Next, as illustrated in c of Fig. 34, the transparent substrate wafer K2W is bonded to the protective film 115 via the adhesive layer 116. Then, the adhesive layer 116 is cured to fix the transparent substrate wafer K2W to the protective film 115.

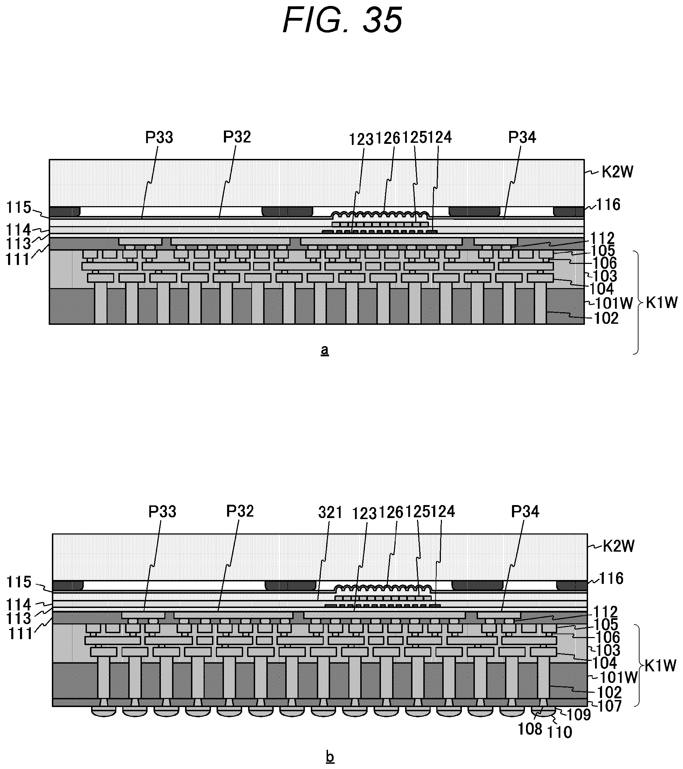

Next, as illustrated in a of Fig. 35, the back surface side of the interposer wafer K1W is thinned to expose the through electrodes 102.

Next, as illustrated in b of Fig. 35, the insulating layer 107 is formed on the interposer wafer K1W. After the vias 108 are embedded in the insulating layer 107, the land electrodes 109 connected to the vias 108 are formed on the insulating layer 107. Moreover, the protruding electrodes 110 are formed on the land electrodes 109.

Next, as illustrated in Fig. 31, the stacked wafer in which the sensor chip P31 and the semiconductor chips P32 to P36 are disposed between the interposer wafer K1W and the transparent substrate wafer K2W is cut along the scribe line SL to be singulated into the sensor package 1800.

As described above, in the eighteenth embodiment described above, the sensor chip P31 and the semiconductor chips P32 to P36 are collectively sealed with the sealing material 111, and the entire back surface of the sensor chip P31 and the entire back surfaces of the semiconductor chips P32 to P36 are uniformly thinned together with the sealing material 111. As a result, it is possible to perform flattening between the back surfaces of the sensor chip P31 and the semiconductor chips P32 to P36 and the surface of the sealing material 111. Therefore, pattern formation of the light shielding layer 124, the color filter 125, and the on-chip lens 126 based on lithography can be made highly accurate.

### <19. Nineteenth Embodiment>

In the eighteenth embodiment described above, the entire back surface of the sensor chip P31 and the entire back surfaces of the semiconductor chips P32 to P36 are thinned together with the sealing material 111, and the transparent substrate K2 is disposed via cavities on the sensor chip P31 and the semiconductor chips P32 to P36. In this nineteenth embodiment, the entire back surface of the sensor chip P31 and the entire back surfaces of the semiconductor chips P32 to P36 are thinned together with the sealing material 111, and the transparent substrate K2 is disposed via the cavity on the sensor chip P31.

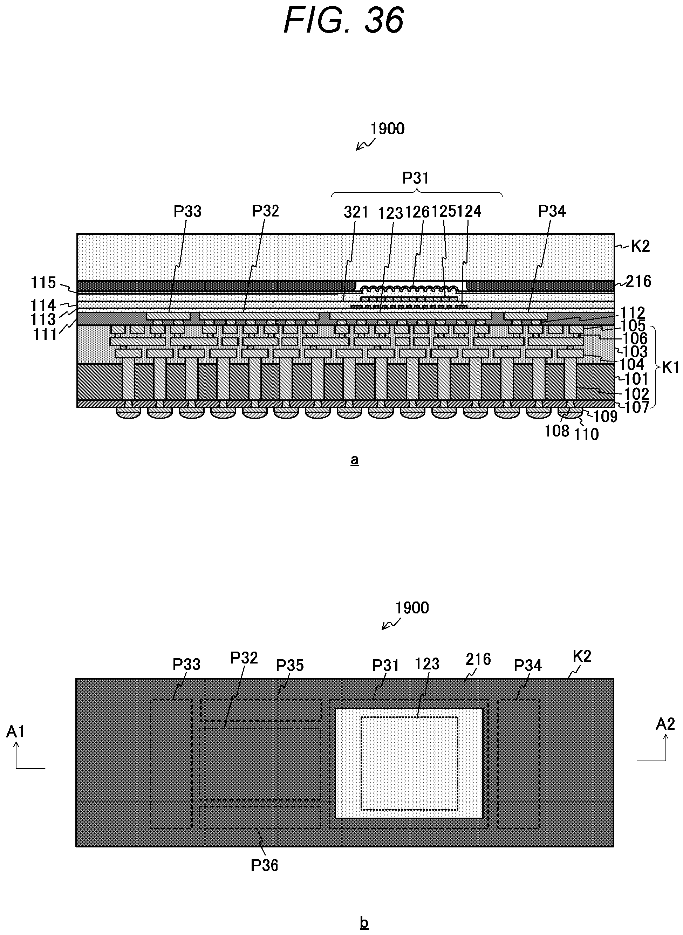

Fig. 36 is a diagram illustrating a configuration example of a sensor package according to the nineteenth embodiment. Note that a in the drawing is a cross-sectional view illustrating a configuration example of the sensor package according to the nineteenth embodiment, and b in the drawing is a plan view illustrating a configuration example of the sensor package according to the nineteenth embodiment.

In the drawing, a sensor package 1900 includes an adhesive layer 216 instead of the adhesive layer 116 of the eighteenth embodiment described above. Other configurations of the sensor package 1900 of the nineteenth embodiment are similar to the configurations of the sensor package 1800 of the eighteenth embodiment described above.

The transparent substrate K2 is bonded to the protective film 115 via the adhesive layer 216. In this case, a cavity is formed between the transparent substrate K2 and the protective film 115 on the back surface side of the sensor chip P31. Other configurations of the adhesive layer 216 of the nineteenth embodiment are similar to the configurations of the adhesive layer 116 of the eighteenth embodiment described above.

As described above, in the above-described nineteenth embodiment, the transparent substrate K2 is supported on the sensor chip P31 and on the semiconductor chips P32 to P36 via the adhesive layer 216, and a cavity is provided on the sensor chip P31. As a result, the contact area between the adhesive layer 216 and the protective film 115 can be increased, with respect to the configuration in which the cavities are formed on the semiconductor chips P32 to P36, and the bonding strength of the transparent substrate K2 can be increased.

### <20. Twentieth Embodiment>

In the eighteenth embodiment described above, the transparent substrate K2 was supported on the sensor chip P31 and the semiconductor chips P32 to P36 via the adhesive layer 116, and cavities were provided on the sensor chip P31 and the semiconductor chips P32 to P36. In this twentieth embodiment, the sensor chip P31 and the semiconductor chips P32 to P36 are flip-chip mounted on the interposer substrate K1, and are bonded to the transparent substrate K2 via a transparent resin 316 to achieve a cavity-less structure.

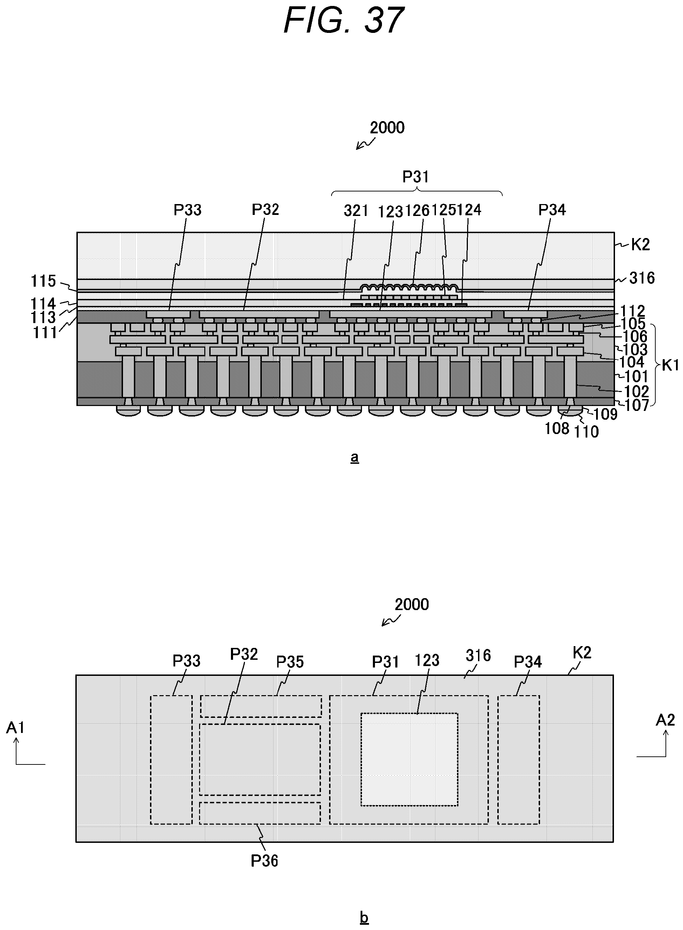

Fig. 37 is a diagram illustrating a configuration example of a sensor package according to the twentieth embodiment. Note that a in the drawing is a cross-sectional view illustrating a configuration example of the sensor package according to the twentieth embodiment, and b in the drawing is a plan view illustrating a configuration example of the sensor package according to the twentieth embodiment.

In the drawing, a sensor package 2000 includes a transparent resin 316 instead of the adhesive layer 116 of the eighteenth embodiment described above. Other configurations of the sensor package 2000 of the twentieth embodiment are similar to the configurations of the sensor package 1800 of the eighteenth embodiment described above.

The transparent substrate K2 is bonded to the protective film 115 via the transparent resin 316. The transparent resin 316 is formed on the entire surface of the protective film 115. Here, the cavity-less structure is formed between the transparent substrate K2 and the protective film 115 on the back surface side of the sensor chip P31 and semiconductor chips P32 to P36.

As described above, in the above-described twentieth embodiment, the sensor chip P31 and the semiconductor chips P32 to P36 are bonded to the transparent substrate K2 via the transparent resin 316, and the cavity-less structure on the sensor surface 123 can be achieved. Therefore, while enabling light reception at the sensor surface 123, it can be unnecessary to provide the cavity in the sensor package 2000. As a result, it is possible to improve the strength of the sensor package 2000, and there is no need to avoid the formation of the transparent resin 316 on the sensor surface 123, thereby enabling simplification of the manufacturing process.

### <21. Twenty-First Embodiment>

In the eighteenth embodiment described above, the transparent substrate K2 was supported on the sensor chip P31 and the semiconductor chips P32 to P36 via the adhesive layer 116 in order to provide the cavities on the sensor chip P31 and the semiconductor chips P32 to P36. In this twenty-first embodiment, in order to adjust the heights of the cavities on the sensor chip P31 and on the semiconductor chips P32 to P36, a spacer 416 is provided between the adhesive layer 116 and the transparent substrate K2.

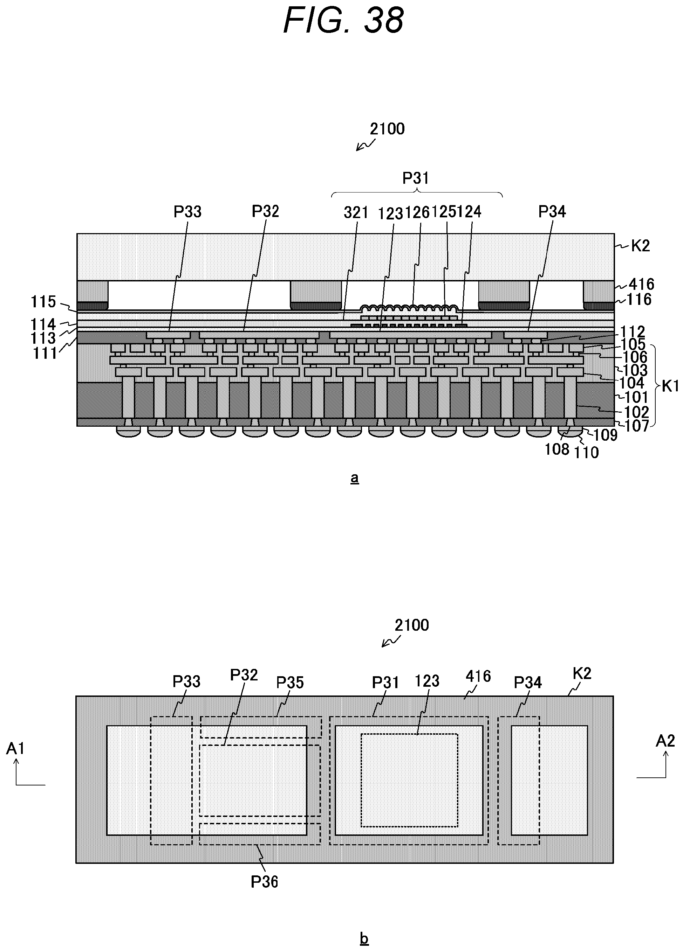

Fig. 38 is a diagram illustrating a configuration example of a sensor package according to the twenty-first embodiment. Note that a in the drawing is a cross-sectional view illustrating a configuration example of the sensor package according to the twenty-first embodiment, and b in the drawing is a plan view illustrating a configuration example of the sensor package according to the twenty-first embodiment.

In the drawing, in a sensor package 2100, a spacer 416 is added to the sensor package 1800 of the eighteenth embodiment described above. Other configurations of the sensor package 2100 of the twenty-first embodiment are similar to the configurations of the sensor package 1800 of the eighteenth embodiment described above.

The spacer 416 is provided between the adhesive layer 116 and the transparent substrate K2. In this case, the cavities can be secured on the sensor chip P31 and on the semiconductor chips P32 to P36 by the adhesive layer 116 and the spacer 416.

As described above, in the above-described twenty-first embodiment, the spacer 416 is provided between the adhesive layer 116 and the transparent substrate K2. As a result, the heights of the cavities on the sensor chip P31 and on the semiconductor chips P32 to P36 can be adjusted, and the optical characteristics on the sensor surface 123 can be adjusted.

Note that, in the above-described twenty-first embodiment, the example in which the spacer 416 is provided between the adhesive layer 116 and the transparent substrate K2 of the above-described eighteenth embodiment has been described, but a spacer may be provided between the adhesive layer 216 and the transparent substrate K2 of the above-described nineteenth embodiment.

Furthermore, in the eighteenth embodiment described above, the example in which the sensor chip P31 and the semiconductor chips P32 to P36 are flip-chip mounted on the interposer substrate K1 has been described. In addition, similarly to the above-described thirteenth embodiment, the sensor chip and the semiconductor chips may be directly bonded to the interposer substrate.

Moreover, the configuration in which the back surface side of the sensor chip P12 of each of the above-described fifth to eighth embodiments is flattened may be applied to any of the above-described eighteenth to twenty-first embodiments.

### <22. Twenty-Second Embodiment>

In the above-described fourteenth embodiment, the sensor chip P31 in which the entire back surface where the sensor surface 123 is formed is thinned and the semiconductor chips P2 to P6 were collectively sealed with the sealing material 111, and the transparent substrate K2 was used for sealing the sensor surface 123. In this twenty-second embodiment, the sensor chip P31 in which the entire back surface where the sensor surface 123 is formed is thinned and the semiconductor chips P2 to P6 are collectively sealed with the sealing material 111, and the sensor surface 123 is sealed on the basis of the substrate-less using a transparent resin.

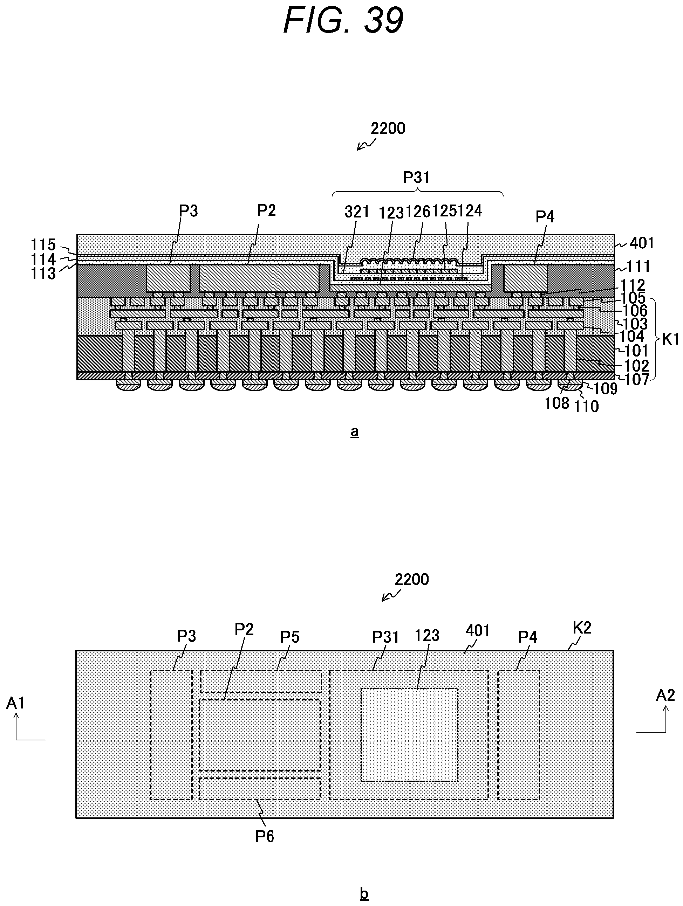

Fig. 39 is a diagram illustrating a configuration example of a sensor package according to the twenty-second embodiment. Note that a in the drawing is a cross-sectional view illustrating a configuration example of the sensor package according to the twenty-second embodiment, and b in the drawing is a plan view illustrating a configuration example of the sensor package according to the twenty-second embodiment.

In the drawing, a sensor package 2200 includes a transparent resin layer 401 instead of the adhesive layer 116 of the first embodiment described above. Furthermore, in the sensor package 2200, the transparent substrate K2 is removed from the sensor package 100 of the first embodiment described above. Other configurations of the sensor package 2200 of the twenty-second embodiment are similar to the configurations of the sensor package 100 of the first embodiment described above.

The transparent resin layer 401 is formed on the protective film 115. The surface of the transparent resin layer 401 is flattened. Note that the surface of the transparent resin layer 401 may be molded in a lens shape for each sensor surface 123. The positions of the end portions of the transparent resin layer 401 in the horizontal direction can be aligned with the positions of end portions of the interposer substrate K1 in the horizontal direction.

The transparent resin layer 401 may be a thermosetting resin or an ultraviolet curable resin. The material of the transparent resin layer 401 may be, for example, a siloxane-based resin, an acrylic resin, an epoxy-based resin, or the like. In this case, the material of the transparent resin layer 401 can be selected in such a way that a refractive index difference with the on-chip lens 126 is secured. The transparent resin layer 401 may contain a filler including an inorganic substance or an organic substance in order to improve reliability. As the transparent resin layer 401, a material having adjusted optical characteristics (refractive index, extinction coefficient, and the like) may be selected in such a way that light can be well received in an effective pixel region.

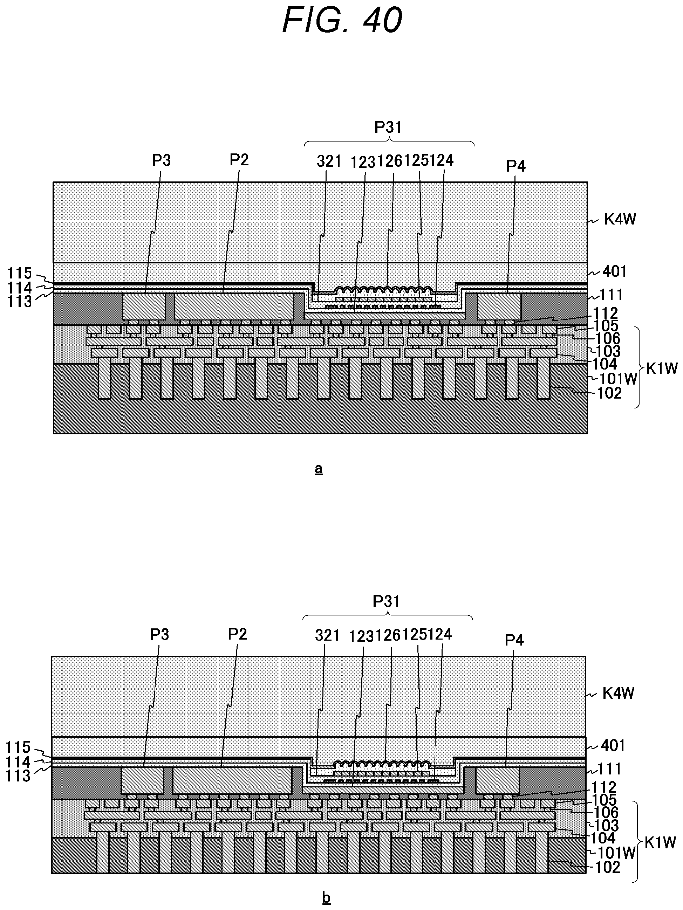

Figs. 40 to 41 are cross-sectional views, each illustrating an example of a method for manufacturing a sensor package according to the twenty-second embodiment.

In a of Fig. 40, after the protective film 115 is formed on the protective film 114, the transparent resin layer 401 is formed on the protective film 115. The transparent resin layer 401 may be formed by coating, potting, or spin coating.

Next, the support substrate wafer K4W is attached onto the transparent resin layer 401. The material of the support substrate wafer K4W may be glass, resin, a semiconductor such as Si, or a metal such as stainless steel.

Next, as illustrated in b of Fig. 40, the back surface side of the interposer wafer K1W is thinned to expose the through electrodes 102.

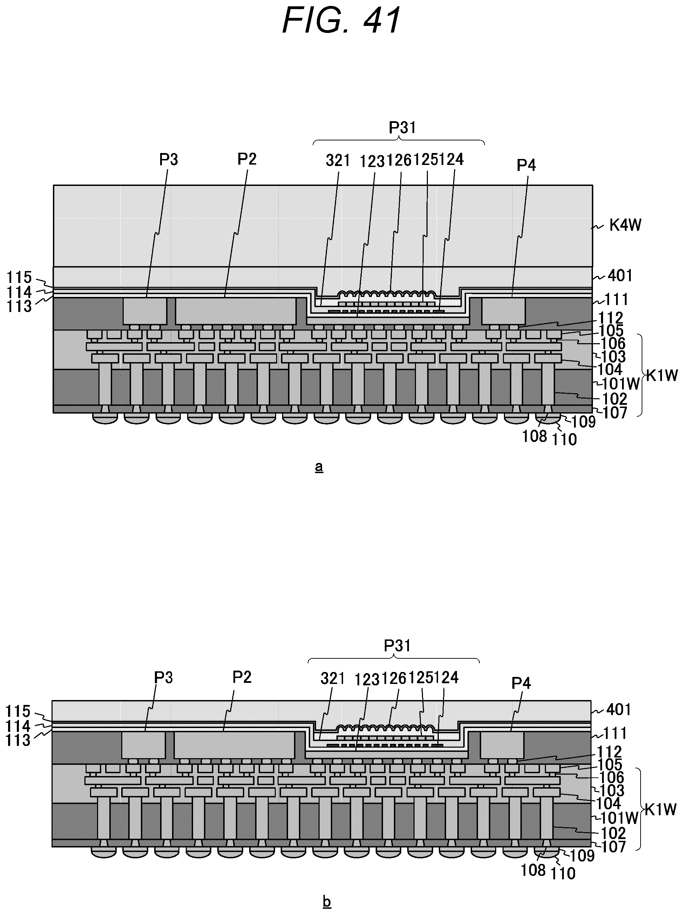

Next, as illustrated in a of Fig. 41, the insulating layer 107 is formed on the interposer wafer K1W. After the vias 108 are embedded in the insulating layer 107, the land electrodes 109 connected to the vias 108 are formed on the insulating layer 107. Moreover, the protruding electrodes 110 are formed on the land electrodes 109.

Next, as illustrated in b of Fig. 41, the support substrate wafer K4W is peeled off from the transparent resin layer 401.

Next, as illustrated in Fig. 39, the stacked wafer in which the sensor chip P31 and the semiconductor chips P2 to P6 are disposed between the interposer wafer K1W and the transparent resin layer 401 is cut along the scribe line SL to be singulated into the sensor package 2200.

As described above, in the twenty-second embodiment described above, the sensor chip P31 in which the entire back surface where the sensor surface 123 is formed is thinned and the semiconductor chips P2 to P6 are collectively sealed with the sealing material 111, and the sensor surface 123 is sealed using the transparent resin layer 401. As a result, it is possible to seal the sensor surface 123 on the basis of the substrate-less while enabling light reception at the sensor surface 123. Thus, it is possible to reduce the height of the sensor package 2200.

Note that, in the above-described twenty-second embodiment, the substrate-less sealing of the sensor surface 123 of the above-described fourteenth embodiment is taken as an example. In addition, the substrate-less sealing of the sensor surface 123 may be applied to any of the configurations of the first, fifth, ninth, thirteenth, and eighteenth embodiments described above.

### <23. Twenty-Third Embodiment>

In the above-described eighteenth embodiment, the sensor chip P31 and the semiconductor chips P32 to P36 collectively sealed with the sealing material 111 are flip-chip mounted on the interposer substrate K1. In the twenty-third embodiment, a redistribution layer is formed on the surface side of the sensor chip and the semiconductor chips collectively sealed with the sealing material 111, and an external terminal is connected.

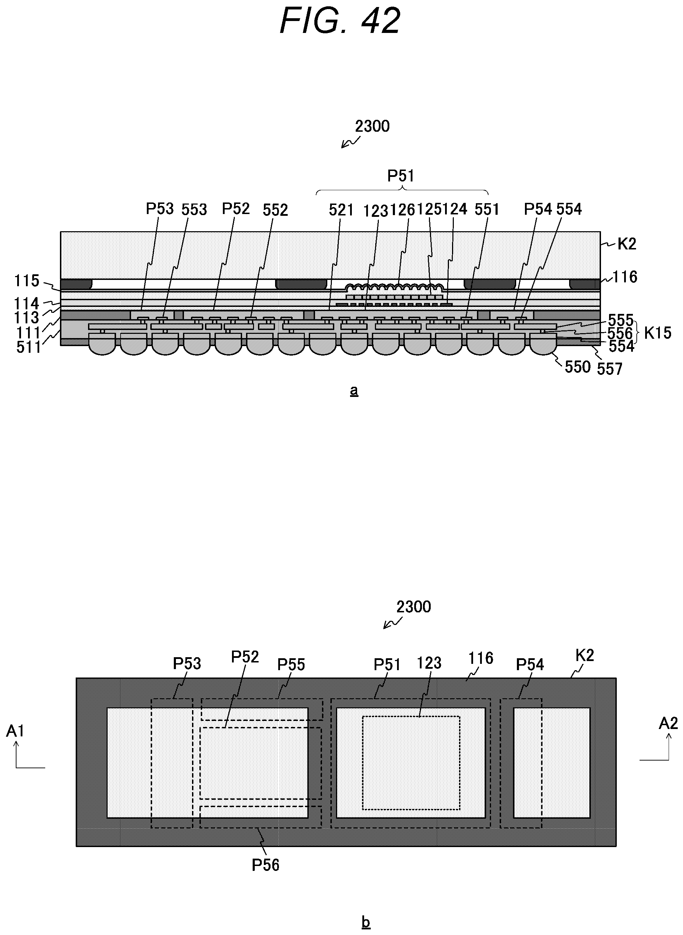

Fig. 42 is a diagram illustrating a configuration example of a sensor package according to the twenty-third embodiment. Note that a in the drawing is a cross-sectional view illustrating a configuration example of the sensor package according to the twenty-third embodiment, and b in the drawing is a plan view illustrating a configuration example of the sensor package according to the twenty-third embodiment.

In the drawing, the sensor package 2300 includes a sensor chip P51, semiconductor chips P52 to P56, and a redistribution layer K15 instead of the sensor chip P31, the semiconductor chips P32 to P36, and the interposer substrate K1 of the eighteenth embodiment described above. Other configurations of the sensor package 1800 of the eighteenth embodiment are similar to the configurations of the sensor package 1400 of the fourteenth embodiment described above.

The sensor chip P51 includes a semiconductor substrate 521. A pad electrode 551 is formed on the wiring layer on the semiconductor substrate 521. The surface of the pad electrode 551 is exposed from the wiring layer on the semiconductor substrate 521. Other configurations of the sensor chip P51 of the twenty-third embodiment are similar to the configurations of the sensor chip P31 of the eighteenth embodiment described above.

A semiconductor element is formed on each of the semiconductor chips P52 to P56. The pad electrodes are formed in the wiring layer of each of the semiconductor chips P52 to P56. The surfaces of the pad electrodes of the semiconductor chips P52 to P56 are exposed from the wiring layers of the semiconductor chips P52 to P56. For example, the pad electrodes 552 to 554 are formed in the wiring layer of each of the semiconductor chips P52 to P54. Other configurations of the semiconductor chips P52 to P56 of the twenty-third embodiment are similar to the configurations of the semiconductor chips P32 to P36 of the eighteenth embodiment described above.

The redistribution layer K15 is formed on the surface side of the sensor chip P51 and the semiconductor chips P52 to P56. The redistribution layer K15 can extend in the horizontal direction from the surface side of the sensor chip P51 and semiconductor chips P52 to P56 on the sealing material 111. In this case, the positions of the end portions of the redistribution layer K15 in the horizontal direction can be aligned with the positions of the end portions of the sealing material 111 in the horizontal direction. As a result, the sensor package 2300 can form a fan-out wafer level package (FOWLP). In the FOWLP, external terminals 550 can also be disposed on the sealing material 111, and the number of external terminals 550 can be increased without increasing the size of the sensor package 2300.

The redistribution layer K15 includes an insulating layer 511, land electrodes 554, a redistribution line 555, and vias 556. The redistribution line 555 is embedded in the insulating layer 511. The surface of each land electrode 554 is exposed from the insulating layer 511. Furthermore, the vias 556 for interlayer-connecting the redistribution line 555 can be formed in the redistribution layer K15. Each of the pad electrodes 551 to 554 is connected to the redistribution line 555 via the via 556.

As the material of the insulating layer 511, for example, a photosensitive insulating resin having SiO₂, SiON, SiN, SiOC or SiCN can be used in the case of an inorganic film, and a photosensitive insulating resin having silicone, polyimide, acrylic, epoxy or the like as a skeleton can be used in the case of an organic film. As the materials of the land electrodes 554, the redistribution line 555, and the vias 556, for example, metals such as Cu, Ti, Ta, Al, W, Ni, Ru, and Co can be used, and a laminated structure of a plurality of materials may be used.

An insulating layer 557 is formed on the redistribution layer K15. The material of the insulating layer 557 may be, for example, an inorganic material such as SiO₂, SiN, or SiCN, or an organic material such as a solder resist. The external terminals 550 are formed on insulating layer 557. The external terminals 550 are connected to the land electrodes 554 via the insulating layer 557. Each external terminal 550 may be a pillar electrode or a solder ball.

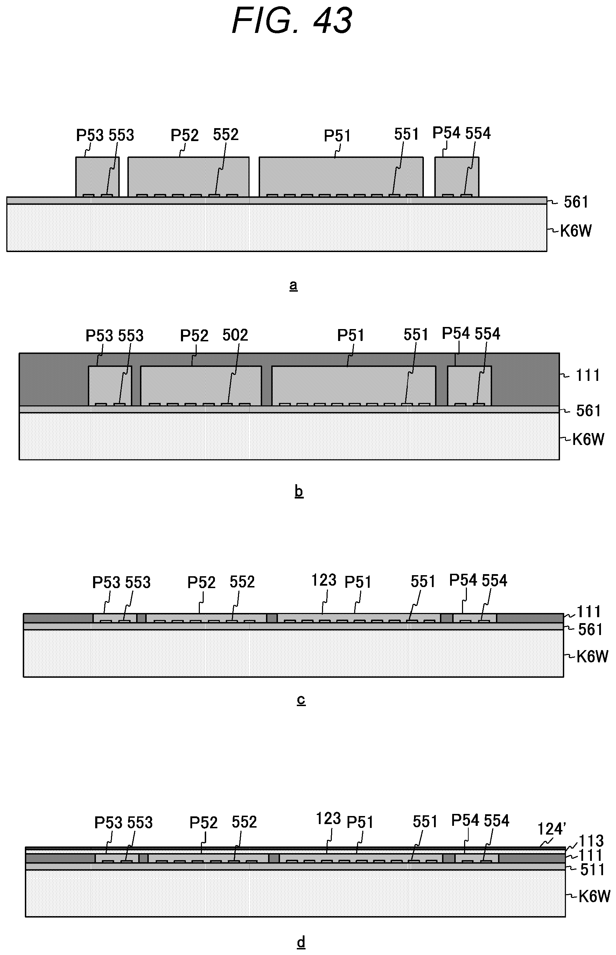

Figs. 43 to 46 are cross-sectional views, each illustrating an example of a method for manufacturing a sensor package according to the twenty-third embodiment.

In a of Fig. 43, the sensor chip P51 and the semiconductor chips P52 to P56 are adhered onto a support substrate wafer K6W via an adhesive layer 561. In this case, the surface side of the sensor chip P51 and semiconductor chips P52 to P56 can be disposed to face the support substrate wafer K6W. The material of the support substrate wafer K6W may be glass, resin, a semiconductor such as Si, or metal such as stainless steel.

Next, as illustrated in b of Fig. 43, the sealing material 111 is formed on the adhesive layer 561 to cover the sensor chip P51 and the semiconductor chips P52 to P56.

Next, as illustrated in c of Fig. 43, the sensor chip P51 and the back surface side of the semiconductor chips P52 to P56 are thinned together with the sealing material 111. In this case, until reaching the position of the sensor surface 123 of the sensor chip P51, the back surface side of the sensor chip P51 and semiconductor chips P52 to P56 can be uniformly thinned together with the sealing material 111.

Next, as illustrated in d of Fig. 43, the underlayer 113 is formed on the sealing material 111 to cover the sensor surface 123. In this case, the back surface of the sensor chip P51 and the back surfaces of the semiconductor chips P52 to P56 can be covered with the underlayer 113. Then, the light shielding material 124' is formed on the underlayer 113.

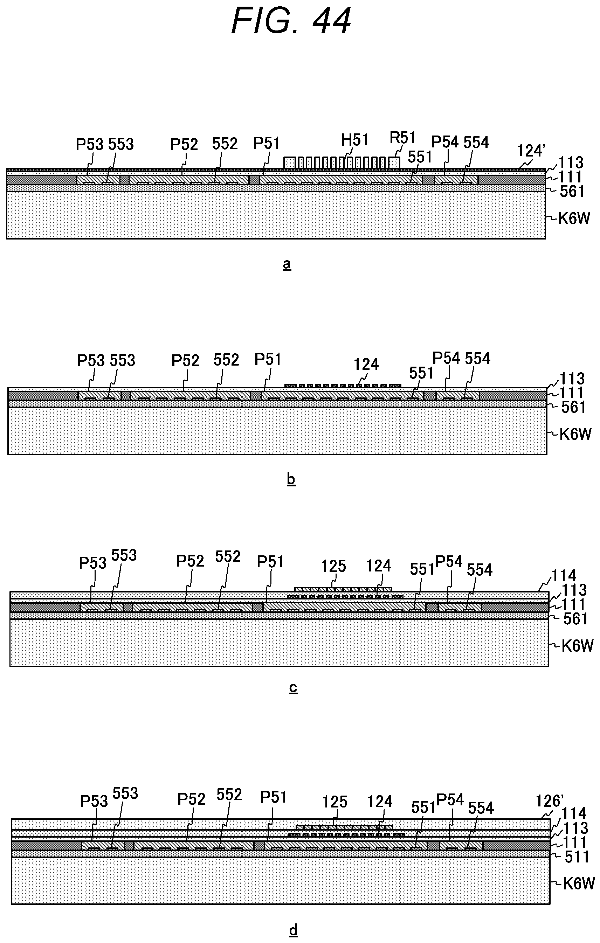

Next, as illustrated in a of Fig. 44, a resist pattern R51 provided with an opening portion H51 is formed on the light shielding material 124'. The resist pattern R51 can be disposed on a position where the light shielding layer 124 is formed.

Next, as illustrated in b of Fig. 44, the light shielding material 124' is etched using the resist pattern R51 as an etching mask to form the light shielding layer 124 on the underlayer 113 on the sensor surface 123, followed by removing the resist pattern R51.

Next, as illustrated in c of Fig. 44, the protective film 114 is formed on the underlayer 113 to cover the light shielding layer 124. Moreover, the color filter 125 is formed on the protective film 114 on the sensor surface 123 for each pixel.

Next, as illustrated in d of Fig. 44, the lens material 126' is formed on the protective film 114 to cover the color filter 125. In this case, the lens material 126' can be flattened over the entire surface.

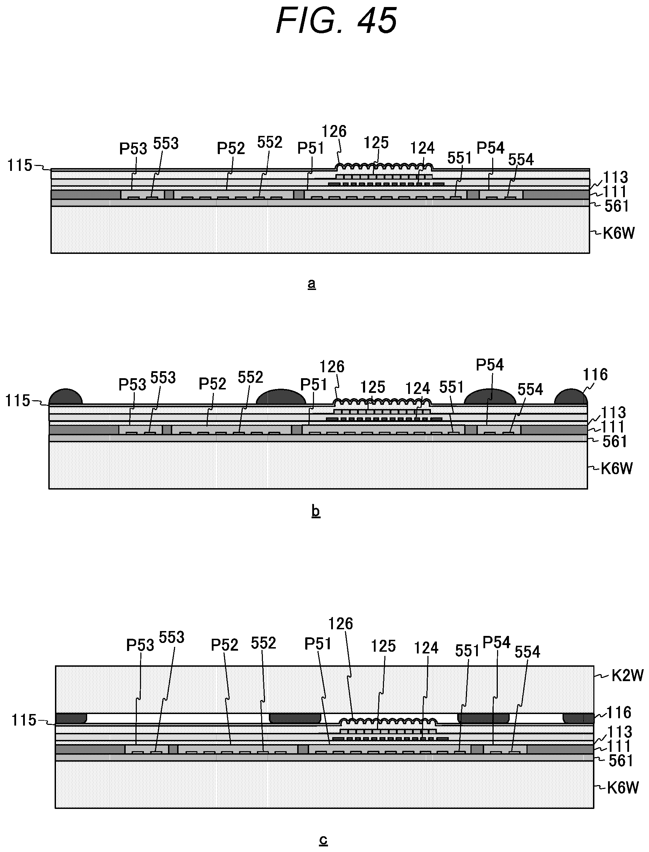

Next, as illustrated in a of Fig. 45, the on-chip lens 126 is formed on the sensor surface 123 by processing the lens material 126' for each pixel. Then, the protective film 115 is formed on the on-chip lens 126.

Next, as illustrated in b of Fig. 45, the adhesive layer 116 is formed on the protective film 115. The adhesive layer 116 can be disposed in the peripheral portion of the sensor chip P51 and the peripheral portion of the sensor package 2300.

Next, as illustrated in c of Fig. 45, the transparent substrate wafer K2W is bonded to the protective film 115 via the adhesive layer 116. Then, the adhesive layer 116 is cured to fix the transparent substrate wafer K2W to the protective film 115.

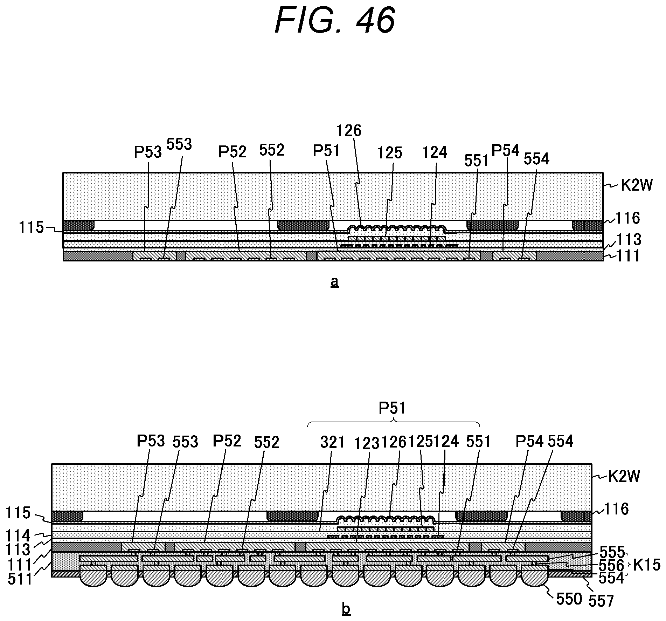

Next, as illustrated in a of Fig. 46, the support substrate wafer K6W is peeled off together with the adhesive layer 561.

Next, as illustrated in b of Fig. 46, the redistribution layer K15 is formed on the surface side of the sensor chip P51 and the semiconductor chips P52 to P56. After the insulating layer 557 is formed on the redistribution layer K15, the external terminals 550 are connected to the land electrodes 554 via the insulating layer 557.

Next, as illustrated in Fig. 42, the stacked wafer in which the sensor chip P51 and the semiconductor chips P52 to P56 are disposed between the redistribution layer K15 and the transparent substrate wafer K2W is cut along the scribe line SL to be singulated into the sensor package 2300.

As described above, in the above-described twenty-third embodiment, the redistribution layer K15 is formed on the surface side of the sensor chip P51 and semiconductor chips P52 to P56 collectively sealed with the sealing material 111, and the external terminals 550 are connected. As a result, the sensor chip P51 and the semiconductor chips P52 to P56 can be connected to the external terminals 550 without using the interposer substrate K1 on which the through electrodes 102 are formed. Therefore, the number of external terminals 550 can be increased without increasing the size of the sensor package 2300, and the height of the sensor package 2300 can be reduced.

### <24. Twenty-Fourth Embodiment>

In the above-described twenty-third embodiment, the redistribution layer K15 is formed on the surface side of the sensor chip P51 and semiconductor chips P52 to P56 collectively sealed with the sealing material 111, and the transparent substrate K2 is disposed via cavities on the sensor chip P51 and the semiconductor chips P52 to P56. In the twenty-fourth embodiment, the redistribution layer K15 is formed on the surface side of the sensor chip P51 and semiconductor chips P52 to P56 collectively sealed with the sealing material 111, and the transparent substrate K2 is disposed via the cavity on the sensor chip P51.

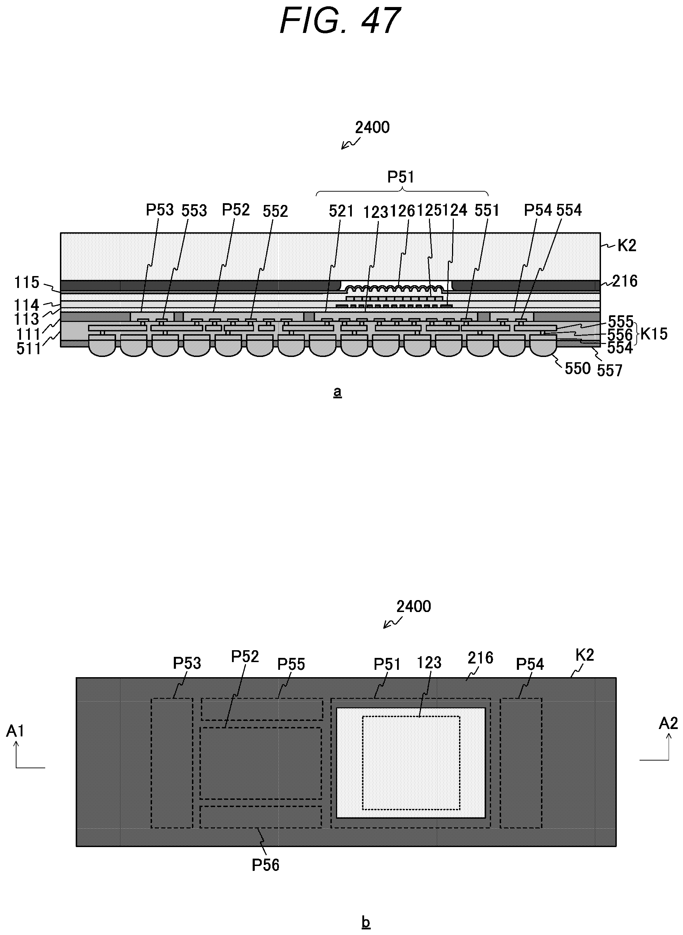

Fig. 47 is a diagram illustrating a configuration example of a sensor package according to the twenty-fourth embodiment. Note that a in the drawing is a cross-sectional view illustrating a configuration example of the sensor package according to the twenty-fourth embodiment, and b in the drawing is a plan view illustrating a configuration example of the sensor package according to the twenty-fourth embodiment.

In the drawing, a sensor package 2400 includes an adhesive layer 216 instead of the adhesive layer 116 of the twenty-third embodiment described above. Other configurations of the sensor package 2400 of the twenty-fourth embodiment are similar to the configurations of the sensor package 2300 of the twenty-third embodiment described above.

The transparent substrate K2 is bonded to the protective film 115 via the adhesive layer 216. In this case, the cavity is formed between the transparent substrate K2 and the protective film 115 on the back surface side of the sensor chip P51. Other configurations of the adhesive layer 216 of the twenty-fourth embodiment are similar to the configurations of the adhesive layer 116 of the twenty-third embodiment described above.

As described above, in the above-described twenty-fourth embodiment, the transparent substrate K2 is supported on the sensor chip P51 and on the semiconductor chips P52 to P56 via the adhesive layer 216, and a cavity is provided on the sensor chip P51. As a result, the contact area between the adhesive layer 216 and the protective film 115 can be increased with respect to the configuration in which a cavity is formed on the semiconductor chips P52 to P56, and the bonding strength of the transparent substrate K2 can be increased.

### <25. Twenty-Fifth Embodiment>

In the above-described twenty-third embodiment, the transparent substrate K2 was supported on the sensor chip P51 and the semiconductor chips P52 to P56 via the adhesive layer 116, and cavities are provided on the sensor chip P51 and the semiconductor chips P52 to P56. In this twenty-fifth embodiment, the redistribution layer K15 is formed on the front surface side of the sensor chip P51 and semiconductor chips P52 to P56, and the sensor chip P51 and the semiconductor chips P52 to P56 are bonded to the transparent substrate K2 via the transparent resin 316 to achieve a cavity-less structure.

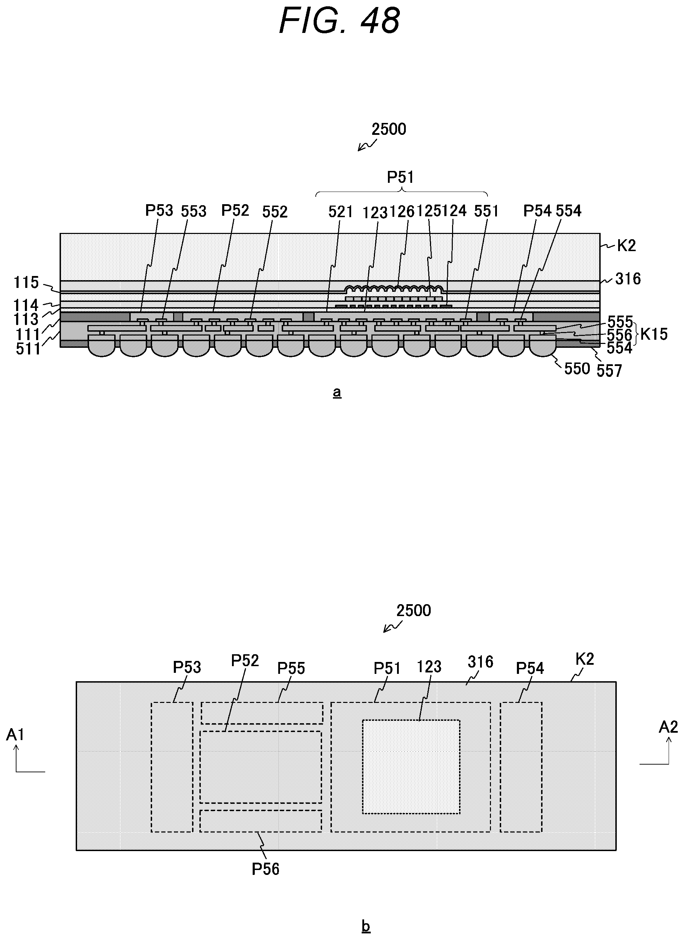

Fig. 48 is a diagram illustrating a configuration example of a sensor package according to the twenty-fifth embodiment. Note that a in the drawing is a cross-sectional view illustrating a configuration example of the sensor package according to the twenty-fifth embodiment, and b in the drawing is a plan view illustrating a configuration example of the sensor package according to the twenty-fifth embodiment.

In the drawing, a sensor package 2500 includes a transparent resin 316 instead of the adhesive layer 116 of the twenty-third embodiment described above. Other configurations of the sensor package 2500 of the twenty-fourth embodiment are similar to the configurations of the sensor package 2300 of the twenty-third embodiment described above.

The transparent substrate K2 is bonded to the protective film 115 via the transparent resin 316. The transparent resin 316 is formed on the entire surface of the protective film 115. Here, the cavity-less structure is formed between the transparent substrate K2 and the protective film 115 on the back surface side of the sensor chip P51 and semiconductor chips P52 to P56.

As described above, in the above-described twenty-fifth embodiment, the sensor chip P51 and the semiconductor chips P52 to P56 are bonded to the transparent substrate K2 via the transparent resin 316, and the cavity-less structure on the sensor surface 123 can be achieved. Therefore, while enabling light reception at the sensor surface 123, it can be unnecessary to provide the cavity in the sensor package 2500. As a result, it is possible to improve the strength of the sensor package 2500, and there is no need to avoid the formation of the transparent resin 316 on the sensor surface 123, thereby enabling simplification of the manufacturing process.

### <26. Twenty-Sixth Embodiment>

In the above-described twenty-third embodiment, the transparent substrate K2 was supported on the sensor chip P51 and on the semiconductor chips P52 to P56 via the adhesive layer 116 in order to provide cavities on the sensor chip P51 and on the semiconductor chips P52 to P56. In this twenty-sixth embodiment, in order to adjust the heights of the cavities on the sensor chip P51 and on the semiconductor chips P52 to P56, a spacer 416 is provided between the adhesive layer 116 and the transparent substrate K2.

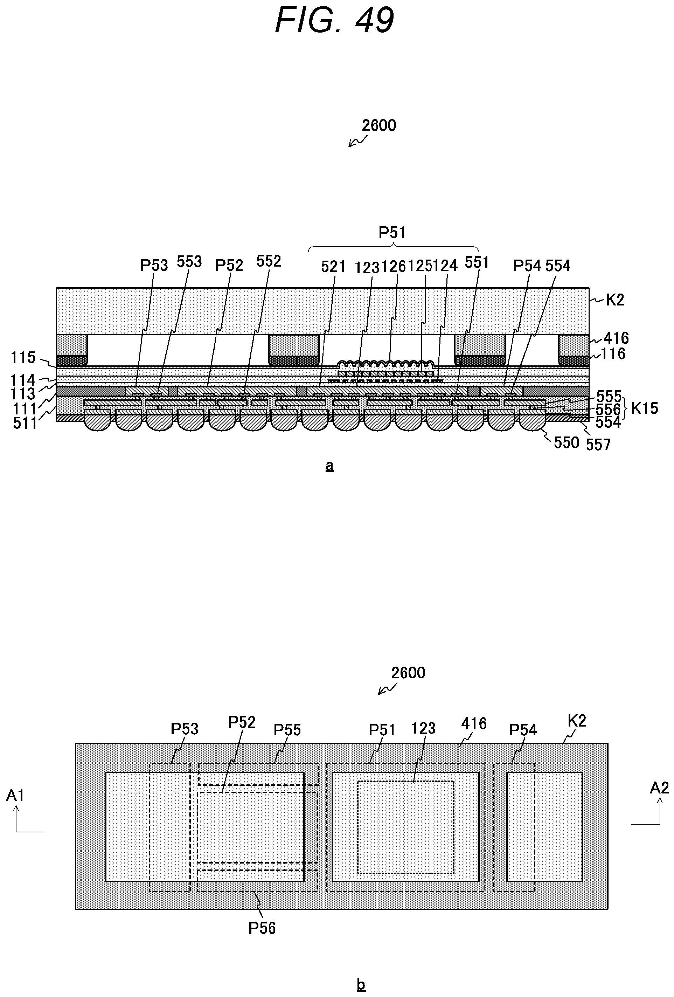

Fig. 49 is a diagram illustrating a configuration example of a sensor package according to the twenty-sixth embodiment. Note that a in the drawing is a cross-sectional view illustrating a configuration example of the sensor package according to the twenty-sixth embodiment, and b in the drawing is a plan view illustrating a configuration example of the sensor package according to the twenty-sixth embodiment.

In the drawing, in a sensor package 2600, a spacer 416 is added to the sensor package 2300 of the twenty-third embodiment described above. Other configurations of the sensor package 2600 of the twenty-sixth embodiment are similar to the configuration of the sensor package 2300 of the twenty-third embodiment described above.

The spacer 416 is provided between the adhesive layer 116 and the transparent substrate K2. In this case, the cavities can be secured on the sensor chip P51 and on the semiconductor chips P52 to P56 by the adhesive layer 116 and the spacer 416.

As described above, in the above-described twenty-sixth embodiment, the spacer 416 is provided between the adhesive layer 116 and the transparent substrate K2. As a result, the heights of the cavities on the sensor chip P51 and on the semiconductor chips P52 to P56 can be adjusted, and the optical characteristics on the sensor surface 123 can be adjusted.

Note that, in the above-described twenty-sixth embodiment, the example in which the spacer 416 is provided between the adhesive layer 116 and the transparent substrate K2 of the above-described twenty-third embodiment has been described, but the spacer may be provided between the adhesive layer 216 and the transparent substrate K2 of the above-described twenty-fourth embodiment.

Furthermore, in the above-described twenty-third embodiment, the example of the configuration in which the redistribution layer K15 is formed on the surface side of the sensor chip P51 and semiconductor chips P52 to P56 collectively sealed with the sealing material 111 is applied to the above-described eighteenth embodiment has been described. In addition, the configuration in which the redistribution layer K15 is formed on the surface side of the sensor chip P51 and semiconductor chips P52 to P56 collectively sealed with the sealing material 111 may be applied to any of the configurations of the second to seventeenth and nineteenth to twenty-second embodiments described above.

### <27. Application Example to Mobile Body>

The technology according to the present disclosure (present technology) can be applied to various products. For example, the technology according to the present disclosure may also be implemented as a device mounted in any type of mobile body such as an automobile, an electric automobile, a hybrid electric automobile, a motorcycle, a bicycle, a personal mobility, an airplane, a drone, a ship, and a robot.

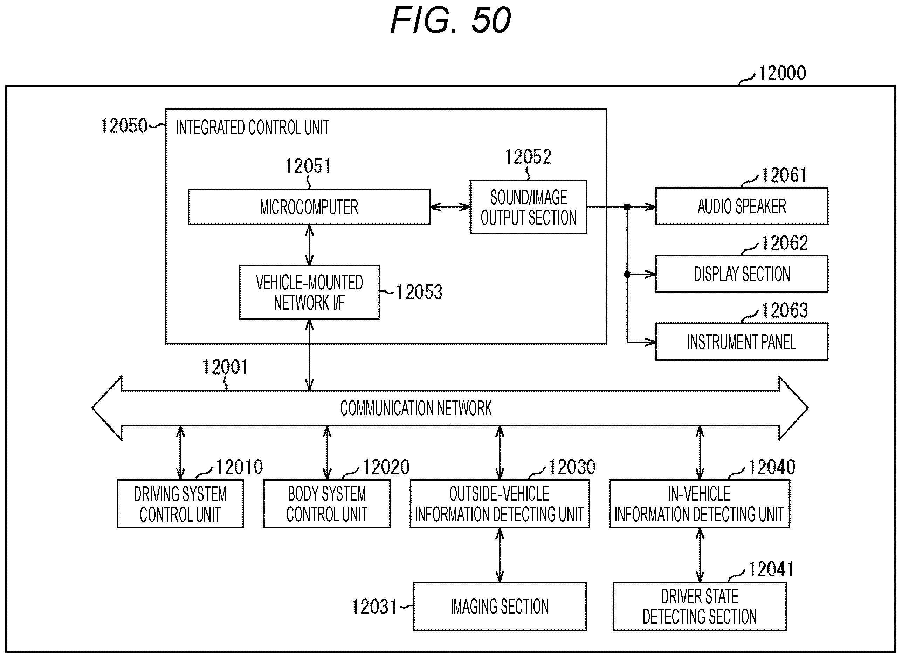

Fig. 50 is a block diagram illustrating a schematic configuration example of a vehicle control system that is an example of a moving body control system to which the technology according to the present disclosure is applicable.

The vehicle control system 12000 includes a plurality of electronic control units connected to each other via a communication network 12001. In the example illustrated in Fig. 50, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. Furthermore, the light received by the imaging section 12031 may be visible light, or may be invisible light such as infrared rays.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 50, an audio speaker 12061, a display section 12062, and an instrument panel 12063 are illustrated as the output device. The display section 12062 may, for example, include at least one of an on-board display and a head-up display.

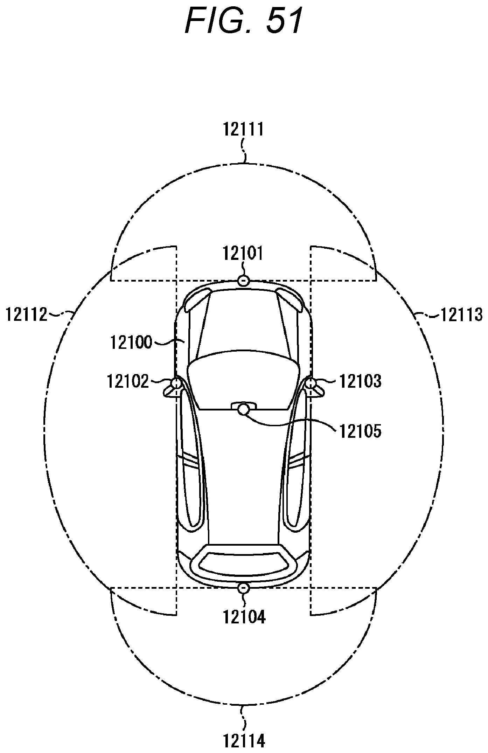

Fig. 51 illustrates an example of installation positions of the imaging sections 12031.

In Fig. 51, the imaging sections 12101, 12102, 12103, 12104, and 12105 are included as the imaging section 12031.

The imaging sections 12101, 12102, 12103, 12104, 12105 are provided, for example, at positions such as a front nose, sideview mirrors, a rear bumper, a back door, and an upper portion of a windshield in the interior of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly images of sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that, Fig. 51 illustrates an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the driving system control unit 12010 including the imaging section 12031, the body system control unit 12020, the outside-vehicle information detecting unit 12030, the in-vehicle information detecting unit 12040, and the integrated control unit 12050 among the above-described configurations. Specifically, for example, an imaging device of the first to twenty-sixth embodiments described above can be applied to the driving system control unit 12010 including the imaging section 12031, the body system control unit 12020, the outside-vehicle information detecting unit 12030, the in-vehicle information detecting unit 12040, and the integrated control unit 12050. By applying the technology according to the present disclosure to the vehicle control system 12000, the vehicle control system 12000 can be made compact.

Note that the embodiments described above indicate examples for embodying the present technology, and the respective matters in the embodiments and the respective matters specifying the invention in the claims have correspondence relationships. Similarly, the matters specifying the invention in the claims and the matters in the embodiments of the present technology denoted by the same names as the matters specifying the invention have a correspondence relationship. The present technology, however, is not limited to the embodiments, and can be implemented by making various modifications to the embodiments without departing from the scope of the present technology. Furthermore, the effects described in the present specification are merely examples and are not limited, and other effects may be provided.

Note that the present technology can also have the following configurations.
(1) A package including:
   a sensor chip that is face-down mounted;
   a semiconductor chip that is face-down mounted at a position different from the sensor chip;
   a sealing material that collectively seals the sensor chip and the semiconductor chip in such a way that a back surface side of the sensor chip is exposed; and
   a wiring layer that is formed on a mounting surface on which the sensor chip and the semiconductor chip are mounted.
(2) The package according to (1), in which
   the sensor chip is a back-side illumination image sensor.
(3) The package according to (1) or (2), in which
   a back surface side of the semiconductor chip is exposed from the sealing material.
(4) The package according to any one of (1) to (3), in which
   the sealing material is a molding resin.
(5) The package according to any one of (1) to (4), further including an interposer substrate including the wiring layer, in which
   the interposer substrate includes a through electrode connected to the wiring layer.
(6) The package according to (5), in which
   the sensor chip and the semiconductor chip are flip-chip mounted on the interposer substrate.
(7) The package according to (5) or (6), in which
   positions of end portions of the sealing material in a horizontal direction are equal to positions of end portions of the interposer substrate in the horizontal direction.
(8) The package according to any one of (1) to (7), in which
   the wiring layer is a redistribution layer formed between the mounting surface on which the sensor chip and the semiconductor chip are mounted, and the sealing material.
(9) The package according to any one of (1) to (8), in which
   a distance between a sensor surface of the sensor chip and the mounting surface is shorter than a distance between a back surface of the semiconductor chip and the mounting surface.
(10) The package according to any one of (1) to (8), in which
   a distance between a surface of the sealing material and the mounting surface is longer than a distance between a back surface of the semiconductor chip and the mounting surface.
(11) The package according to any one of (1) to (8), in which
   a distance between a sensor surface of the sensor chip and the mounting surface side is equal to a distance between a back surface of the semiconductor chip and the mounting surface.
(12) The package according to any one of (1) to (11), in which
   the sensor chip includes a plurality of sensor chips having different types and being face-down mounted at different positions from each other.
(13) The package according to any one of (1) to (12), further including
   a transparent substrate disposed on a sensor surface of the sensor chip.
(14) The package according to (13), further including
   a transparent adhesive layer provided between the sensor chip and the transparent substrate.
(15) The package according to (13) or (14), further including
   a cavity provided between the sensor chip and the transparent substrate.
(16) The package according to (15), in which
   a height of the cavity on the sensor surface is greater than a height of a cavity on a region other than the sensor surface.
(17) The package according to any one of (1) to (16), further including
   an opaque layer that is disposed around a sensor surface of the sensor chip.
(18) The package according to any one of (1) to (17), further including
   a spacer that is disposed around a sensor surface of the sensor chip.
(19) A method for manufacturing a package including:
   a step of collectively sealing a sensor chip and a semiconductor chip disposed at different positions from each other, with a sealing material;
   a step of thinning the sensor chip, the semiconductor chip, and the sealing material to expose a back surface of the sensor chip and a back surface of the semiconductor chip.
(20) The method for manufacturing a package according to (19), the method further including
   a step of face-down mounting the sensor chip and the semiconductor chip at different positions from each other on an interposer substrate before collectively sealing the sensor chip and the semiconductor chip with the sealing material.

### REFERENCE SIGNS LIST

- 100: Sensor package
- P1: Sensor chip
- P2 to P4: Semiconductor chip
- K1: Interposer substrate
- K2: Transparent substrate
- 101: Base substrate
- 102: Through electrode
- 103: Wiring layer
- 104: Wiring line
- 105, 109: Land electrode
- 106, 108: Via
- 107: Insulating layer
- 110, 112: Protruding electrode
- 111: Sealing material
- 113: Underlayer
- 114, 115: Protective film
- 116: Adhesive layer
- 121: Semiconductor substrate
- 122: Recess
- 123: Sensor surface
- 124: Light shielding layer
- 125: Color filter
- 126: On-chip lens

## Claims

1. A package comprising:
a sensor chip that is face-down mounted;
a semiconductor chip that is face-down mounted at a position different from the sensor chip;
a sealing material that collectively seals the sensor chip and the semiconductor chip in such a way that a back surface side of the sensor chip is exposed; and
a wiring layer that is formed on a mounting surface on which the sensor chip and the semiconductor chip are mounted.

2. The package according to claim 1, wherein
the sensor chip is a back-side illumination image sensor.

3. The package according to claim 1, wherein
a back surface side of the semiconductor chip is exposed from the sealing material.

4. The package according to claim 1, wherein
the sealing material is a molding resin.

5. The package according to claim 1, further comprising
an interposer substrate including the wiring layer, wherein
the interposer substrate includes a through electrode connected to the wiring layer.

6. The package according to claim 5, wherein
the sensor chip and the semiconductor chip are flip-chip mounted on the interposer substrate.

7. The package according to claim 5, wherein
positions of end portions of the sealing material in a horizontal direction are equal to positions of end portions of the interposer substrate in the horizontal direction.

8. The package according to claim 1, wherein
the wiring layer is a redistribution layer formed between the mounting surface on which the sensor chip and the semiconductor chip are mounted, and the sealing material.

9. The package according to claim 1, wherein
a distance between a sensor surface of the sensor chip and the mounting surface side is shorter than a distance between a back surface of the semiconductor chip and the mounting surface.

10. The package according to claim 1, wherein
a distance between a surface of the sealing material and the mounting surface is longer than a distance between a back surface of the semiconductor chip and the mounting surface.

11. The package according to claim 1, wherein
a distance between a sensor surface of the sensor chip and the mounting surface side is equal to a distance between a back surface of the semiconductor chip and the mounting surface.

12. The package according to claim 1, wherein
the sensor chip includes a plurality of sensor chips having different types and being face-down mounted at different positions from each other.

13. The package according to claim 1, further comprising
a transparent substrate disposed on a sensor surface of the sensor chip.

14. The package according to claim 13, further comprising
a transparent adhesive layer provided between the sensor chip and the transparent substrate.

15. The package according to claim 13, further comprising
a cavity provided between the sensor chip and the transparent substrate.

16. The package according to claim 15, wherein
a height of the cavity on the sensor surface is greater than a height of a cavity on a region other than the sensor surface.

17. The package according to claim 1, further comprising
an opaque layer that is disposed around a sensor surface of the sensor chip.

18. The package according to claim 1, further comprising
a spacer that is disposed around a sensor surface of the sensor chip.

19. A method for manufacturing a package comprising:
a step of collectively sealing a sensor chip and a semiconductor chip disposed at different positions from each other, with a sealing material;
a step of thinning the sensor chip, the semiconductor chip, and the sealing material to expose a back surface of the sensor chip and a back surface of the semiconductor chip.

20. The method for manufacturing a package according to claim 19, the method further comprising
a step of face-down mounting the sensor chip and the semiconductor chip at different positions from each other on an interposer substrate before collectively sealing the sensor chip and the semiconductor chip with the sealing material.
